(19) Europäisches Patentamt
European Patent Office
Office européen des brevets

(11) EP 1 720 065 B1

(12) **EUROPEAN PATENT SPECIFICATION**

(45) Date of publication and mention of the grant of the patent:
**14.06.2017 Bulletin 2017/24**

(51) Int Cl.:
***G03F 7/09*** *(2006.01)* ***B41C 1/10*** *(2006.01)*
***G03F 7/11*** *(2006.01)* ***C11D 11/00*** *(2006.01)*

(21) Application number: **06005825.2**

(22) Date of filing: **22.03.2006**

(54) **Photosensitive lithographic printing plate**

Lichtempfindliche Lithografiedruckform

Plaque d’impression lithographique photosensible

(84) Designated Contracting States:
**AT BE BG CH CY CZ DE DK EE ES FI FR GB GR HU IE IS IT LI LT LU LV MC NL PL PT RO SE SI SK TR**

(30) Priority: **23.03.2005 JP 2005084081**

(43) Date of publication of application:
**08.11.2006 Bulletin 2006/45**

(73) Proprietor: **FUJIFILM Corporation**
**Minato-ku**
**Tokyo (JP)**

(72) Inventor: **Nagase, Hiroyuki**
**Yoshida-cho**
**Haibara-gun**
**Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A- 0 819 987**
**EP-A- 1 450 207**
**JP-A- 2004 125 876**
**JP-A- 2004 361 720**
**US-A1- 2005 005 794**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 720 065 B1

Printed by Jouve, 75001 PARIS (FR)

## Description

### FIELD OF THE INVENTION

The present invention relates to a photosensitive lithographic printing plate with excellent passing suitability in a plate setter.

### BACKGROUND OF THE INVENTION

The image formation of a negative photosensitive lithographic printing plate is generally performed through a process of coating a photosensitive composition on a support such as surface-roughened aluminum plate to form a photosensitive layer, exposing it to a desired image to cause polymerization or crosslinking in the exposed area of the photosensitive layer, thereby insolubilizing that area in a developer, and dissolving out the unexposed area of the photosensitive layer with a developer. As for the photosensitive composition heretofore used to this purpose, a photopolymerizable composition is well known and is partially used in practice. Also, a photopolymerizable composition taking in the recent technology of photoinitiation system highly sensitive to visible light has sensitivity elevated to the region of light used for direct plate-making by a visible laser, and the printing plate using this composition is widespread as a so-called CTP plate.

A photosensitive lithographic printing plate using a radical polymerization-system composition in the photosensitive layer is known as a representative example of the negative photosensitive lithographic printing plate for use with an ultraviolet or visible laser (see, for example, JP-A-8-220758 (the term "JP-A" as used herein means an "unexamined published Japanese patent application") and JP-A-2000-35673).

The sensitivity of the radical polymerization system greatly decreases in the air due to polymerization inhibition by oxygen and for preventing this, an oxygen-blocking protective layer is usually provided in a photosensitive lithographic printing plate using a radical polymerization system. However, when the oxygen-blocking function of the protective layer is high, the sensitivity becomes high and this conversely causes a so-called flare problem that even a non-image area is cured by the effect of a radical generated in a slight amount due to scattered light upon exposure and staining occurs at the printing. In order to solve this problem, it has been proposed to improve the flare by using a low oxygen-blocking protective layer and prevent the reduction in sensitivity due to low oxygen-blocking property by increasing the content of a polymerizable compound in the photosensitive layer (see, JP-A-2003-98674). Also, when the oxygen-blocking function of the protective layer is high, fogging sometimes occurs due to dark polymerization, that is, storage stability may deteriorate, and for preventing this, a polymerization inhibitor is usually added to the photosensitive layer.

The photosensitive lithographic printing plate having such a protective layer is generally piled up to form a stacked body consisting of tens of plates with an inserting paper between photosensitive lithographic printing plates for the purpose of protecting the protective layer, and shipped by packing the stacked body.

JP 2004 125876 A describes a photopolymerizable planographic printing plate that is highly sensitive as well as scratch- and printing-resistant.

EP 1450 207 A discloses a planographic printing plate precursor, including: a substrate, a photosensitive layer containing an IR absorber, a polymerization initiator, a polymerizable compound and a binder polymer; and a protective layer containing a UV absorber; disposed in this order.

US 2005/0005794 A1 provides a method of coating a coating solution comprising: providing a web; providing a coating solution; coating the coating solution on at least one surface of the web; and drying the coating solution to form a coated layer, wherein a temperature of the web is maintained at 35°C or more during coating. According to the coating method, a multi-layered planographic printing plate can be manufactured.

In many cases, the CTP system has an autoloader function of automatically feeding a plate material to an exposure system (plate setter) and when a plate material in the form of a stacked product is charged into a cassette, the inserting paper is automatically separated and only a plate material is fed to the plate setter. Accordingly, it is important that the inserting paper and the protective layer are smoothly separated without sticking each other and damaging the surface. For this purpose, a technique of adjusting the dynamic friction coefficient between the inserting paper and the outermost surface on the photosensitive layer side to 0.2 to 0.7 has been proposed (see, JP-A-2003-287878).

### SUMMARY OF THE INVENTION

However, according to conventional techniques, it has been difficult to balance the passing suitability in a plate setter with the sensitivity, press life, scumming resistance, storage stability and the like. An object of the present invention is to provide a photosensitive lithographic printing plate assured of high passing suitability in a plate setter and good storage stability and at the same time, excellent in the press life and scumming resistance.

As a result of extensive studies, the present inventors have succeeded in satisfying all of those various functions

required of a protective layer by forming the protective layer in a multilayer system and dispersing the functions to respective layers constituting the protective layer. That is, the present invention is as follows.

1. A photosensitive lithographic printing plate comprising a hydrophilic support, a photosensitive layer and a protective layer provided in this order, the photosensitive layer comprising a compound having an ethylenically unsaturated double bond and a polymer binder, and the protective layer including two or more water-soluble resin layers stacked, wherein at least one of the layers included in the protective layer contains a polyvinyl alcohol and wherein at least one of the layers included in the protective layer contains polyester or polyurethane.

2. The photosensitive lithographic printing plate as described in 1 above, wherein any one layer of the protective layer has an oxygen permeability (at 25°C under 1 atm) of 1.0 to 20 $cm^3/m^2$ day and the dynamic friction coefficient between the outermost protective layer and the inserting paper or back surface of the photosensitive lithographic printing plate is from 0.2 to 0.7.

3. The photosensitive lithographic printing plate as described in any one of 1 to 2 above, wherein the polymer binder is a polyurethane resin having a crosslinking group in the side chain or a (meth)acrylic resin having a crosslinking group in the side chain.

Preferred embodiments of the photosensitive lithographic printing plates according to the present invention are defined in the claims.

According to the present invention, a photosensitive lithographic printing plate assured of high passing suitability in a plate setter and good storage stability and at the same time, excellent in the sensitivity, press life and scumming resistance can be provided.

DETAILED DESCRIPTION OF THE INVENTION

The present invention is described in detail below.

<Protective Layer>

The protective layer of the present invention is characterized by comprising two or more layers. A layer for controlling oxygen permeability and a layer for controlling, for example, surface slipperiness, strength and adhesion to photosensitive layer are superposed, whereby a photosensitive printing plate excellent in sensitivity, storability and handleability can be produced. The combination of layers laminated varies depending on the function to which importance is attached, but representative examples of the combination include a construction such that the lowest layer in contact with a photosensitive layer has a function of enhancing the adhesion between the photosensitive layer and the protective layer, the layer thereon has a function of controlling the oxygen permeability, and the layer further thereon has a function of controlling the physical properties of the protective layer, such as slipperiness and attachment to inserting paper. By superposing layers in this way to form a protective layer, a protective layer with functional separation can be designed.

(1) The outermost layer (upper) layer comes into contact with an inserting paper interposed between a printing plate and a printing plate at the time of forming a stacked body by stacking photosensitive lithographic printing plates, and the dynamic friction coefficient between the protective layer surface of the lithographic printing plate and the inserting paper is preferably from 0.2 to 0.7. Within this range, the passing suitability in a plate setter is remarkably enhanced. If the dynamic friction coefficient between the protective layer surface and the inserting paper is out of the above-described range, not only the passing suitability in a plate setter is worsened but also there arise the following problems. That is, if the dynamic friction coefficient is less than 0.2, the plate materials may slide over each other to cause collapse of cargo at the time of stacking a large number of plate materials and transporting the stacked body, whereas if it exceeds 0.7, the conveyability and scratch-preventing effect may decrease. The dynamic friction coefficient is more preferably from 0.3 to 0.6.
Here, the dynamic friction coefficient as used in the present invention is a value measured according to JIS P 8147. Incidentally, for adjusting the dynamic friction coefficient between the protective layer surface and the inserting paper to the range specified above, a method of controlling the mixing ratio of a polymer having a high frictional coefficient and a polymer having a low frictional coefficient, or a method of adding a surfactant or polymer affecting the slipperiness, may be employed.
The material which can be used is preferably, for example, a water-soluble polymer compound. Specific examples thereof include a water-soluble polymer such as polyvinyl alcohol, vinyl alcohol/vinyl phthalate copolymer, vinyl acetate/vinyl alcohol/vinyl phthalate copolymer, vinyl acetate/crotonic acid copolymer, polyvinylpyrrolidone, acidic

celluloses, gelatin, gum arabic, polyacrylic acid, polyacrylamide, polyester and polyurethane. These may be used individually or as a mixture.

Furthermore, a filler such as silica gel and mica may also be added thereto to adjust the surface physical properties.

An inorganic layered compound is incorporated.

The inorganic layered compound for use in the present invention is a particle having a thin plate-like shape, and examples thereof include a mica family represented by the formula: $A(B,C)_{2-5}D_4O_{10}(OH,F,O)_2$ [wherein A is any one of K, Na and Ca, B and C each is any one of Fe(II), Fe(III), Mn, Al, Mg and V, and D is Si or Al], such as natural mica and synthetic mica; talc represented by the formula: $3MgO \cdot 4SiO \cdot H_2O$; taeniolite; montmorillonite; saponite; hectorite; and zirconium phosphate.

In the mica family, examples of the natural mica include muscovite, paragonite, phlogopite, biotite and lepidolite, and examples of the synthetic mica include a non-swelling mica such as fluorophlogopite $KMg_3(AlSi_3O_{10})F_2$ and potassium tetrasilicic mica $KMg_{2.5}(Si_4O_{10})F_2$, and a swelling mica such as Na tetrasilicic mica $NaMg_{2.5}(Si_4O_{10})F_2$, Na or Li taeniolite $(Na,Li)Mg_2Li(Si_4O_{10})F_2$ and montmorillonite-based Na or Li hectorite $(Na,Li)_{1/8}Mg_{2/5}Li_{1/8}(Si_4O_{10})F_2$. Furthermore, synthetic smectite is also useful.

Among these inorganic layered compounds, a fluorine-based swelling mica which is a synthetic inorganic layered compound, is preferred in the present invention. More specifically, this swelling synthetic mica and swelling clay minerals such as montmorillonite, saponite, hectorite and bentonite have a laminate structure comprising a unit crystal lattice layer having a thickness of approximately from 1 nm to 1.5 nm (10 to 15 Å), and the degree of metal atom substitution in the lattice is significantly higher than that of other clay minerals. As a result, a shortage of positive charges arises in the lattice layer and in order to compensate therefor, a cation such as $Na^+$, $Ca^{2+}$ and $Mg^{2+}$ is adsorbed between the layers. This cation present between the layers is called an exchangeable cation and can be exchanged with various cations. Particularly, in the case where the cation between the layers is $Li^+$ or $Na^+$, the ionic radius is small and therefore, the bond between the layered crystal lattices is weak to allow for great swelling with water. When shearing is applied in this state, the bond is readily cleaved, and a sol which is stable in water is formed.

The bentonite and swelling synthetic mica strongly show this tendency and are useful in the present invention. In particular, a swelling synthetic mica is preferred.

With respect to the profile of the inorganic layered compound for use in the present invention, from the standpoint of control of diffusion, the thickness is preferably smaller and as long as the smoothness of the coated surface or the transparency to actinic rays is not impaired, the plane size is preferably larger. Accordingly, the aspect ratio is 20 or more, preferably 100 or more, more preferably 200 or more. Incidentally, the aspect ratio is a ratio of thickness to long diameter of a particle and can be measured, for example, from a projection view by a microphotograph of particles. As the aspect ratio is larger, the effect obtained is higher.

With respect to the particle diameter of the inorganic layered compound for use in the present invention, the average long diameter is from 0.3 to 20 $\mu$m, preferably from 0.5 to 10$\mu$m, more preferably from 1 to 5 $\mu$m. The average thickness of the particle is 0.1 $\mu$m or less, preferably 0.05 $\mu$m or less, more preferably 0.01 $\mu$m or less. For example, the swelling synthetic mica as a representative compound of the inorganic layered compound has a thickness of 1 to 50 nm and a plane size of approximately from 1 to 20 $\mu$m.

When an inorganic layered compound particle having such a large aspect ratio is incorporated into the protective layer, the coating film strength is enhanced and the permeation of oxygen or free water is effectively prevented, so that the protective layer can be prevented from deterioration due to deformation or the like.

The amount of the inorganic layered compound contained in the protective layer is from 5 to 55 mass%, preferably from 10 to 40 mass%, based on the entire solid content of the protective layer. When the inorganic layered compound content is 5 mass% or more, a sufficiently high effect is obtained on the adhesion resistance, and when the content is 55 mass% or less, the coating film is satisfactorily formed and the sensitivity is also good. Even in the case of using a plurality of kinds of inorganic layered compounds in combination, the total amount of these inorganic layered compounds is preferably in the above-described range.

An example of the method generally employed for dispersing the inorganic layered compound for use in the protective layer is described below. First, from 5 to 10 parts by mass of a swelling layered compound described above as a preferred inorganic layered compound is added to 100 parts by mass of water and after being well wetted and swelled with water, dispersed by using a disperser. Examples of the disperser used here include various mills of effecting dispersion by directly applying a mechanical force, a high-speed stirring-type disperser having a large shearing force, and a disperser of giving a high-intensity ultrasonic energy. Specific examples thereof include a ball mill, a sand grinder mill, a visco-mill, a colloid mill, a homogenizer, a dissolver, a polytron, a homomixer, a homoblender, a KD mill, a jet agitator, a capillary-type emulsifier, a liquid siren, an electromagnetic strain-type ultrasonic generator, and an emulsifier with Paulman whistle. A dispersion containing from 5 to 10 mass% of the inorganic layered compound dispersed by the above-described method is in a highly viscous or gelled state, and its storage stability is remarkably good. At the time of preparing a coating solution for protective layer by using this dispersion, the dispersion is preferably diluted with water, thoroughly stirred and blended with a binder solution.

The amount of the inorganic layered compound contained in the protective layer is preferably from 5/1 to 1/100 in terms of the mass ratio to the amount of the binder used in the protective layer. Within this range, a sufficiently high effect can be obtained. Even in the case of using a plurality of kinds of inorganic layered compounds in combination, the total amount of these inorganic layered compounds is preferably in the above-described range.

(2) The protective layer having a function of controlling the permeability, which is mainly used as an intermediate layer, is described below. This intermediate layer preferably has an oxygen permeability A of $1.0 \leq A \leq 20$ ($cm^3/m^2 \cdot day$) at 25°C under 1 atm. By adjusting the oxygen permeability A to this range, an unnecessary polymerization reaction does not take place during production or stock storage or a problem such as occurrence of unnecessary fogging or thickening of image line does not arise at the image exposure, and good sensitivity is obtained.

As for the properties required of the protective layer, in addition to the above-described oxygen permeability, it is preferred that the protective layer does not substantially inhibit transmission of light used for exposure, exhibits excellent adhesion to the photosensitive layer and is readily removed in the development step after exposure. Various studies have been heretofore made on the protective layer having such properties, and these are described in detail, for example, in U.S. Patent 3,458,311 and JP-B-55-49729 (the term "JP-B" as used herein means an "examined Japanese patent publication").

The material which can be used in the protective layer is preferably, for example, a water-soluble polymer compound having relatively excellent crystallinity. Specific examples thereof include a water-soluble polymer such as polyvinyl alcohol, vinyl alcohol/vinyl phthalate copolymer, vinyl acetate/vinyl alcohol/vinyl phthalate copolymer, vinyl acetate/crotonic acid copolymer, polyvinylpyrrolidone, acidic celluloses, gelatin, gum arabic, polyacrylic acid, polyacrylamide, polyester and polyurethane. These may be used individually or as a mixture. Among these, a polyvinyl alcohol is preferably used as the main component, because most preferred results are obtained in view of fundamental properties such as oxygen-blocking property and development removability.

As long as the polyvinyl alcohol contains an unsubstituted vinyl alcohol unit for giving necessary oxygen-blocking property and water solubility, a part of the polyvinyl alcohol for use in the protective layer may be substituted by an ester, an ether or an acetal or may have another copolymerization component. Examples of the polyvinyl alcohol include those having a hydrolysis degree of 71 to 100% and containing a repeating unit with a polymerization degree of 300 to 2,400. Specific examples thereof include PVA-105®, PVA-110®, PVA-117®, PVA-117H®, PVA-120®, PVA-124®, PVA-124H®, PVA-CS®, PVA-CST®, PVA-HC®, PVA-203®, PVA-204®, PVA-205®, PVA-210®, PVA-217®, PVA-220®, PVA-224®, PVA-217EE®, PVA-217E®, PVA-220E®, PVA-224E®, PVA-405®, PVA-420®, PVA-613®, L-8®, KL-506®, KL-318®, KL-118®, KM-618®, KM-118®, C-506®, R-2105®, R-1130®, R-2130®, M-205®, MP-203®, LM15®, LM20® and LM25® produced by

Kuraray Co., Ltd. These may be used individually or as a mixture. The-content of the polyvinyl alcohol in the protective layer is preferably from 20 to 95 mass%, more preferably from 30 to 90 mass%.

(3) The lower layer in contact with the photosensitive layer is required to have a function of keeping adhesion to the photosensitive layer and ensuring difficult separation therefrom.

The material therefor can be selected from those described above for the upper layer. In particular, a resin such as polyester and polyurethane is preferred.

A surfactant may be added to any layer of the protective layer for use in the present invention. Examples of the surfactant which can be used include a nonionic surfactant such as polyoxyethylene alkyl ethers (e.g., polyoxyethylene castor oil ether, polyoxyethylene lauryl ether, polyoxyethylene cetyl ether, polyoxyethylene stearyl ether), polyoxyethylene alkyl allyl ethers (e.g., polyoxyethylene octyl phenyl ether, polyoxyethylene nonyl phenyl ether), polyoxyethylene alkyl esters (e.g., polyoxyethylene stearate), sorbitan alkyl esters (e.g., sorbitan monolaurate, sorbitan monostearate, sorbitan distearate, sorbitan monooleate, sorbitan sesquioleate, sorbitan trioleate), and monoglyceride alkyl esters (e.g., glycerol monostearate, glycerol monooleate); an anionic surfactant such as alkylbenzenesulfonates (e.g., sodium dodecylbenzenesulfonate), alkylnaphthalenesulfonates (e.g., sodium butylnaphthalenesulfonate, sodium pentylnaphthalenesulfonate, sodium hexylnaphthalenesulfonate, sodium octylnaphthalenesulfonate), alkylsulfates (e.g., sodium laurylsulfate), alkylsulfonates (e.g., sodium dodecylsulfonate), and sulfosuccinic ester salts (e.g., sodium dilaurylsulfosuccinate); and an amphoteric surfactant such as alkylbetaines (e.g., laurylbetaine, stearylbetaine) and amino acids.

Among these surfactants, a polyoxyethylene castor oil ether-based surfactant is preferred. The castor oil which is the main component of the polyoxyethylene castor oil ether-based surfactant is a vegetable nondrying oil obtained from a castor bean seed by a milling process. The castor bean seed contains from 35 to 57% of oil based on the entire seed. As for the component, the castor oil contains about 85% of ricinoleic acid which is an unsaturated carboxylic acid. The ricinoleic acid is a stearic acid derivative having a carboxy group at the terminal, a hydroxyl group at the 12-position and an unsaturated double bong at the 9-position. The polyoxyethylene castor oil ether surfactant is a generic term of nonionic surfactants synthesized by adding an ethylene oxide to a ricinoleic acid which is the main component of the castor oil. In the process of the addition reaction, the hydroxy group of the ricinoleic acid reacts with the carboxylic acid group to form a polyester and depending on the conditions, even a surfactant containing a polymer having a molecular

weight as large as from 10,000 to 20,000 can be formed.

The polyoxyethylene castor oil ether surfactant also includes a surfactant obtained by adding an ethylene oxide to glycerol of a ricinoleic acid.

The polyoxyethylene castor oil ether surfactant suitably used in the present invention has HLB of 10.0 to 16.0, preferably from 11.0 to 15.0. If the HLB is less than 10.0, the water solubility is low and when the surfactant is added to an aqueous polyvinyl alcohol solution, the resulting solution becomes turbid, whereas if HLB exceeds 16, the hydrophilicity is too high and the hygroscopicity of the protective layer increases. The mass average molecular weight of the polyoxyethylene castor oil ether surfactant is from 800 to 5,000, preferably from 1,000 to 3,000. If the mass average molecular weight is excessively small, the effect of reducing the frictional coefficient is not obtained, whereas if it is too large, the solubility decreases.

Specific examples of the polyoxyethylene castor oil ether surfactant include Pionin D-225®, Pionin D-240-W®, Pionin D-230®, Pionin D-236® and Pionin D-225-K® produced by Takemoto Oil & Fat Co., Ltd.; and Emanon CH-25®, Emanon CH-40® and Emanon CH-60® prodcued by Kao Corp.

The amount of the polyoxyethylene castor oil ether surfactant added is from 1.0 to 10 mass%, preferably from 2.0 to 6.0 mass%, based on the entire solid content of the protective layer. If the amount added is small, the effect for reducing frictional coefficient decreases, whereas if the amount added is excessively large, coatability of the protective layer is deteriorated and coating unevenness occurs.

The coated amount of the protective layer is, in terms of the dry mass, generally from 0.1 to 10 $g/m^2$, preferably from 0.5 to 5 $g/m^2$. In terms of individual layers, the coated amount of any layer is preferably from 0.1 to 3 $g/m^2$. The coating method includes a method of sequentially coating the layers and a method of coating and superposing the layers all at once, and either method may be used.

<Photosensitive Layer>

The photopolymerizable composition for forming the photosensitive layer of the photosensitive lithographic printing plate of the present invention comprises a compound having an ethylenically unsaturated double bond (hereinafter simply referred to as an "ethylenically unsaturated bond-containing compound"), an alkali water-soluble or swellable binder, preferably an alkali water-soluble or swellable polymer binder having a crosslinking group, and a polymerization initiation system, and if desired, further contains various compounds such as coloring agent, plasticizer and thermal polymerization inhibitor.

[Ethylenically Unsaturated Bond-Containing Compound]

The ethylenically unsaturated bond-containing compound is a compound having at least one ethylenically unsaturated bond and contributes to crosslinking or curing by being addition-polymerized under the action of a photopolymerization initiator when the photopolymerizable compound is irradiated with actinic rays.

The ethylenically unsaturated bond-containing compound can be arbitrarily selected, for example, from the compounds having at least one, preferably two or more, more preferably from 2 to 6, terminal ethylenically unsaturated bond(s). These are a compound having a chemical mode such as monomer, prepolymer (that is, dimer, trimer or oligomer) or a mixture or copolymer thereof.

Examples of the ethylenically unsaturated bond-containing compound include an ester of an unsaturated carboxylic acid (e.g., acrylic acid, methacrylic acid, itaconic acid, crotonic acid, isocrotonic acid, maleic acid) with an aliphatic polyhydric alcohol compound, and an amide of the unsaturated carboxylic acid with an aliphatic polyvalent amine compound. With respect to specific examples of the monomer of the ester between an aliphatic polyhydric alcohol compound and an unsaturated carboxylic acid, examples of acrylic esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)pheny]dimethylmethane, and bis[p-(methacryloxyethoxy)phenyl]dimethylmethane.

Examples of itaconic esters include ethylene glycol diitaconate, propylene glycol diitaconate, 1,5-butanediol

diitaconate, 1,4-butanediol diitaconate, tetramethylene glycol diitaconate, pentaerythritol diitaconate, and sorbitol tetraitaconate. Examples of crotonic esters include ethylene glycol dicrotonate, tetramethylene glycol dicrotonate, pentaerythritol dicrotonate, and sorbitol tetradicrotonate. Examples of isocrotonic esters include ethylene glycol diisocrotonate, pentaerythritol diisocrotonate, and sorbitol tetraisocrotonate.

Examples of maleic esters include ethylene glycol dimaleate, triethylene glycol dimaleate, pentaerythritol dimaleate, and sorbitol tetramaleate. In addition, mixtures of the foregoing ester monomers can be enumerated. Furthermore, specific examples of the monomer of the amide between an aliphatic polyhydric amine compound and an unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamdie, and xylylene bismethacrylamide.

Other examples include vinyl urethane compounds containing two or more polymerizable vinyl groups in one molecule thereof resulting from adding a hydroxyl group-containing vinyl monomer represented by the following formula (m) to a polyisocyanate compound containing two or more isocyanate groups in one molecule thereof as described in JP-B-48-41708.

$$CH_2=C(R)COOCH_2CH(R')OH \qquad (m)$$

In the foregoing formula (m), R and R' each independently represents H or $CH_3$.

Furthermore, urethane acrylates as described in JP-A-51-37193 and JP-B-2-32293; polyester acrylates as described in JP-A-48-64183, JP-B-49-43191, and JP-B-52-30490; and polyfunctional acrylates or methacrylates such as epoxy acrylates obtained by reaction between an epoxy resin and (meth)acrylic acid can be enumerated. Photocurable monomers and oligomers as introduced in Journal of the Adhesion Society of Japan, Vol. 20, No. 7, pages 300 to 308 (1984) can also be used. Incidentally, the amount of such an ethylenically unsaturated bond-containing compound to be used is usually in the range of from 5 to 80 % by weight, and preferably from 30 to 70 % by weight based on the total weight of the photosensitive layer.

[Polymer binder]

In the photosensitive layer of the invention, a polymer binder is contained, and preferably a polymer binder having a crosslinking group in the side chain thereof is contained.

The crosslinking group as referred to herein means a group for crosslinking a polymer binder in the process of radical polymerization reaction which is caused in the photosensitive layer during exposing the photosensitive lithographic printing plate. The crosslinking group is not particularly limited so far as it has such a function. Examples of a functional group which can be subjected to addition polymerization reaction include an ethylenically unsaturated bond group, an amino group, and an epoxy group. Furthermore, the crosslinking group may be a functional group which can become a radical upon irradiation with light. Examples of such a crosslinking group include a thiol group, a halogen group, and an onium salt structure. Above all, an ethylenically unsaturated bond group is preferable, and functional groups represented by the following formulae (1) to (3) are especially preferable.

Formula (1)

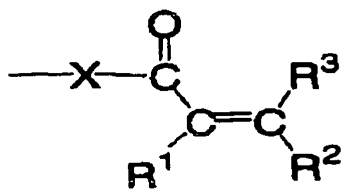

In the foregoing formula (1), $R^1$ to $R^3$ each independently represents a monovalent organic group. Preferred examples of $R^1$ include a hydrogen atom and an optionally substituted alkyl group; and above all, a hydrogen atom and a methyl group are preferable because of high radical reactivity. Examples of each of $R^2$ and $R^3$ include a hydrogen atom, a halogen atom, an amino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, and an optionally substituted arylsulfonyl group; and above all, a hydrogen atom, a carboxyl group, an alkoxycarbonyl group, an optionally substituted alkyl group, and an optionally substituted aryl group are preferable because of high radical reactivity.

X represents an oxygen atom, a sulfur atom, or $-N(R^{12})-$; and $R^{12}$ represents a hydrogen atom or a monovalent

organic group. Here, examples of $R^{12}$ include an optionally substituted alkyl group; and above all, a hydrogen atom, a methyl group, an ethyl group, and an isopropyl group are preferable because of high radical reactivity.

Here, examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amide group, an alkylsulfonyl group, and an arylsulfonyl group.

Formula (2)

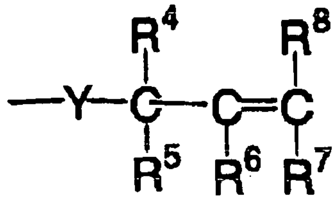

In the foregoing formula (2), $R^4$ to $R^8$ each independently represents a monovalent organic group. Preferred examples of each of $R^4$ to $R^8$ include a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, and an optionally substituted arylsulfonyl group; and above all, a hydrogen atom, a carboxyl group, an alkoxycarbonyl group, an optionally substituted alkyl group, and an optionally substituted aryl group are preferable. As the substituent which can be introduced, those which are the same as in the formula (1) are enumerated.

Y represents an oxygen atom, a sulfur atom, or $-N(R^{12})-$. $R^{12}$ is synonymous with $R^{12}$ in the formula (1), and preferred examples thereof are also the same.

Formula (3)

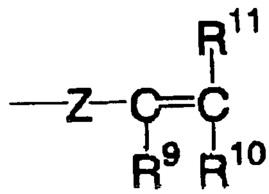

In the foregoing formula (3), examples of $R^9$ preferably include a hydrogen atom or an optionally substituted alkyl group. Above all, a hydrogen atom and a methyl group are preferable because of high radical reactivity. $R^{10}$ and $R^{11}$ each independently represents a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group. Above all, a hydrogen atom, a carboxyl group, an alkoxycarbonyl group, an optionally substituted alkyl group, and an optionally substituted aryl group are preferable because of high radical reactivity.

As the substituent which can be introduced, those which are the same as in the formula (1) are enumerated. Furthermore, Z represents an oxygen atom, a sulfur atom, $-N(R^{13})-$, or an optionally substituted phenylene group. Examples of $R^{13}$ include an optionally substituted alkyl group. Above all, a methyl group, an ethyl group, and an isopropyl group are preferable because of high radical reactivity.

Since the foregoing polymer binder having a crosslinking group in the side chain thereof according to the invention is required such that not only it functions as a film forming agent of the photosensitive layer, but also it is soluble in a developing solution, preferably an alkaline developing solution, it is preferably an alkaline water-soluble or swelling organic high molecular polymer. For that reason, it is preferable that the polymer binder of the invention contains, in addition to a crosslinking group, an alkalisoluble group, for example, a carboxyl group in the side chain thereof.

In the case where the polymer binder having a crosslinking group in the side chain thereof is a water-soluble organic high molecular polymer, water development becomes possible.

Examples of the foregoing polymer binder according to the invention include those as described in JP-A-59-53836 and JP-A-59-71048, namely (meth)acrylic acid copolymers, itaconic acid copolymers, crotonic acid copolymers, maleic acid copolymers, and partially esterified maleic acid copolymers, each having a crosslinking group (for example, an allyl group and a (meth)acryloyl group) in the side chain thereof.

As the polymer binder according to the invention, polyurethanes, acidic cellulose derivatives, adducts resulting from addition of a cyclic acid anhydride to a hydroxyl group-containing addition polymer, and the like are also useful.

Above all, (meth)acrylic acid copolymers and polyurethanes are more preferable. Polyurethane resins are especially preferable because nevertheless an acid value of the photosensitive layer is low, they can inhibit development damage in an exposed area without reducing developability in an unexposed area and have both good staining properties and high printing resistance.

The polyurethane resin having a crosslinking group in the side chain thereof will be hereunder described in more detail.

The polyurethane resin having a crosslinking group in the side chain thereof which is especially preferably used in the invention can be obtained by polyaddition reaction of (i) a diisocyanate compound, (ii) a carboxyl group-containing diol compound and (iii) a crosslinking group-containing diisocyanate compound, and optionally, (iv) a carboxyl group-free diol compound.

The diisocyanate compound and the diol compound which are the raw materials of the foregoing polyurethane resin will be hereunder described.

(i) Diisocyanate compound:

Examples of the diisocyanate compound include a diisocyanate compound represented by the formula (4).

OCN-L-NCO (4)

In the foregoing formula (4), L represents an optionally substituted divalent aliphatic or aromatic hydrocarbon group. If desired, L may contain other functional group which does not react with the isocyanate group, for example, a carbonyl group, an ester group, a urethane group, an amide group, and an ureido group. More specifically, L represents a single bond or an optionally substituted divalent aliphatic or aromatic hydrocarbon group (preferred examples of the substituent include an alkyl group, an aralkyl group, an aryl group, an alkoxy group, and a halogeno group). Above all, an alkylene group having from 1 to 20 carbon atoms and an arylene group having from 6 to 15 carbon atoms are preferable; and an alkylene group having from 1 to 8 carbon atoms is more preferable. Furthermore, if desired, L may contain other functional group which does not react with the isocyanate group, such as a carbonyl group, an ester group, a urethane group, an amide group, an ureido group, and an ether group.

Specific examples thereof include aromatic diisocyanate compounds (for example, 2,4-tolylene diisocyanate, a dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthylene diisocyanate, and 3,3'-dimethylbiphenyl-4,4'-diisocyanate); aliphatic diisocyanate compounds (for example, hexamethylene diisocyanate, trimethylhexamethylene diisocyanate, lysine diisocyanate, and dimeric acid diisocyanate); alicyclic diisocyanate compounds (for example, isophorone diisocyanate, 4,4'-methylenebis(cyclohexyl isocyanate), methylcyclohexane-2,4-(or 2,6-)diisocyanate, and 1,3-(isocyanatomethyl)cyclohexane; and diisocyanate compound which is a reaction product between a diol and a diisocyanate (for example, an adduct of one mole of 1,3-butylene glycol and 2 moles of tolylene diisocyanate).

The diisocyanate compound may be used singly or in combination of two or more kinds thereof. In view of a balance between printing resistance and staining properties, it is preferred to use a combination of two or more kinds thereof. It is especially preferred to use at least one kind of each of an aromatic diisocyanate compound (wherein L represents an aromatic group) and an aliphatic diisocyanate compound (wherein L represents an aliphatic group).

The amount of the diisocyanate to be used is preferably from 0.8 to 1.2, and more preferably from 0.9 to 1.1 in terms of a molar ratio to the diol compound. In the case where an excess of the diisocyanate compound is used against the diol compound so that the isocyanate group remains in the polymer terminals, it is preferable that after completion of urethanization reaction, the reaction product is treated with an alcohol or an amine so that the polyurethane resin is finally synthesized in the form that no isocyanate group remains.

(ii) Diol compound containing at least one carboxyl group:

Examples of the diol compound containing at least one carboxyl group include diol compounds represented by the formulae (5), (6) and (7) and/or compounds resulting from ring opening of a tetracarboxylic dianhydride with a diol compound. The diol compound which is used for ring opening of a tetracarboxylic dianhydride can be used.

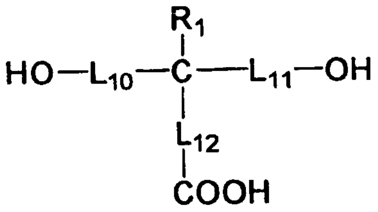

(5)

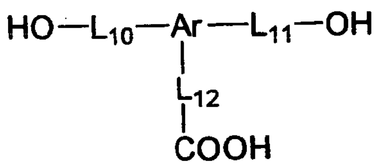

(6)

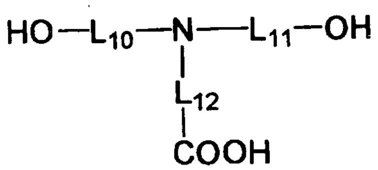

(7)

In the foregoing formulae, $R_1$ represents a hydrogen atom or an optionally substituted alkyl group, aralkyl group, aryl group, alkoxy group or aryloxy group (examples of the substituent include a cyano group, a nitro group, a halogen atom (for example, -F, -Cl, -Br, and -I), a $-CONH_2$ group, a $-COOR_{113}$ group, an $-OR_{113}$ group, an $-NHCOOR_{113}$ group, an $-NHCOR_{113}$ group, an $-NHCONHR_{113}$ group, and an - $OCONHR_{113}$ (wherein $R_{113}$ represents an alkyl group having from 1 to 10 carbon atoms or an aralkyl group having from 7 to 15 carbon atoms); and preferably a hydrogen atom, an alkyl group having from 1 to 8 carbon atoms, or an aryl group having from 6 to 15 carbon atoms. $L_{10}$, $L_{11}$, and $L_{12}$ may be the same or different and each represents a single bond or an optionally substituted divalent aliphatic or aromatic hydrocarbon group (examples of the substituent include an alkyl group, an aralkyl group, an aryl group, an alkoxy group, and a halogeno group); preferably an alkylene group having from 1 to 20 carbon atoms or an arylene group having from 6 to 15 carbon atoms; and more preferably an alkylene group having from 1 to 8 carbon atoms. If desired, $L_{10}$, $L_{11}$, and $L_{12}$ may each contain a functional group which does not react with the isocyanate group (example of the functional group include a carbonyl group, an ester group, a urethane group, an amide group, an ureido group, and an ether group). Incidentally, two or three of $R_1$, $L_{10}$, $L_{11}$, and $L_{12}$ may be taken together to form a ring. Ar represents an optionally substituted trivalent aromatic hydrocarbon group, and preferably an aromatic group having from 6 to 15 carbon atoms.

Specific examples of the carboxyl group-containing diol compound represented by the formula (5), (6) or (7) include the following compounds.

Namely, examples include 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)-acetic acid, 2,2-bis(hydroxymethyl)butyric acid, 4,4-bis(4-hydroxyphenyl)pentanoic acid, tartaric acid, N,N-dihydroxyethylglycine, and N,N-bis(2-hydroxyethyl)-3-carboxy-propionamide.

Preferred examples of the tetracarboxylic dianhydride which is used for the formation of at least one kind of a diol compound containing at least one carboxyl group include compounds represented by the formulae (8), (9) and (10).

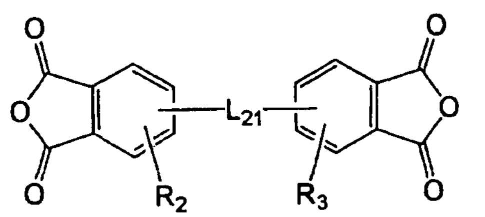

(8)

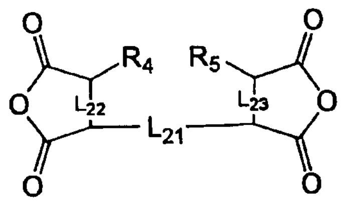

(9)

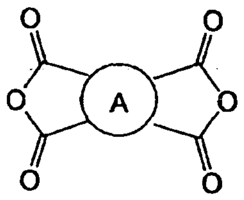

(10)

In the foregoing formulae, $L_{21}$ represents a single bond, an optionally substituted divalent aliphatic or aromatic hydrocarbon group (examples of the substituent include an alkyl group, an aralkyl group, an aryl group, an alkoxy group, a halogeno group, an ester group, and an amide group), -CO-, -SO-, $-SO_2-$ -O-, or -O-; and preferably a single bond, a divalent aliphatic hydrocarbon group having from 1 to 15 carbon atoms, - CO-, $-SO_2-$, -O-, or -S-. $R_2$ and $R_3$ may be the same or different and each represents a hydrogen atom, an alkyl group, an aralkyl group, an aryl group, an alkoxy group, or a halogeno group; and preferably a hydrogen atom, an alkyl group having from 1 to 8 carbon atoms, an aryl group having from 6 to 15 carbon atoms, an alkoxy group having from 1 to 8 carbon atoms, or a halogeno group. Furthermore, two of $L_{21}$, $R_2$, and $R_3$ may be taken together to form a ring. $R_4$ and $R_5$ may be the same or different and each represents a hydrogen atom, an alkyl group, an aralkyl group, an aryl group, or a halogeno group; and preferably a hydrogen atom, an alkyl group having from 1 to 8 carbon atoms, or an aryl group having from 6 to 15 carbon atoms. Moreover, two of $L_{21}$, $R_4$, and $R_5$ may be taken together to form a ring. $L_{22}$ and $L_{23}$ may be the same or different and each represents a single bond, a double bond, or a divalent aliphatic hydrocarbon group; and preferably a single bond, a double bond, or a methylene group. A represents a mononucleic or polynucleic aromatic ring, and preferably an aromatic ring having from 6 to 18 carbon atoms.

Specific examples of the compound represented by the formula (8), (9) or (10) include the following compounds.

Namely, examples include aromatic tetracarboxylic anhydrides such as pyromellitic dianhydride, 3,3',4,4'-benzophenonetetracarboxylic dianhydride, 3,3',4,4'-diphenyltetracarboxylic dianhydride, 2,3,6,7-naphthalenetetracarboxylic dianhydride, 1,4,5,8-naphthalenetetracarboxylic dianhydride, 4,4'-sulfonyldiphthalic dianhydride, 2,2-bis(3,4-dicarboxyphenyl)propane dianhydride, bis(3,4-dicarboxyphenyl) ether dianhydride, 4,4'-[3,3'-(alkylphosphoryldiphenylene)-bis(iminocarbonyl)]diphthalic dianhydride, an adduct of hydroquinone diacetate and trimellitic anhydride, and an adduct of diacetyldiamine and trimellitic anhydride; alicyclic tetracarboxylic dianhydrides such as 5-(2,5-dioxotetrahydrofuryl)-3-methyl-3-cyclohexene-1,2-dicarboxylic anhydride (EPICLON B-4400, manufactured by Dainippon Ink and Chemicals, Incorporated), 1,2,3,4-cyclopentanetetracarboxylic dianhydride, 1,2,4,5-cyclohexanetetracarboxylic dianhydride, and tetrahydrofurantetracarboxylic dianhydride; and aliphatic tetracarboxylic dianhydrides such as 1,2,3,4-butanetetracarboxylic dianhydride and 1,2,4,5-pentanetetracarboxylic dianhydride.

By ring opening of such a tetracarboxylic dianhydride with a diol compound, it is possible to synthesize (ii) at least one kind of a diol compound containing at least one carboxyl group. However, it is also possible to synthesize the polyurethane resin of the invention by performing reaction between the diol compound and the diisocyanate compound (ii) and allowing this reaction product to react with the foregoing tetracarboxylic dianhydride, and this method is included in the viewpoint of the invention. Namely, examples of a method for introducing a structural unit derived from the tetracarboxylic dianhydride and the diol compound into the polyurethane resin include the following methods.

a) Method for allowing an alcohol-terminated compound as obtained by ring opening of a tetracarboxylic dianhydride with a diol compound to react with a diisocyanate compound.

b) Method for allowing an alcohol-terminated urethane compound as obtained by reaction of a diisocyanate compound with an excess of a diol compound to react with a tetracarboxylic dianhydride.

With respect to the at least one kind of a diol compound containing at least one carboxyl group, the compound represented by the formula (5) is more preferable because it has high solubility in solvent and its synthesis is easy. Furthermore, the at least one kind of a diol compound containing at least one carboxyl group is introduced into the polyurethane resin binder in such an amount that the polyurethane resin binder contains a carboxyl group in an amount ranging from 0.2 to 4.0 meq/g, preferably from 0.3 to 3.0 meq/g, more preferably from 0.4 to 2.0 meq/g, especially

preferably from 0.5 to 1.5 meq/g, and most preferably from 0.6 to 1.2 meq/g. Accordingly, while the content of the structure derived from the at least one kind of a diol compound containing at least one carboxyl group in the polyurethane resin binder is properly chosen depending upon the number of carboxyl groups, what should be used as other diol components, the acid value and molecular weight of the resulting polyurethane resin binder, the composition and pH of the developing solution, and the like, it is, for example, from 5 to 45 % by mole, preferably from 10 to 40 % by mole, and more preferably from 15 to 35 % by mole.

(iii) Crosslinking group-containing diisocyanate compound:

Examples of the crosslinking group-containing diisocyanate compound include a product as obtained by addition reaction of a triisocyanate compound and one equivalent of a crosslinking group-containing monofunctional alcohol or monofunctional amine compound.

Examples of the triisocyanate compound will be given below, but it should not be construed that the invention is limited thereto.

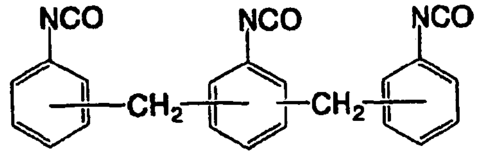

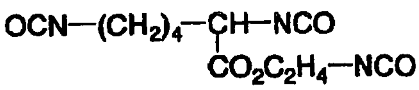

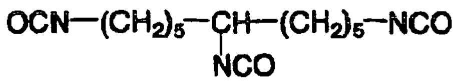

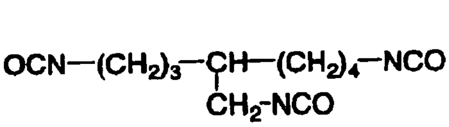

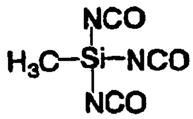

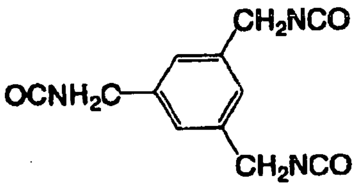

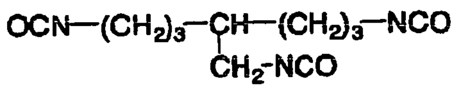

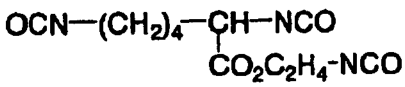

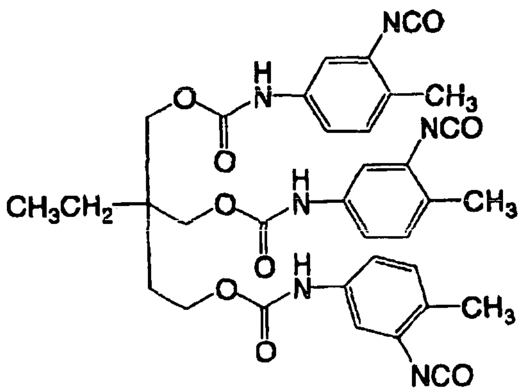

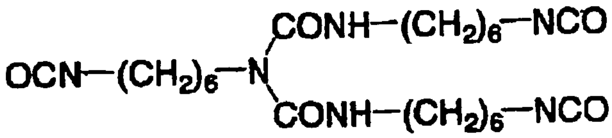

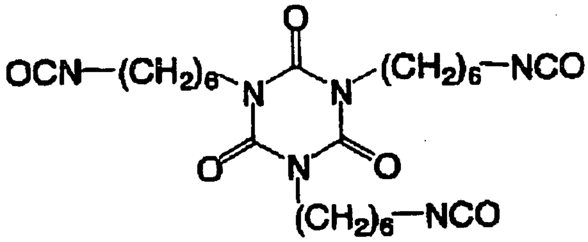

Examples of the crosslinking group-containing monofunctional alcohol or monofunctional amine compound will be given below, but it should not be construed that the invention is limited thereto.

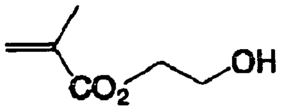
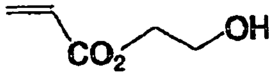

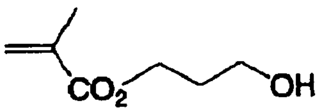
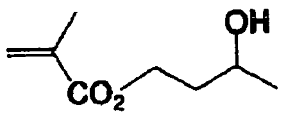

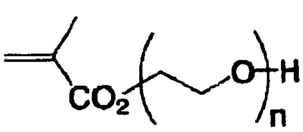
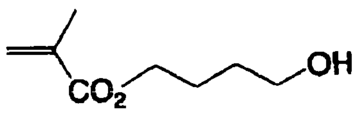

n: an integer of from 2 to 10

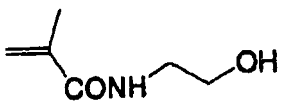
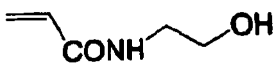

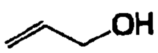
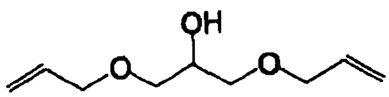

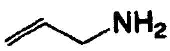
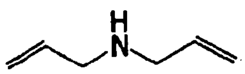

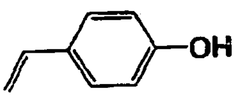
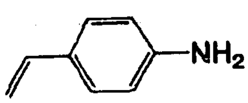

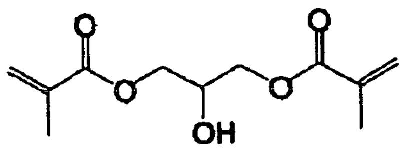

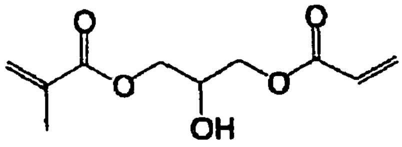

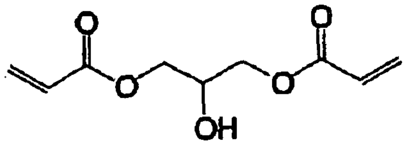

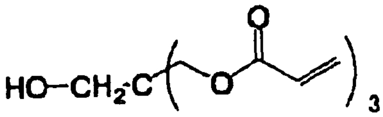

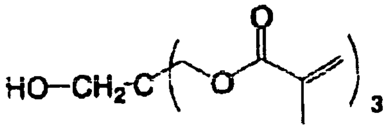

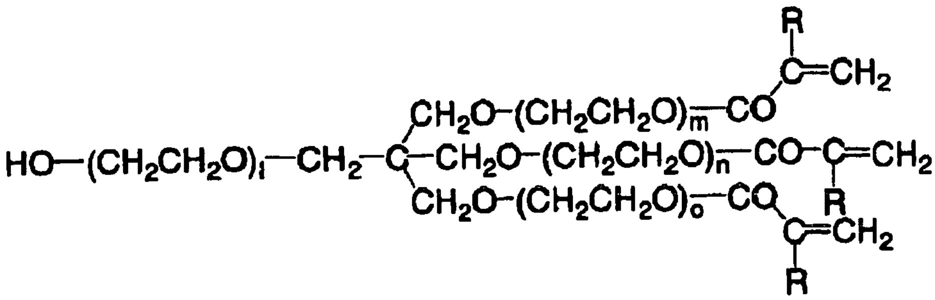

R: hydrogen or a methyl group
1, m, n and o: an integer of from 1 to 20

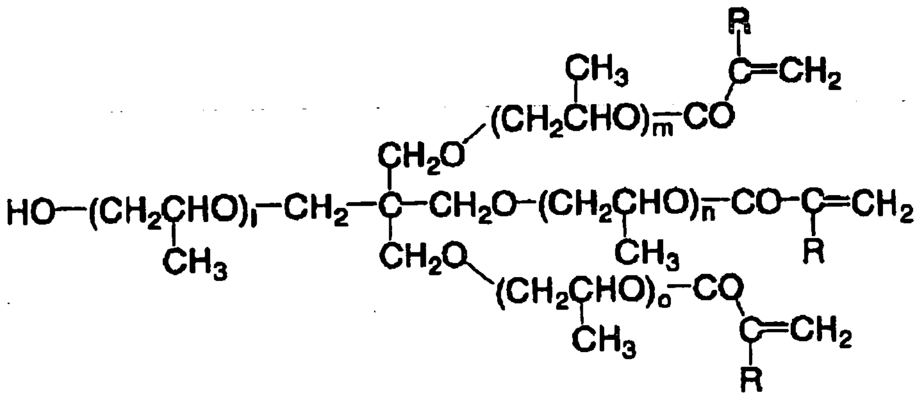

R: hydrogen or a methyl group
1, m, n and o: an integer of from 1 to 20

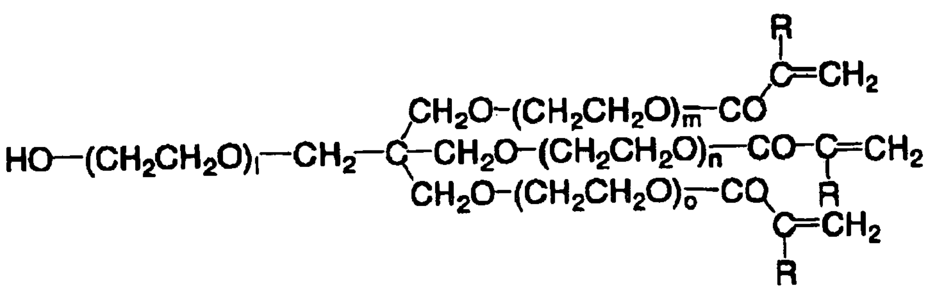

R: hydrogen or a methyl group
1, m, n and o: an integer of from 1 to 20

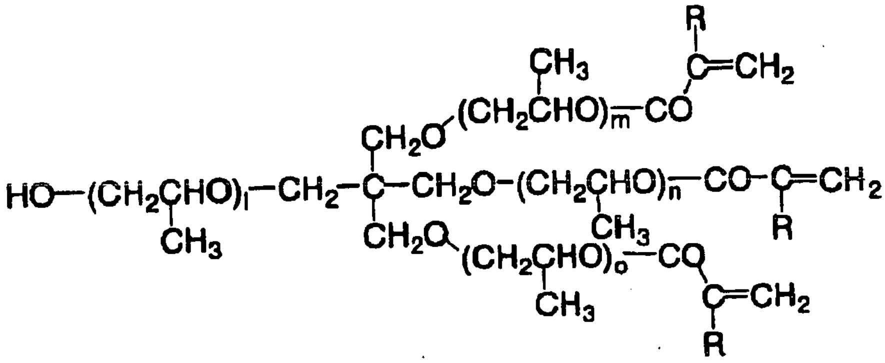

R: hydrogen or a methyl group
1, m, n and o: an integer of from 1 to 20

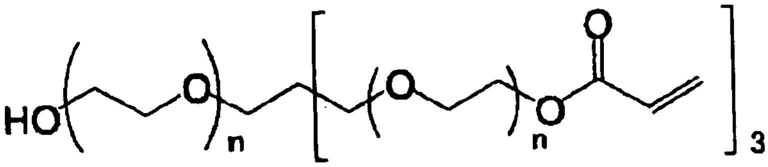

n: an integer of from 2 to 10

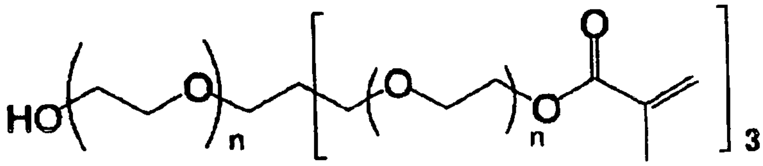

n: an integer of from 2 to 10

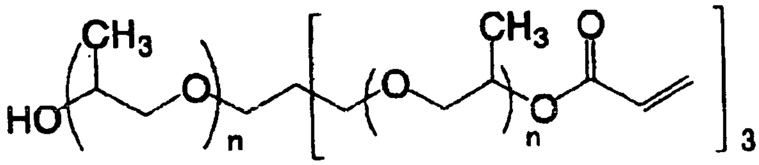

n: an integer of from 2 to 10

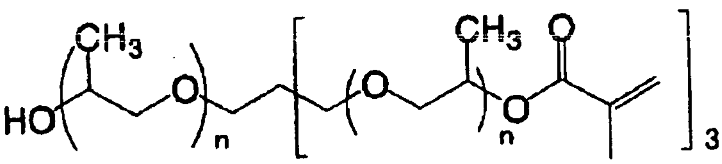

n: an integer of from 2 to 10

Here, as a method for introducing a crosslinking group into the side chain of the polyurethane resin, a method for using a diisocyanate compound having a crosslinking group in the side chain thereof as the raw material for producing a polyurethane resin is suitable. Examples of a diisocyanate compound having a crosslinking group in the side chain thereof, which can be obtained by addition reaction of a triisocyanate compound and one equivalent of a crosslinking

group-containing monofunctional alcohol or monofunctional amine compound will be given below, but it should not be construed that the invention is limited thereto.

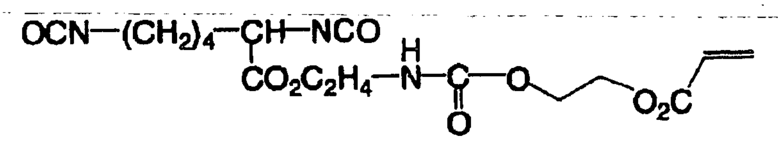

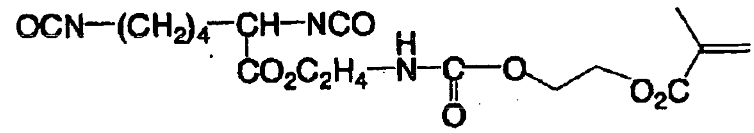

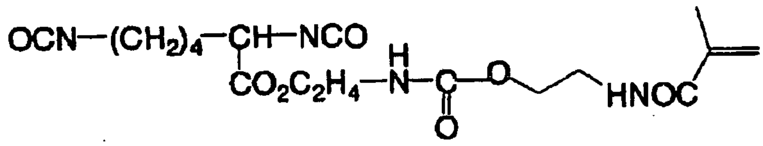

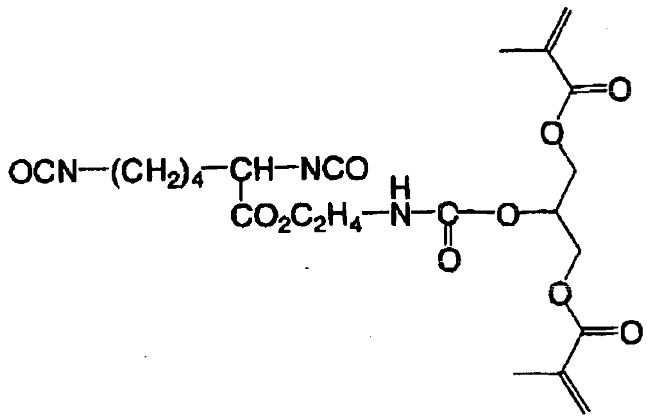

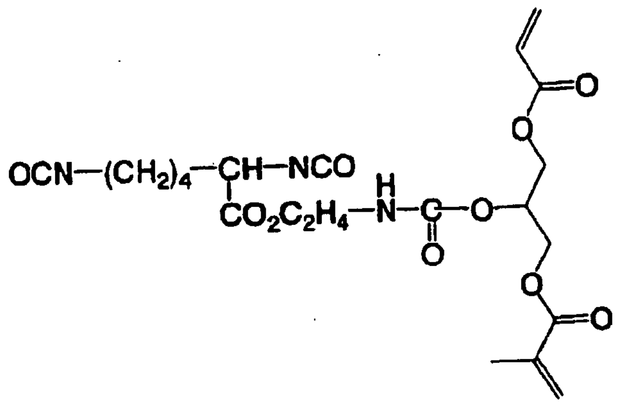

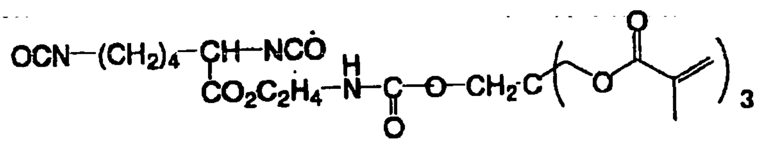

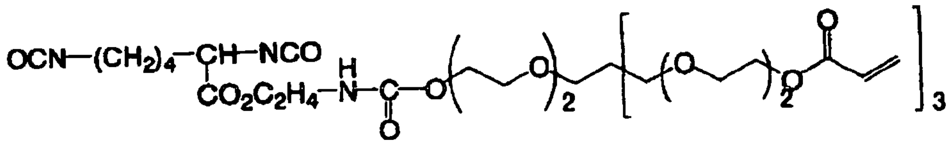

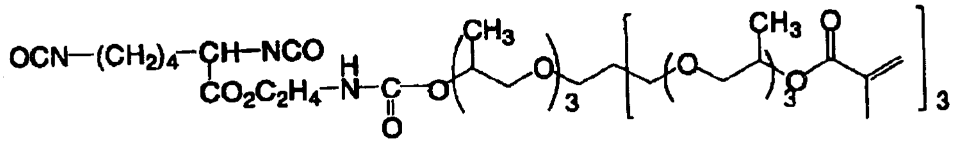

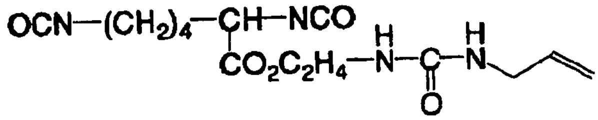

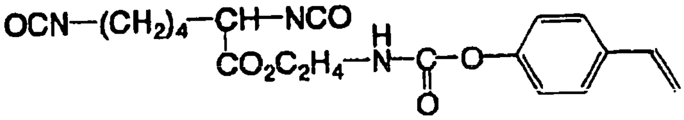

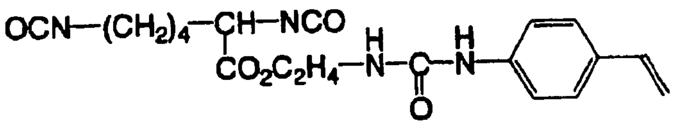

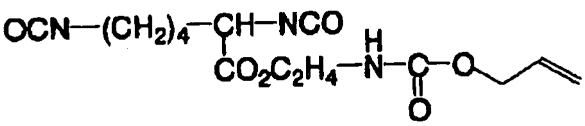

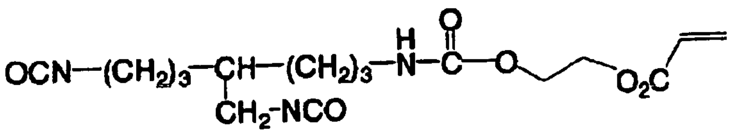

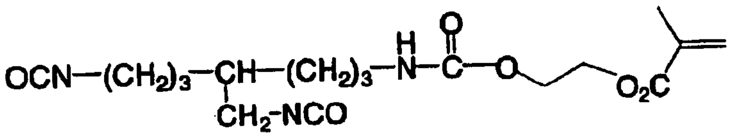

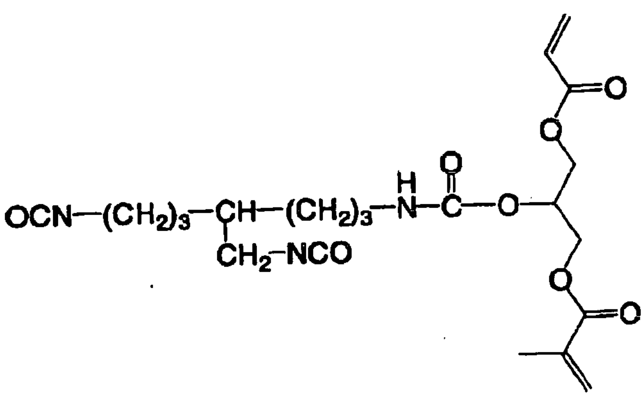

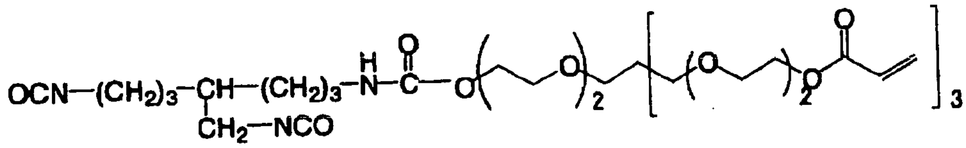

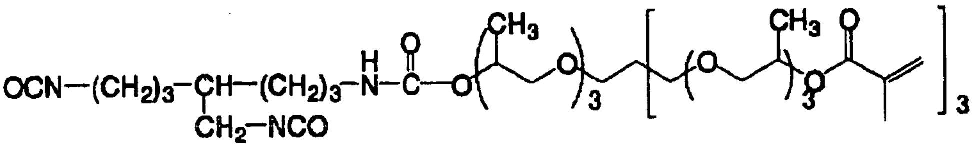

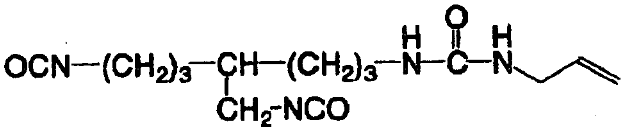

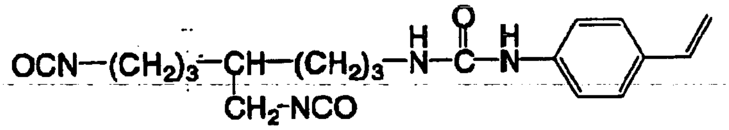

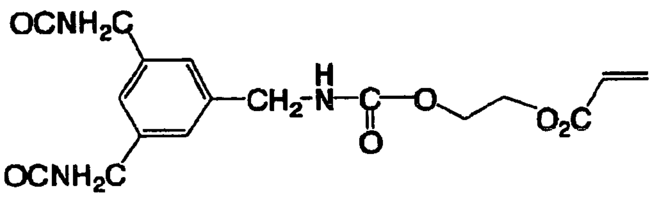

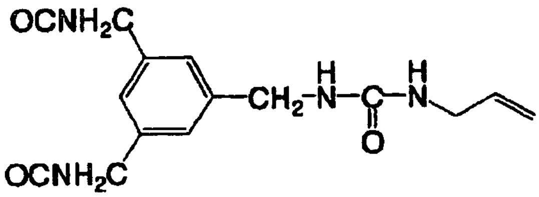

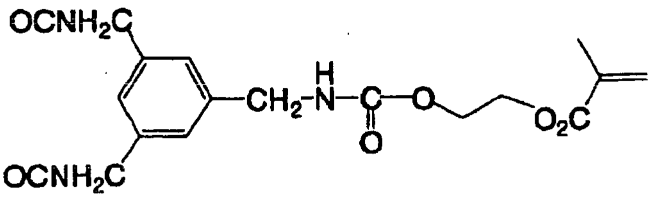

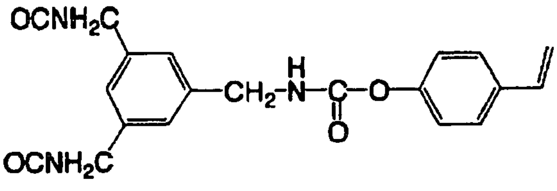

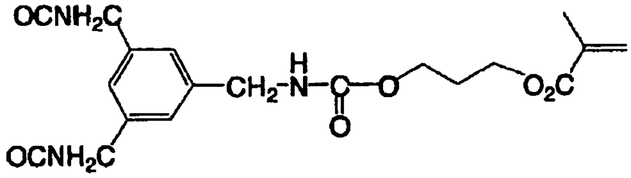

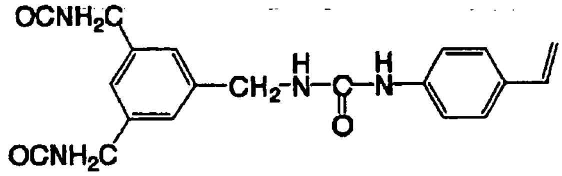

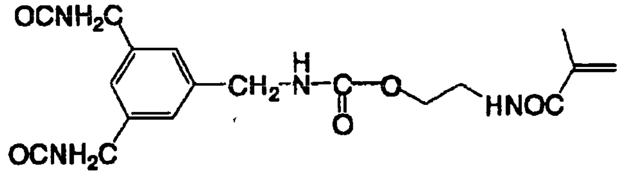

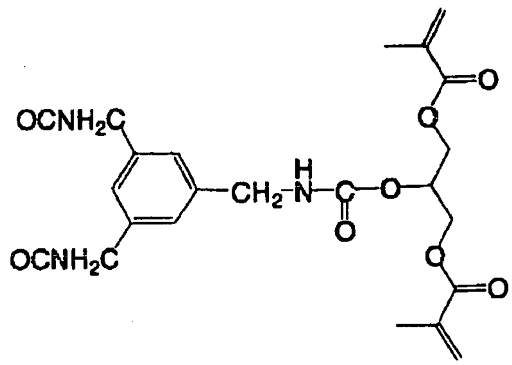

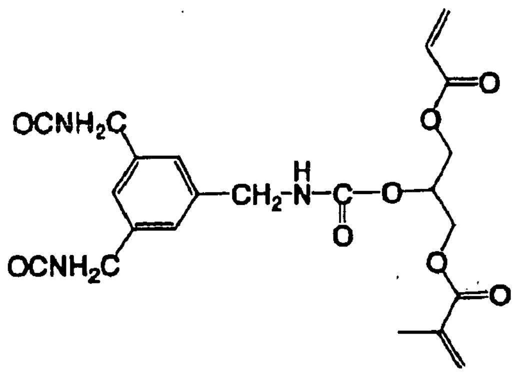

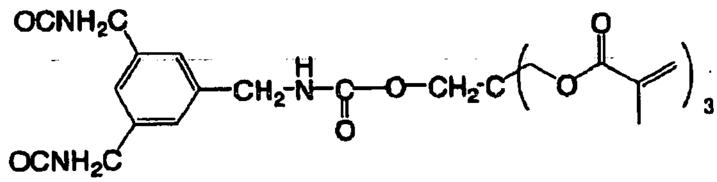

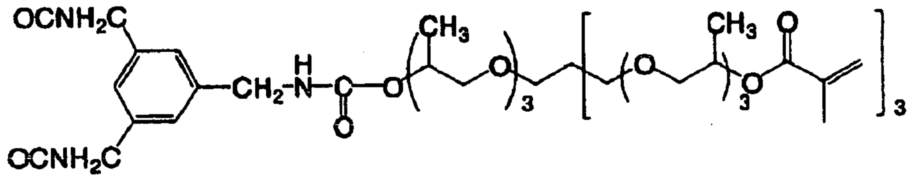

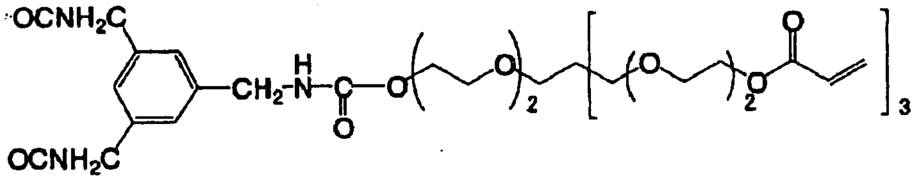

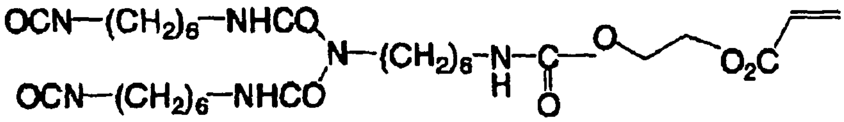

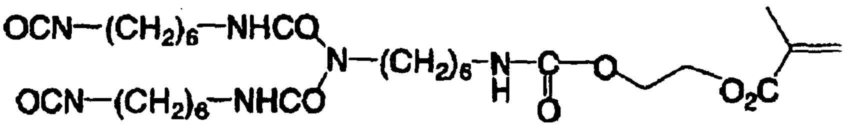

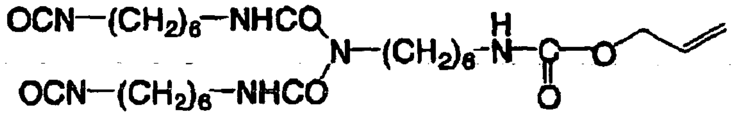

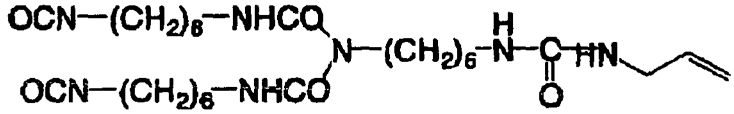

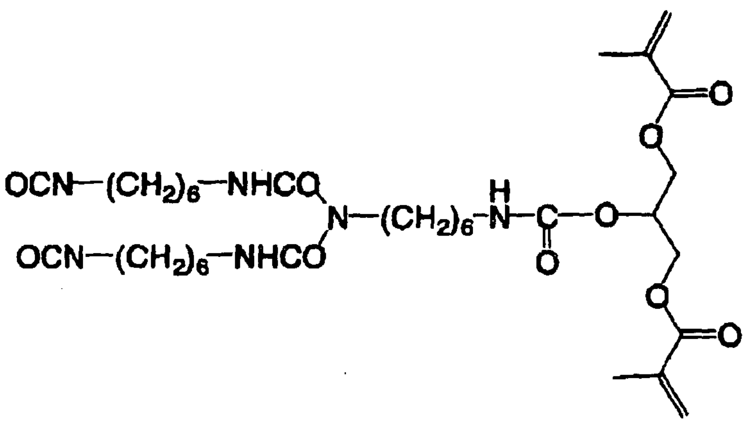

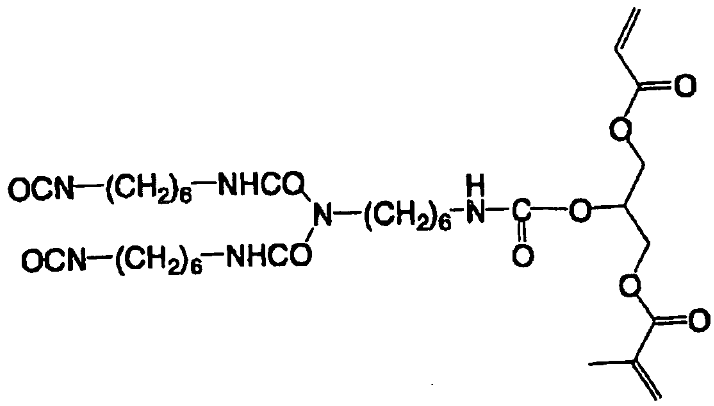

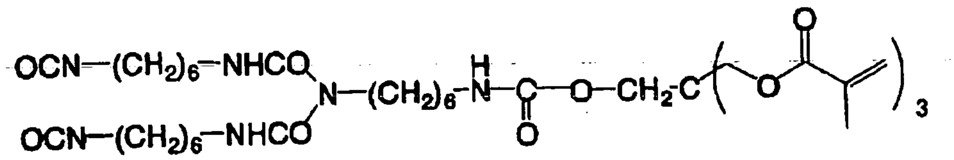

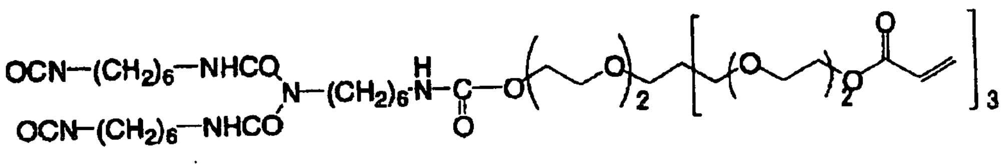

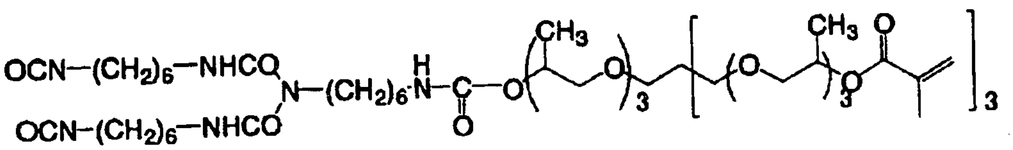

(iv) Carboxyl group-free diol compound:

As a method for introducing an unsaturated group into the side chain of the polyurethane resin, in addition to the foregoing methods, a method for using a diol compound containing an unsaturated group in the side chain thereof as the raw material for producing a polyurethane resin is suitable. As such a diol compound, commercially available products such as trimethylolpropane monoallyl ether may be employed. Compounds which are easily produced by reaction of a halogenated diol compound, a triol compound or an aminodiol compound with an unsaturated group-containing carboxylic acid, acid chloride, isocyanate, alcohol, amine, thiol or halogenated alkyl compound may also be employed. Specific examples of these compounds include the following compounds, but it should not be construed that the invention is limited thereto.

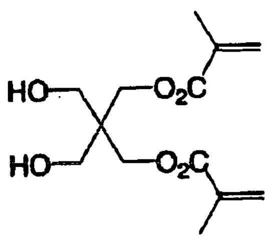

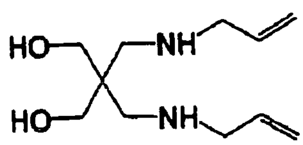

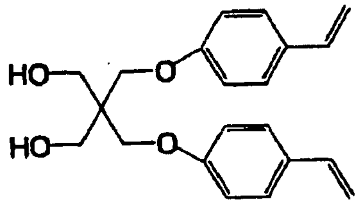

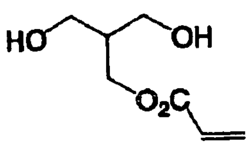

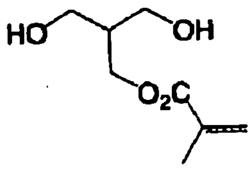

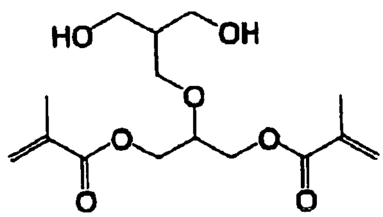

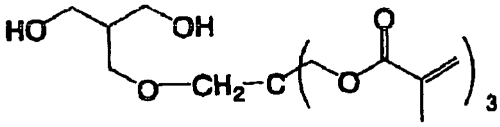

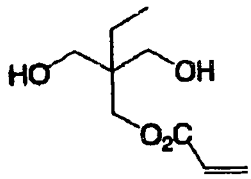

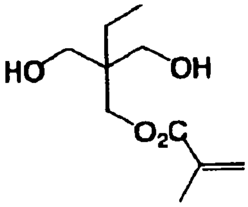

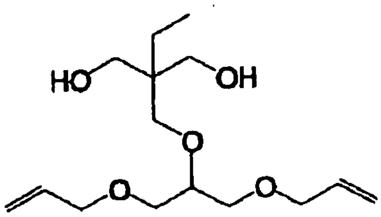

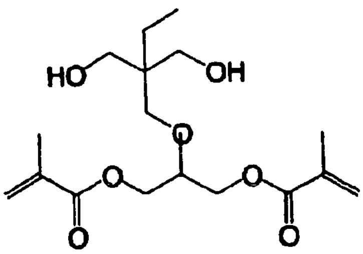

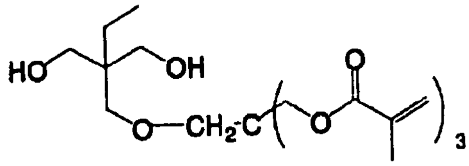

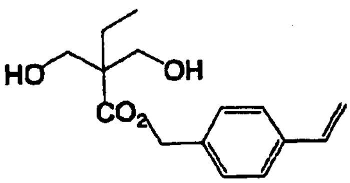

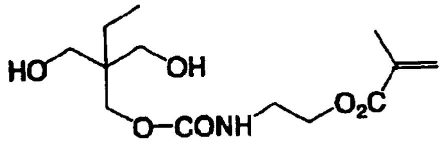

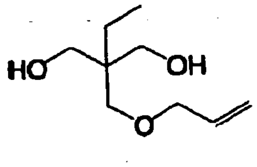

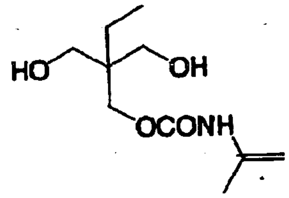

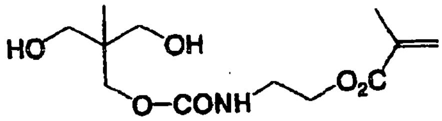

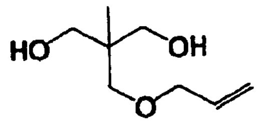

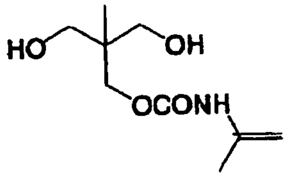

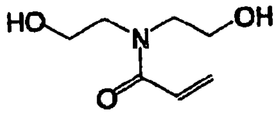

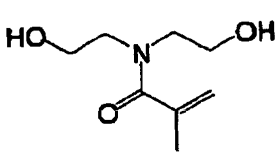

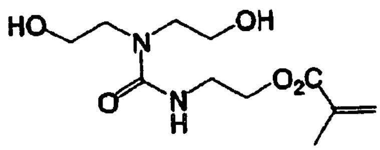

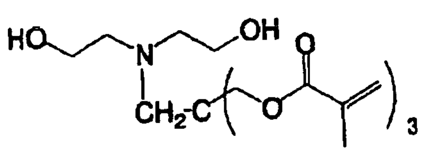

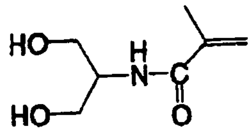

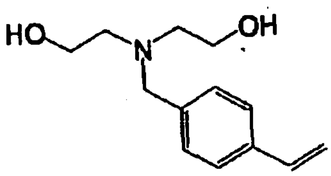

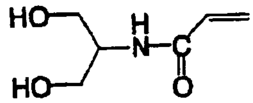

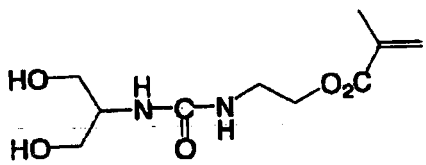

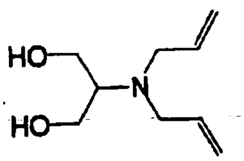

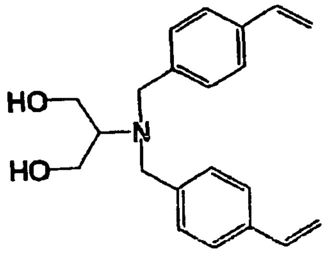

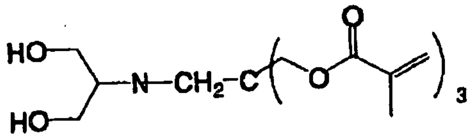

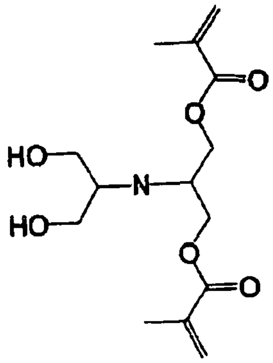

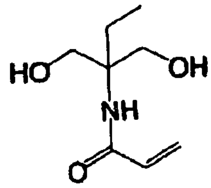

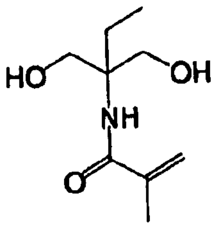

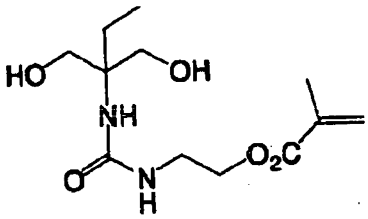

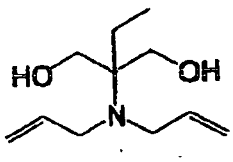

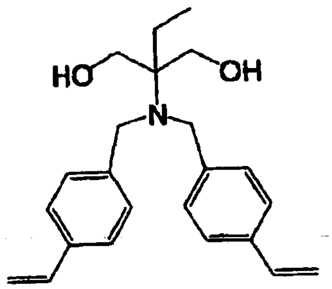

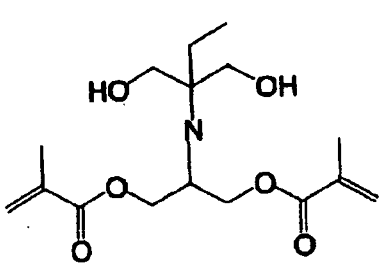

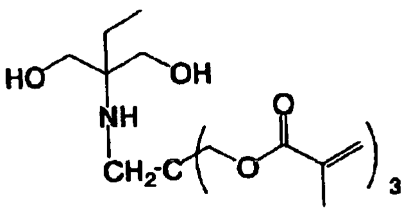

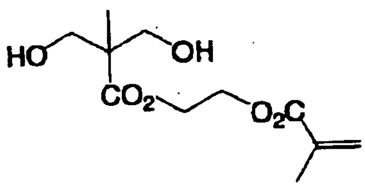

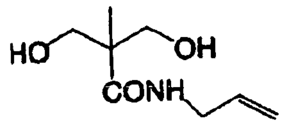

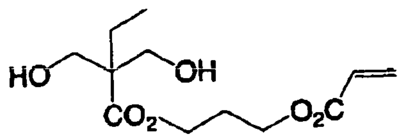

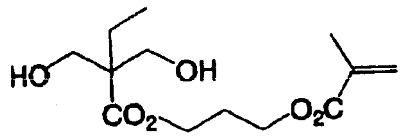

In addition, examples of still other diol compounds include ethylene glycol compounds represented by the following formula (A').

$$HO\text{-}(CH_2CH_2O)_n\text{-}H \qquad (A')$$

In the foregoing formula (A'), n represents an integer of 1 or more.

Furthermore, there are numerated hydroxyl group-terminated random copolymers and block copolymers of ethylene oxide and propylene oxide.

In addition, ethylene oxide adducts of bisphenol A (the number of addition of ethylene oxide is 27 to 100), ethylene oxide adducts of bisphenol F (the number of addition of ethylene oxide is from 22 to 100), ethylene oxide adducts of hydrogenated bisphenol A (the number of addition of ethylene oxide is from 23 to 100), and ethylene oxide adducts of hydrogenated bisphenol F (the number of addition of ethylene oxide is from 18 to 100) can be used. More specifically, ethylene glycol compounds represented by the formula (A') are preferable in view of staining properties; ethylene glycol compounds wherein n is from 2 to 50 are more preferable; ethylene glycol compounds wherein n is from 3 to 30 are further preferable; and ethylene glycol compounds wherein n is from 4 to 10 are especially preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bits-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (the number of addition of ethylene oxide is not more than 26), an ethylene oxide adduct of bisphenol F (the number of addition of ethylene oxide is not more than 21), an ethylene oxide adduct of hydrogenated bisphenol A (the number of addition of ethylene oxide is not more than 22), an ethylene oxide adduct of hydrogenated bisphenol F (the number of addition of ethylene oxide is not more than 17), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinonedihydroxyethyl ether, p-xylylene glycol, dihydroxyethylsulfone, bis(2-hydroxyethyl)-2,4-tolylene dicarbamate, 2,4-tolylene-bis-(2-hydroxyethyl carbamide), bis(2-hydroxyethyl)-m-xylylene dicarbamate, and bis(2-hydroxyethyl) isophthalate.

Polyether diol compounds of a compound represented by the formula (A), (B), (C), (D) or (E) can also be suitably used.

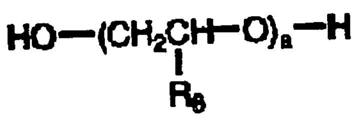

(A)

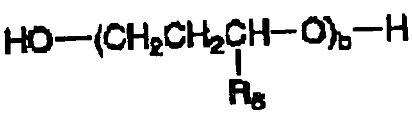 (B)

$$HO-(CH_2CH_2CH_2CH_2-O)_c-H \quad (C)$$

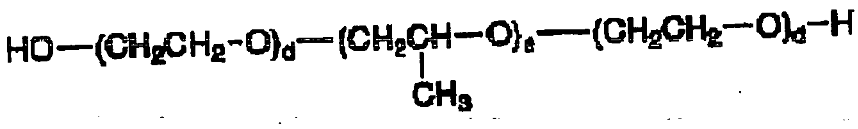 (D)

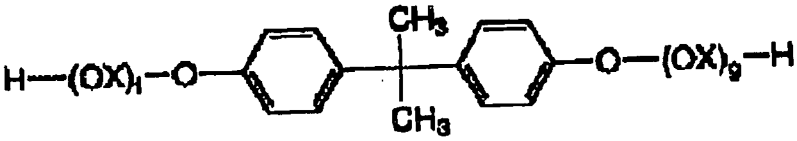 (E)

In the foregoing formulae, $R_6$ represents a hydrogen atom or a methyl group, provided that in the formula (A), $R_6$ represents a methyl group. X represents either one of the following groups:

$-CH_2CH_2-$ 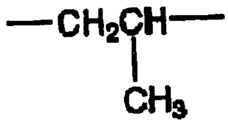

In the foregoing formulae, <u>a</u>, <u>b</u>, <u>c</u>, <u>d</u>, <u>e</u>, and <u>f</u> each represents an integer of 2 or more, and preferably an integer of from 2 to 100.

In addition, polyester diol compounds represented by the formulae (11) and (12) can be enumerated as specific examples.

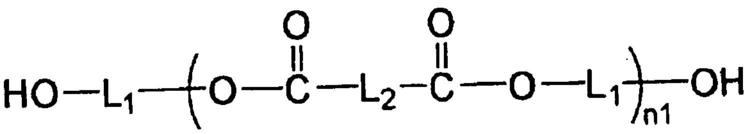 ( 11 )

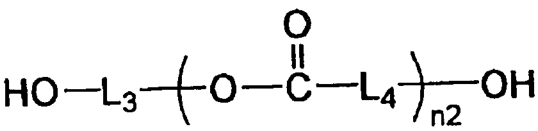 ( 12 )

In the foregoing formulae, $L_1$, $L_2$, and $L_3$ may be the same or different and each a divalent aliphatic or aromatic hydrocarbon group; and $L_4$ represents a divalent aliphatic hydrocarbon group. Preferably, $L_1$, $L_2$, and $L_3$ each represents an alkylene group, an alkenylene group, an alkynylene group, or an arylene group; and $L_4$ represents an alkylene group. Furthermore, $L_1$, $L_2$, $L_3$, and $L_4$ may contain other functional group which does not react with the isocyanate group, such as an ether group, a carbonyl group, an ester group, a cyano group, an olefin group, a urethane group, an amide group, an ureido group, and a halogen atom. $n_1$ and $n_2$ each represents an integer of 2 or more, and preferably an integer of from 2 to 100.

In addition, polycarbonate diol compounds represented by the formula (13) can be enumerated as specific examples.

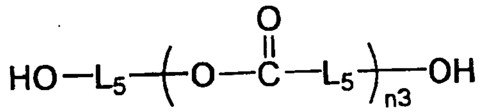

(13)

In the foregoing formula (13), $L_5$s may be the same or different and each represents a divalent aliphatic or aromatic hydrocarbon group. Preferably, $L_5$ represents an alkylene group, an alkenylene group, an alknylene group, or an arylene group. Furthermore, $L_5$ may contain other functional group which does not react with the isocyanate group, such as an ether group, a carbonyl group, an ester group, a cyano group, an olefin group, a urethane group, an amide group, an ureido group, and a halogen atom. $n_3$ represents an integer of 2 or more, and preferably an integer of from 2 to 100.

Specific examples of the diol compounds represented by the formulae (11), (12) and (13) include the following compounds. In the following specific examples, n represents an integer of 2 or more.

(No.1)

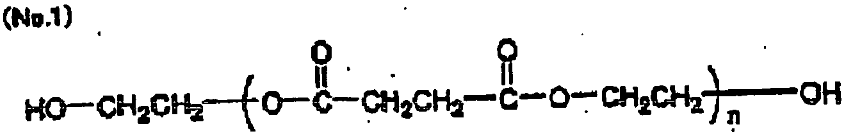

(No.2)

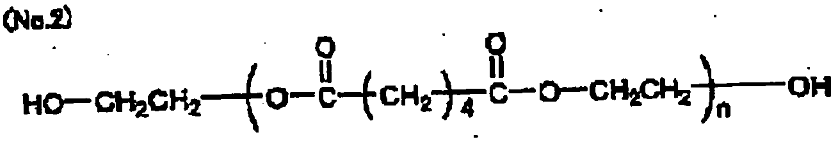

(No.3)

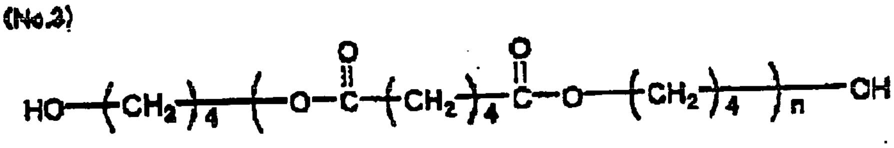

(No.4)

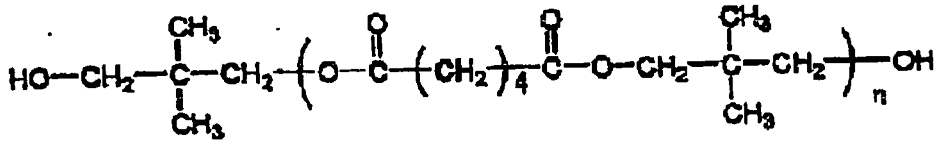

(No.5)

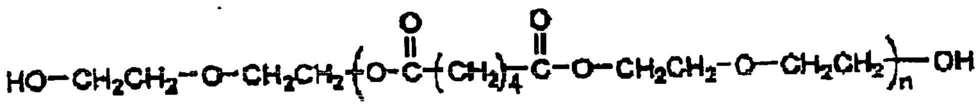

(No.6)

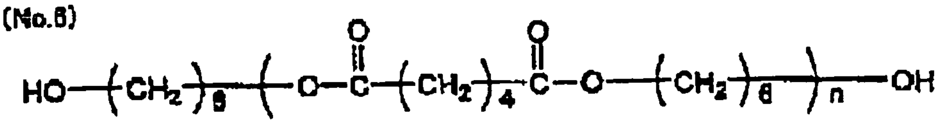

(No.7)

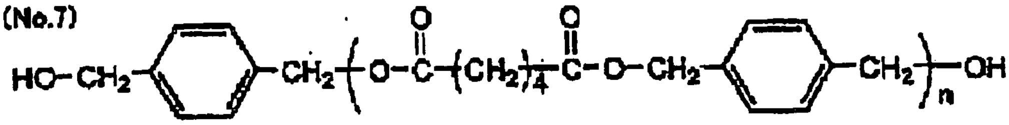

(No.8)

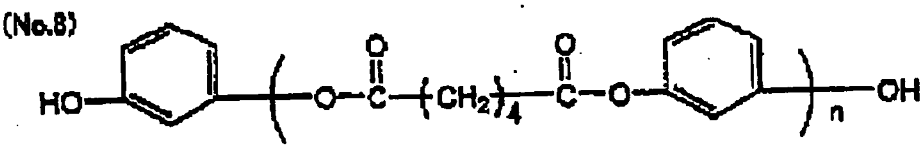

(No.9)

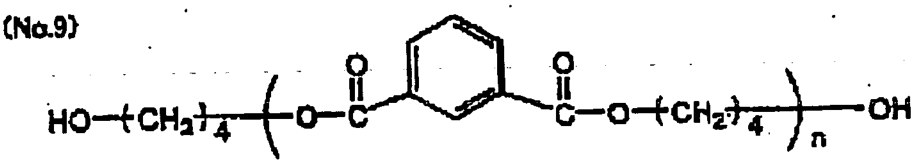

(No.10)

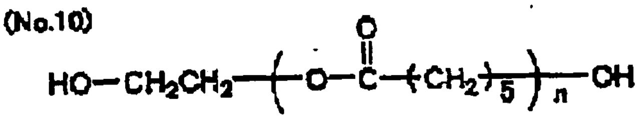

(No.11)

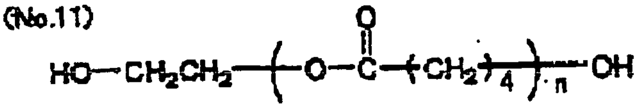

(No.12)

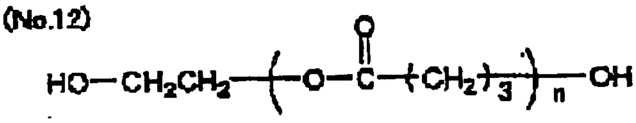

(No.13)

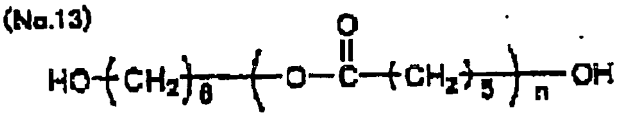

(No.14)

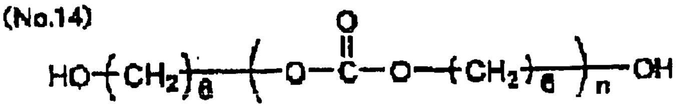

(No.15)

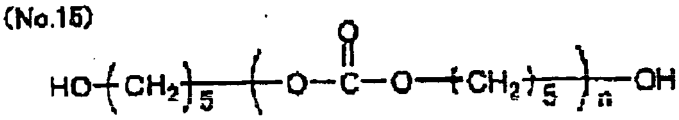

(No.16)

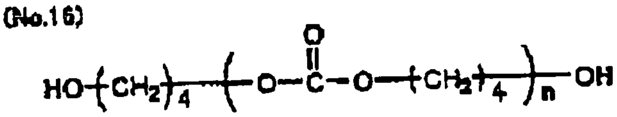

(No.17)

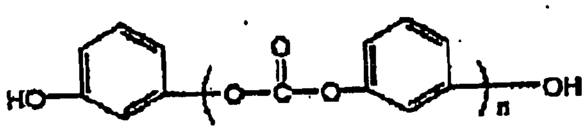

(No.18)

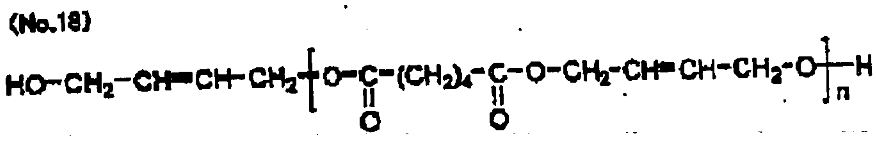

(No.19)

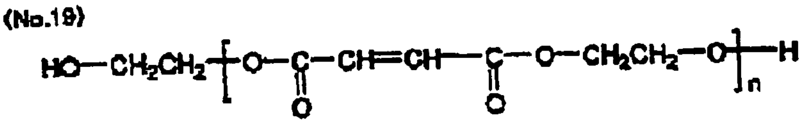

(No.20)

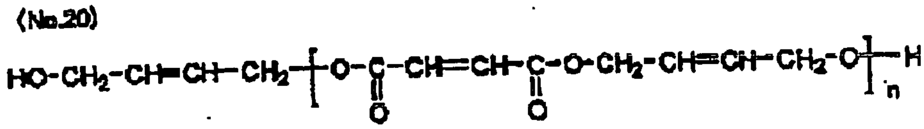

(No.21)

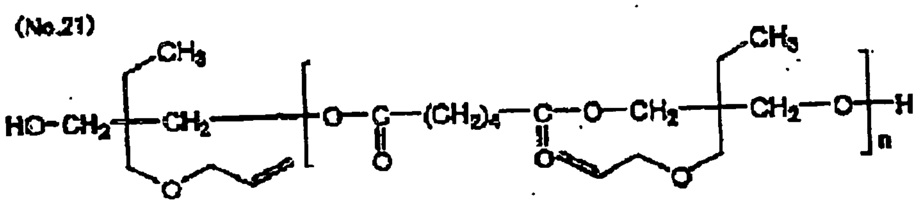

(No.22)

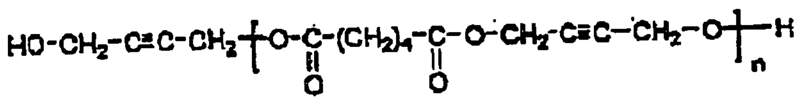

(No.23)

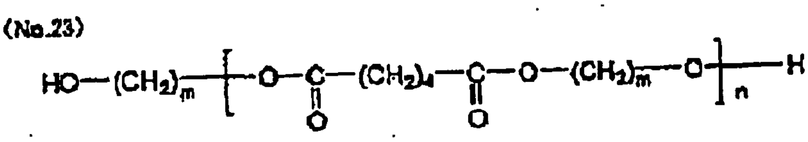

m=2.4

Moreover, diol compounds which do not contain a carboxyl group and may contain other substituent which does not react with the isocyanate can be used.

Such a diol compound includes the following compounds.

$$HO\text{-}L_6\text{-}O\text{-}CO\text{-}L_7\text{-}CO\text{-}O\text{-}L_6\text{-}OH \quad (14)$$

$$HO\text{-}L_7\text{-}CO\text{-}O\text{-}L_6\text{-}OH \quad (15)$$

In the foregoing formulae, $L_6$ and $L_7$ may be the same or different and each represents an optionally substituted divalent aliphatic hydrocarbon group, aromatic hydrocarbon group or heterocyclic group (examples of the substituent include an alkyl group, an aralkyl group, an aryl group, an alkoxy group, an aryloxy group, and a halogen atom (for example, -F, -Cl, -Br, and -I). If desired, $L_6$ and $L_7$ may each contain other functional group which does not react with the isocyanate group, such as a carbonyl group, an ester group, a urethane group, an amide group, and an ureido group. Incidentally, $L_6$ and $L_7$ may be taken together to form a ring.

Specific examples of the compound represented by the formula (14) or (15) include the following compounds.

(No.101)

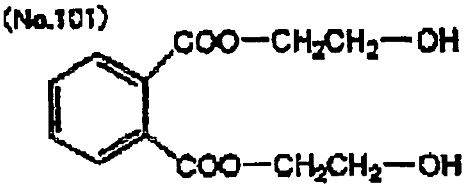

(No.102)

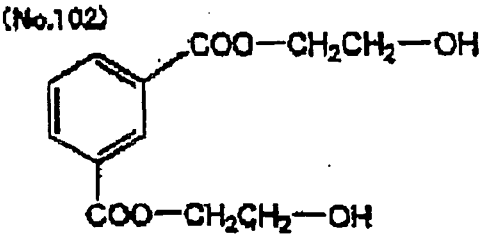

(No.103)

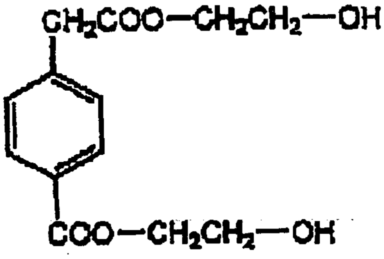

(No.104)

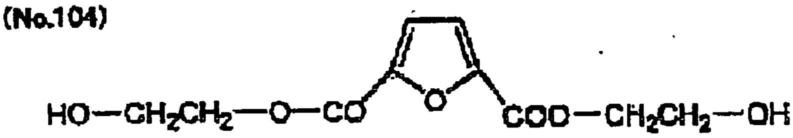

(No.105) $HO-CH_2CH_2-O-CO-CH=CH-COO-CH_2CH_2-OH$

(No.106) $HO-CH_2CH_2-O-COC_{11}H_{22}COO-CH_2CH_2-OH$

(No.107) $HO-CH_2CH_2-O-COC_{12}H_{24}COO-CH_2CH_2-OH$

(No.108) $HO-CH_2CH_2-O-COC_{14}H_{28}COO-CH_2CH_2-OH$

(No.109)

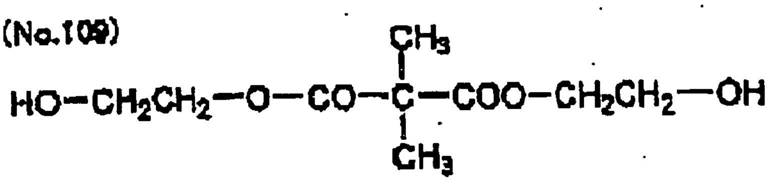

(No.110) $HO-CH_2CH_2-O-CO-C\equiv C-COO-CH_2CH_2-OH$

(No.111)

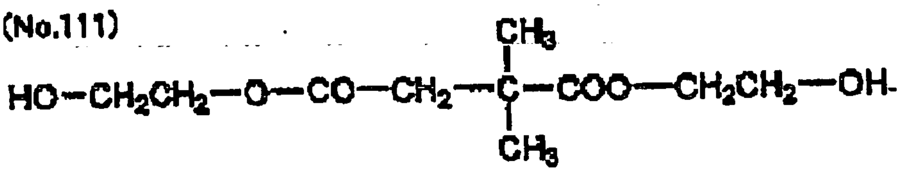

(No.112)

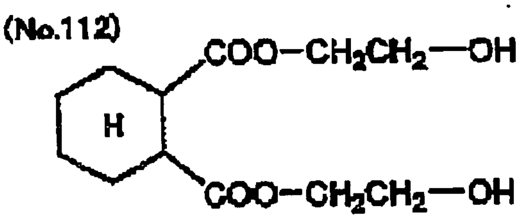

(No.113) HO-$CH_2CH_2$-O-CO-$CH_2$-O-$CH_2$-COO-$CH_2CH_2$-OH

(No.114)

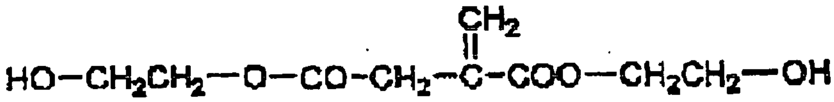

(No.115)

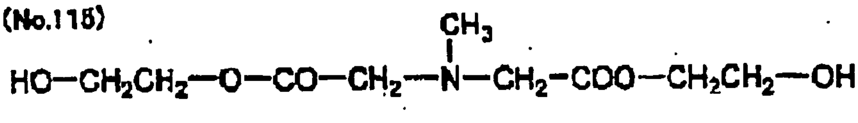

(No.116)

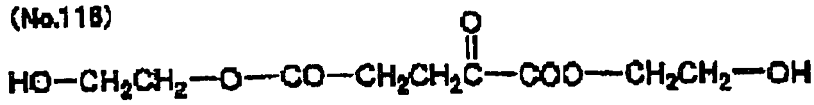

(No.117)

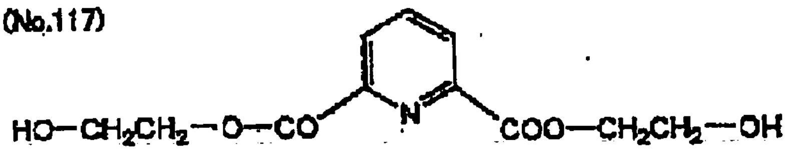

(No.118)

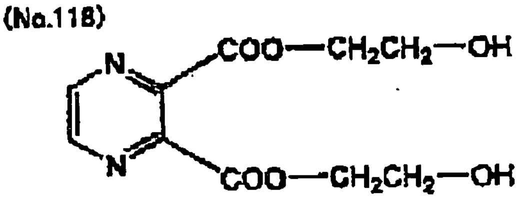

(No.119)

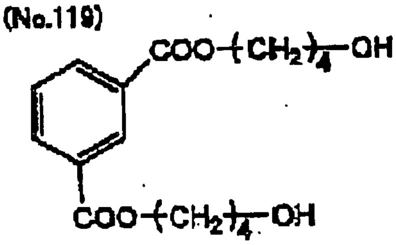

(No.120)

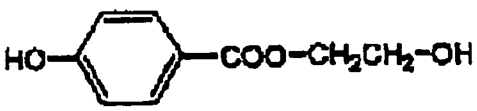

(No.121)

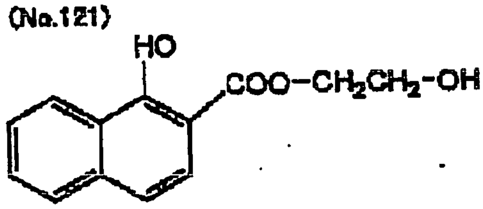

(No.122)

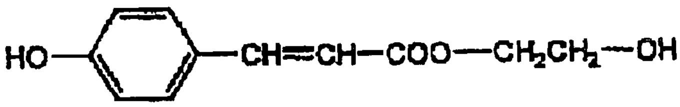

(No.123) HO-$CH_2CH_2$-COO-$CH_2CH_2$-OH

(No.124)

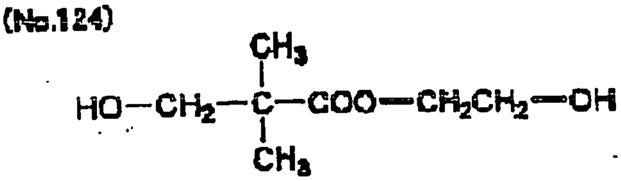

(No.125)

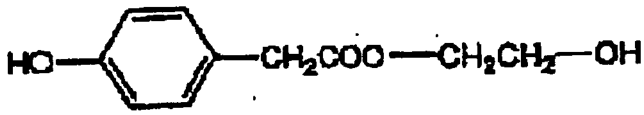

(No.126)

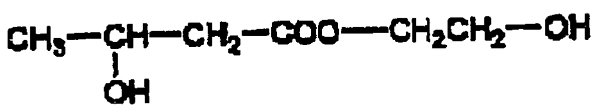

(No.127)

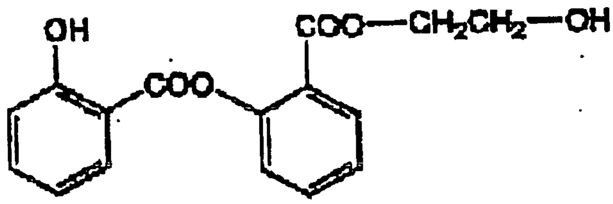

(No.126)

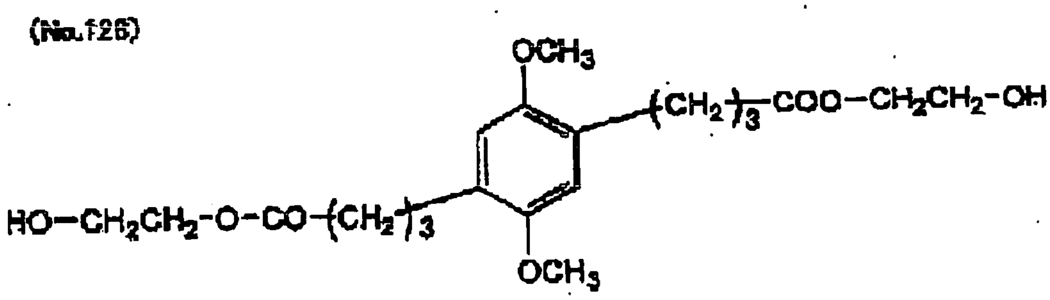

The following diol compounds can also be suitably used.

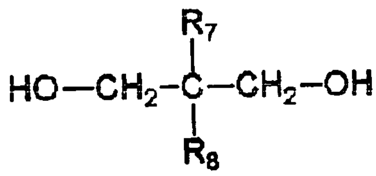

(16)

HO-$CH_2$-C≡C-$CH_2$-OH (17)

HO-$CH_2$-CH=CH-$CH_2$-OH (18)

In the foregoing formulae, $R_7$ and $R_8$ may be the same or different and each represents an optionally substituted alkyl group, and preferably an optionally substituted alkyl group having from 1 to 10 carbon atoms (examples of the substituent include a cyano group, a nitro group, a halogen atom (for example, -F, -Cl, -Br, and -I), a - $CONH_2$ group, -COOR group, and an -OR group (wherein Rs may be the same or different and each represents an alkyl group having from 1 to 10 carbon atoms, an aryl group having from 7 to 15 carbon atoms, or an aralkyl group)).

Specific examples of the diol compound represented by the formula (16) include the following compounds.

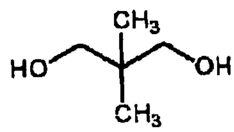

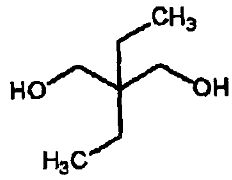

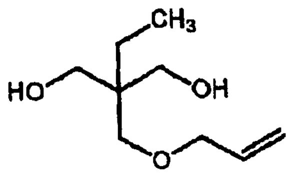

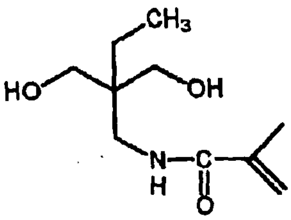

2-Butyne-1,4-diol is enumerated as the formula (17); and cis-2-butene-1,4-diol and trans-2-butene-1,4-diol are enumerated as the formula (18).

Diol compounds represented by the following formulae (19) and (20) can also be suitably used.

HO-$L_8$-NH-CO-$L_9$-CO-NH-$L_8$-OH (19)

HO-$L_9$-CO-NH-$L_8$-OH (20)

In the foregoing formulae, $L_8$ and $L_9$ may be the same or different and each represents an optionally substituted divalent aliphatic hydrocarbon group, aromatic hydrocarbon group or heterocyclic group (examples of the substituent include an alkyl group, an aralkyl group, an aryl group, an alkoxy group, an aryloxy group, and a halogen atom (for example, -F, -Cl, -Br, and -I)). If desired, $L_8$ and $L_9$ may each contain other functional group which does not react with the isocyanate group, such as a carbonyl group, an ester group, a urethane group, an amide group, and an ureido group. Incidentally, $L_8$ and $L_9$ may be taken together to form a ring.

Specific examples of the compound represented by the formula (19) or (20) include the following compounds.

(No.201)

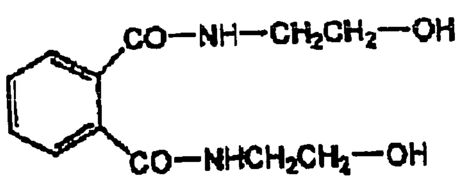

(No.202)

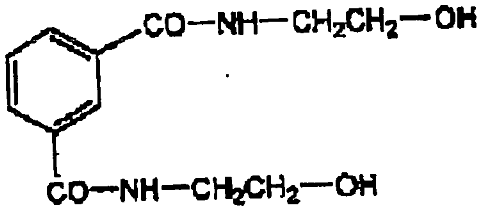

(No.203) $HO-CH_2CH_2-NH-CO-CH=CH-CO-NH-CH_2CH_2-OH$

(No.204) $HO-CH_2CH_2-NH-CO-C=C-CO-NH-CH_2CH_2-OH$

(No.205)

$HO-CH_2CH_2-NH-CO-(CH_2)_2-CO-NH-CH_2CH_2-OH$

(No.206)

$HO-CH_2CH_2-NH-CO-(CH_2)_3-CO-NH-CH_2CH_2-OH$

(No.207)

$HO-CH_2CH_2-NH-CO-(CH_2)_5-CO-NH-CH_2CH_2-OH$

(No.208)

$HO-CH_2CH_2-NH-CO-(CH_2)_8-CO-NH-CH_2CH_2-OH$

(No.209)

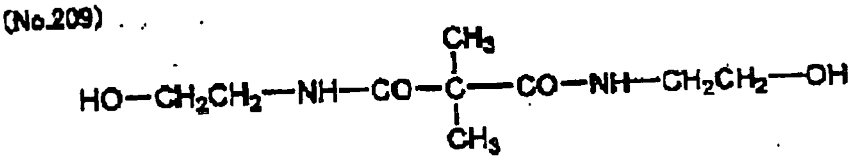

(No.210)

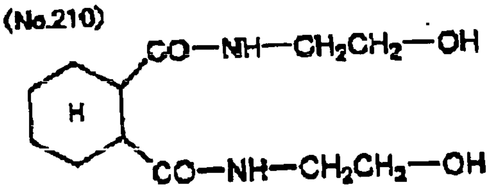

(No.211)

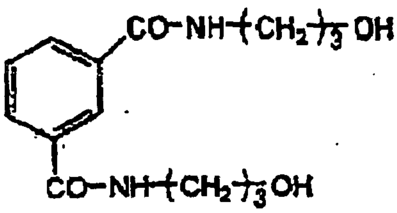

(No.212)

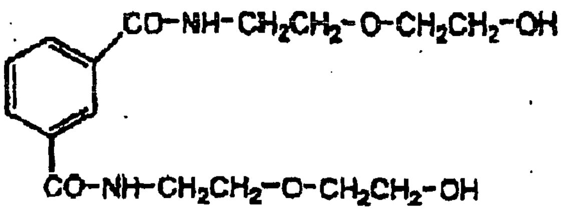

(No.213)

$HO-(CH_2)_3-NH-(CH_2)_3-NH-CO-(CH_2)_2-CO-NH-(CH_2)_3-OH$

(No.214)

$HO-CH_2CH_2-O-CH_2CH_2-NH-CO-(CH_2)_4-CO-NH-CH_2CH_2-O-CH_2CH_2-OH$

(No.215) $HO-CH_2CH_2-NH-CO-CH_2-O-CH_2-CO-NH-CH_2CH2-OH$

(No.216)

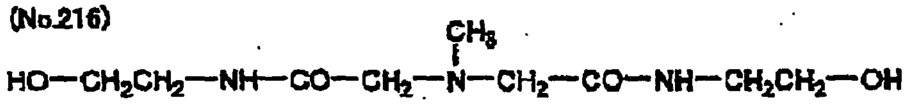

(No.217)

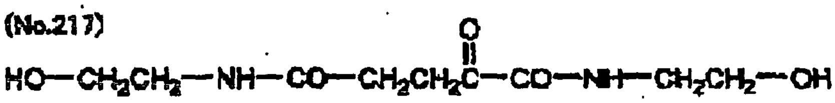

(No.218) $HO-CH_2CH_2-NH-CO-CH_2-s-CH_2-CO-NH-CH_2CH_2-OH$

(No.219)

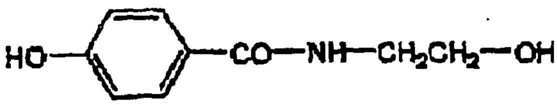

(No.220)

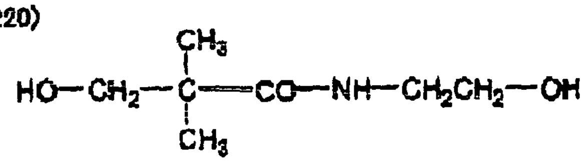

In addition, diol compounds represented by the following formulae (21) and (22) can be suitably used.

$HO-Ar_2-(L_{16}-Ar_3)_n-OH$ (21)

$HO-Ar_2-L_{16}-OH$ (22)

In the foregoing formulae, $L_{16}$ represents an optionally substituted divalent aliphatic hydrocarbon group (examples of the substituent include an alkyl group, an aralkyl group, an aryl group, an alkoxy group, an aryloxy group, and a halogen atom. If desired, $L_{16}$ may contain other functional group which does not react with the isocyanate group, such as an ester group, a urethane group, an amide group, and an ureido group.

$Ar_2$ and $Ar_3$ may be the same or different and each represents an optionally substituted divalent aromatic hydrocarbon group, and preferably an aromatic hydrocarbon group having from 6 to 15 carbon atoms; and n represents an integer of from 0 to 10.

Specific examples of the diol compound represented by the formula (21) or (22) include the following compounds.

Namely, examples include catechol, resorcin, hydroquinone, 4-methylcatechol, 4-t-butylcatechol, 4-acetylcatechol, 3-methoxycatechol, 4-phenylcatechol, 4-methylresorcin, 4-ethylresorcin, 4-t-butylresorcin, 4-hexylresorcin, 4-chlororesorcin, 4-benzylresorcin, 4-acetylresorcin, 4-carbomethoxyresorcin, 2-methylresorcin, 5-methylresorcin, t-butylhydroquinone, 2,5-di-t-butylhydroquinone, 2,5-di-t-amylhydroquinone, tetramethylhydroquinone, tetrachlorohydroquinone, methylcarbaminohydroquione, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-(p-hydroxyphenyl)propyl)-benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybenzyl alcohol, 4-hydroxybenzyl alcohol, 2-hydroxy-3,5-di-t-butylbenzyl alcohol, 4-hydroxy-3,5-di-t-butylbenzyl alcohol, 4-hydroxyphenethyl alcohol, 2-hydroxyethyl-4-hydroxybenzoate, 2-hydroxyethyl-4-hydroxyphenyl acetate, and resorcin mono-2-hydroxyethyl ether. The following diol compounds can also be suitably used.

(v) Other amino group-containing compound:

In the polyurethane resin binder in the invention, a structure of a polyurethane resin as prepared by combining an amino group-containing compound represented by the following formula (31) or (32) and allowing it to react with a diisocyanate compound, thereby forming a urea structure may be incorporated.

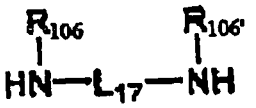

(31)

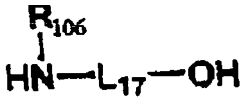

(32)

In the foregoing formulae, $R_{106}$ and $R_{106'}$ may be the same or different and each represents a hydrogen atom or an optionally substituted alkyl, aralkyl or aryl group (examples of the substituent include an alkoxy group, a halogen atom (for example, -F,-Cl, -Br, and -I), an ester group, and a carboxyl group), and preferably a hydrogen atom or an alkyl group having from 1 to 8 carbon atoms or an aryl group having from 6 to 15 carbon atoms, each of which may contain a carboxyl group as a substituent. $L_{17}$ represents an optionally substituted divalent aliphatic hydrocarbon group, aromatic hydrocarbon group or heterocyclic hydrocarbon group (examples of the substituent include an alkyl group, an aralkyl group, an aryl group, an alkoxy group, an aryloxy group, a halogen atom (for example, -F, -Cl, -Br, and -I), and a carboxyl group). If desired, $L_{17}$ may contain other functional group which does not react with the isocyanate group, such as a carbonyl group, an ester group, a urethane group, and an amide group. Incidentally, two of $R_{106}$, $L_{17}$, and $R_{106'}$ may be taken together to form a ring.

Specific examples of the compound represented by the formula (31) or (32) include the following compounds.

Namely, examples include aliphatic diamine compounds (for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine, and isophoronediamine); aromatic diamine compounds (for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether, and 1,8-naphthalenediamine); heterocyclic amine compounds (for example, 2-aminoimidazole, 3-aminotriazole, 5-amino-1H-tetrazole, 4-aminopyrazole, 2-aminobenzimidazole, 2-amino-5-carboxy-triazole, 2,4-diamino-6-methyl-S-triazine, 2,6-diaminopyridine, L-histidine, DL-tryptophan, and adenine); and amino alcohol or amino phenol compounds (for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol, and L-tyrosine).

In addition to the foregoing polyurethane resins as obtained by introducing a crosslinking group in the side chain thereof at the time of synthesis of polyurethane, polyurethane resins as obtained by introducing a crosslinking group into a carboxyl group-containing polyurethane by polymeric reaction as described in JP-A-2003-270775 can be used as the polymer binder according to the invention.

The (meth)acrylic resin having a crosslinking group in the side chain thereof used in the invention will be hereunder described.

As the (meth)acrylic resin having a crosslinking group in the side chain thereof which is used in the invention, a resin containing a repeating unit represented by the following formula (i) is preferable from the viewpoint of developability.

The resin containing a repeating unit represented by the formula (i) will be hereunder properly referred to as a "specific (meth)acrylic resin" and described below in detail.

Formula (i)

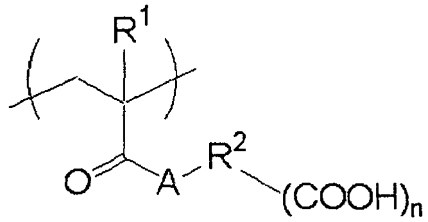

In the foregoing formula (i), $R^1$ represents a hydrogen atom or a methyl group; $R^2$ represents a connecting group constituted of one or more atoms selected from the group consisting of a carbon atom, a hydrogen atom, an oxygen atom, a nitrogen atom, and a sulfur atom; A represents an oxygen atom or $-NR^3-$; $R^3$ represents a hydrogen atom or a monovalent hydrocarbon group having from 1 to 10 carbon atoms; and n represents an integer of from 1 to 5.

First of all, $R^1$ in the formula (i) represents a hydrogen atom or a methyl group, and especially preferably a methyl group.

The connecting group represented by $R^2$ in the formula (i) is constituted of one or more atoms selected from the group consisting of a carbon atom, a hydrogen atom, an oxygen atom, a nitrogen atom, and a sulfur atom, and it is preferable that the number of atoms exclusive of its substituent is from 2 to 82. Specifically, the number of atoms constituting the principal skeleton of the connecting group represented by $R^2$ is preferably from 1 to 30, more preferably from 3 to 25, further preferably from 4 to 20, and most preferably from 5 to 10. Incidentally, the term "principal skeleton of the connecting group" as referred to in the invention refers to atoms or an atomic group to be used only for connecting A to the terminal COOH in the formula (i); and in particular, when plural connecting routes are present, this term refers to atoms or an atomic group for constituting a route where the number of atoms to be used is the smallest. Accordingly, in the case where a cyclic structure is contained in the connecting group, the number of atoms to be counted varies depending upon its connecting site (for example, o-, m-, and p-).

Furthermore, more specifically, examples of the connecting group include an alkylene, a substituted alkylene, an arylene, and a substituted arylene. The connecting group may have a structure in which a plural number of such divalent groups are connected to each other via an amide bond or an ester bond.

Examples of the connecting group of a chain structure include ethylene and propylene. Structures in which such alkylenes are connected to each other via an ester bond can also be enumerated as a preferred structure.

Above all, it is preferable that the connecting group represented by $R^2$ in the formula (i) is a hydrocarbon group having a valence of (n + 1) and having an aliphatic cyclic structure having from 3 to 30 carbon atoms. More specifically, a hydrocarbon group having a valence of (n + 1) resulting from elimination of (n + 1) hydrogen atoms on arbitrary carbon atoms constituting a compound having an aliphatic cyclic structure, which may be substituted with one or more arbitrary substituents, such as cyclopropane, cyclopentane, cyclohexane, cycloheptane, cyclooctane, cyclodecane, dicyclohexyl, tercyclohexyl, and norbornane can be enumerated. Furthermore, it is preferable that $R^2$ has from 3 to 30 carbon atoms including the substituent.

One or more arbitrary carbon atoms of a compound constituting an aliphatic cyclic structure may be substituted with a hetero atom selected from a nitrogen atom, an oxygen atom, and a sulfur atom. In view of printing resistance, $R^2$ is preferably a hydrocarbon group having a valence of (n + 1) and having an optionally substituted aliphatic cyclic structure, which has from 5 to 30 carbon atoms and contains two or more rings, such as fused polycyclic aliphatic hydrocarbons, crosslinked alicyclic hydrocarbons, spiro aliphatic hydrocarbons, and aliphatic hydrocarbon ring agglomerations (in which plural rings are connected to each other via a bond or a connecting group). In this case, the number of carbon atoms is one including the number of carbon atoms which the substituent has, too.

As the connecting group represented by $R^2$, a connecting group having the number of atoms constituting the principal skeleton of the connecting group of from 5 to 10 is preferable. With respect to the structure, a connecting group having a chain structure and containing an ester bond in the structure thereof and a connecting group having the foregoing cyclic structure are preferable.

As the substituent which can be introduced into the connecting group represented by $R^2$, a monovalent non-metallic atomic group excluding hydrogen can be enumerated. Examples thereof include a halogen atom (for example, -F, -Br, -Cl, and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylactylamino group, an ureido group, an N'-alkylureido group,

an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycabonylamino group, an aryl-N-alkoxycarbonylamino group, an N-aryl-N-aryloxycarbonylamino group, a formyl group, an acyl group, a carboxyl group and its conjugated base group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group, an alkoxy-sulfonyl group, an aryloxysulfonyl group, a sulfinamoyl group, an N-alkylsulfinamoyl group, an N,N-dialkylsulfinamoyl group, an N-arylsulfinamoyl group, an N,N-di-arylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and its conjugated base group, an N-alkylsulfonylsulfamoyl group ($-SO_2NHSO_2$(alkyl)) and its conjugated base group, an N-arylsulfonylsulfamoyl group ($-SO_2NHSO_2$(aryl)) and its conjugated base group, an N-alkylsulfonylcarbamoyl group ($-CONHSO_2$(alkyl)) and its conjugated base group, an N-arylsulfonylcarbamoyl group ($-CONHSO_2$(aryl)) and its conjugated base group, an alkoxysilyl group (-Si(Oalkyl)$_3$), an aryloxysilyl group (-Si(Oaryl)$_3$), a hydroxysilyl group ($-Si(OH)_3$) and its conjugated base group, a phosphono group ($-PO_3H_2$) and its conjugated base group, a dialkylphosphono group ($-PO_3$(alkyl)$_2$), a diarylphosphono group ($-PO_3$(aryl)$_2$), an alkylarylphosphono group ($-PO_3$(alkyl)(aryl)), a monoalkylphosphono group ($-PO_3H$(alkyl)) and its conjugated base group, a monoarylphosphono group ($-PO_3H$(aryl)) and its conjugated base group, a phosphonoxy group ($-OPO_3H_2$) and its conjugated base group, a dialkylphosphonoxy group ($-OPO_3$(alkyl)$_2$), a diarylphosphonoxy group ($-OPO_3$(aryl)$_2$), an alkylarylphosphonoxy group ($-OPO_3$(alkyl)(aryl)), a monoalkylphosphonoxy group ($-OPO_3H$(alkyl)) and its conjugated base group, a monoarylphosphonoxy group ($-OPO_3H$(aryl)) and its conjugated base group, a cyano group, a nitro group, a dialkylboryl group (-B(alkyl)$_2$), a diarylboryl group (-B(aryl)$_2$), an alkylarylboryl group (-B(alkyl)(aryl)), a dihydroxyboryl group ($-B(OH)_2$) and its conjugated base group, an alkylhydroxyboryl group (-B(alkyl)(OH)) and its conjugated base group, an arylhydroxyboryl group (-B(aryl)(OH)) and its conjugated base group, an aryl group, an alkenyl group, and an alkynyl group.

In the photosensitive lithographic printing plate of the invention, a hydrogencontaining substituent which can undergo hydrogen bonding, and especially an acidic substituent having an acid dissociation constant (pKa) lower than carboxylic acids are not preferable because they are liable to lower the printing resistance, an aspect of which, however, varies depending upon the design of the photosensitive layer. On the other hand, a halogen atom and a hydrophobic substituent such as a hydrocarbon group (for example, an alkyl group, an aryl group, an alkenyl group, and an alkynyl group), an alkoxy group, and an aryloxy group are preferable because they are liable to enhance the printing resistance. In particular, in the case where the cyclic structure is a monocyclic aliphatic hydrocarbon constructed of not more than 6 members, such as cyclopentane and cyclohexane, it is preferable that such a hydrophobic substituent is contained. If possible, such substituents may be taken together or bonded to a hydrocarbon group as substituted to form a ring. The substituent may be further substituted.

When A in the formula (i) is $NR^3$-, $R^3$ represents a hydrogen atom or a monovalent hydrocarbon group having from 1 to 10 carbon atoms. Examples of the monovalent hydrocarbon group having from 1 to 10 carbon atoms as represented by $R^3$ include an alkyl group, an aryl group, an alkenyl group, and an alkynyl group.

Specific examples of the alkyl group include linear, branched or cyclic alkyl groups having from 1 to 10 carbon atoms such as a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group, and a 2-norbornyl group.

Specific examples of the aryl group include aryl groups having from 1 to 10 carbon atoms (for example, a phenyl group, a naphthyl group, and an indenyl group) and heteroaryl groups having from 1 to 10 carbon atoms and containing one hetero atom selected from the group consisting of a nitrogen atom, an oxygen atom, and a sulfur atom (for example, a furyl group, a thienyl group, a pyrrolyl group, a pyridyl group, and a quinolyl group).

Specific examples of the alkenyl group include linear, branched or cyclic alkenyl groups having from 1 to 10 carbon atoms such as a vinyl group, a 1-propenyl group, a 1-butenyl group, a 1-methyl-1-propenyl group, a 1-cyclopentenyl group, and a 1-cyclohexenyl group.

Specific examples of the alkynyl group include alkynyl groups having from 1 to 10 carbon atoms such as an ethynyl group, a 1-propynyl group, a 1-butynyl group, and a 1-octynyl group. The substituent which $R^3$ may contain is the same as the substituent which $R^2$ can introduce. However, the number of carbon atoms of $R^3$ is from 1 to 10 inclusive of the number of carbon atoms of the substituent.

A in the formula (i) is preferably an oxygen atom or -NH- because of easiness of the synthesis.

n in the formula (i) represents an integer of from 1 to 5, and preferably 1 in view of printing resistance.

Preferred specific examples of the repeating unit represented by the formula (i) will be given below, but it should not be construed that the invention is limited thereto.

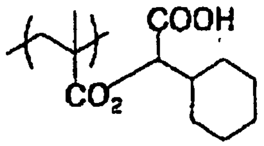

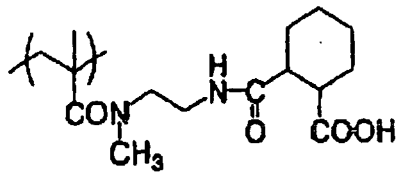

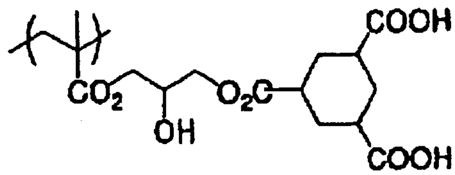

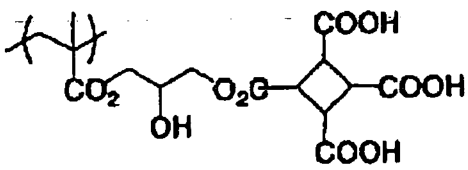

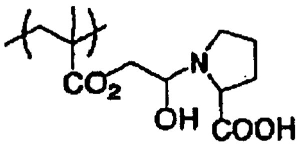

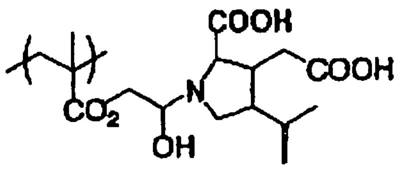

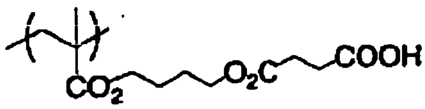

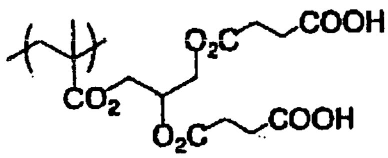

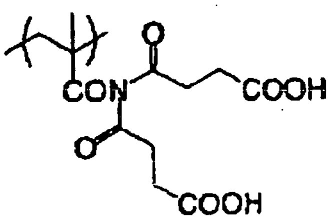

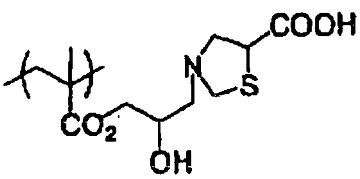

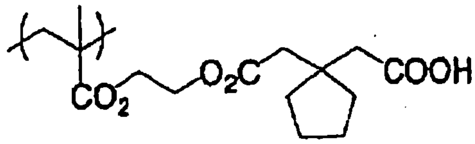

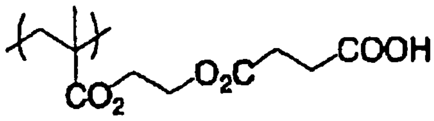

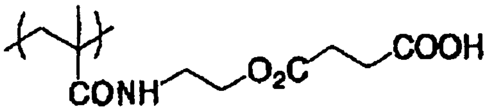

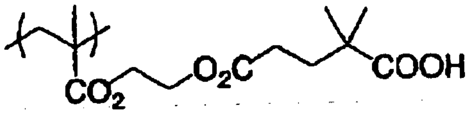

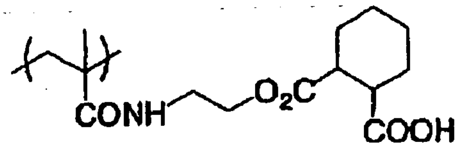

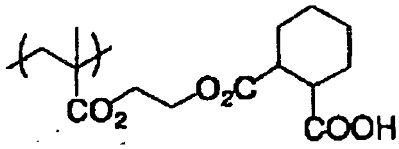

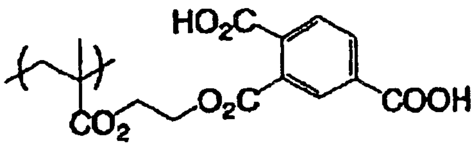

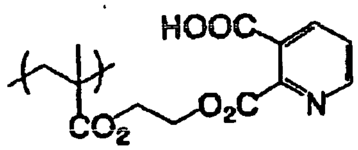

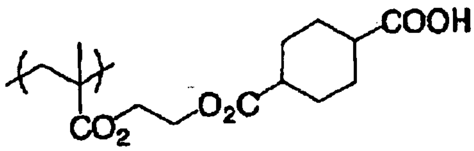

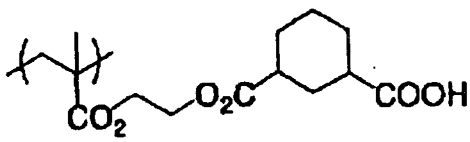

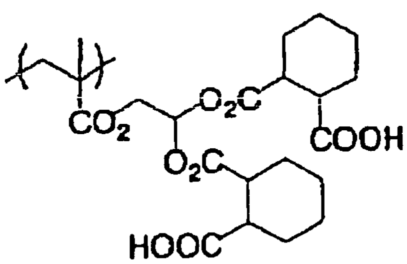

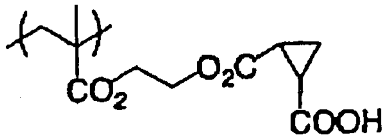

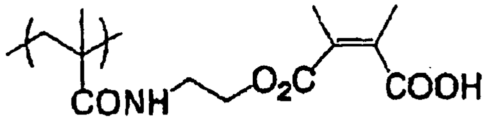

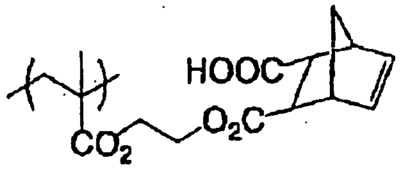

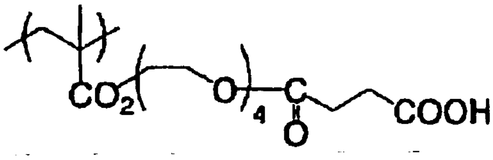

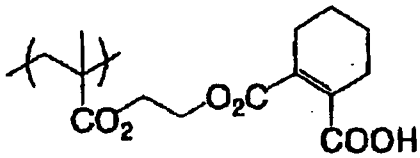

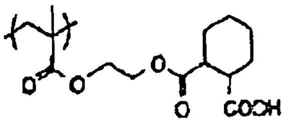

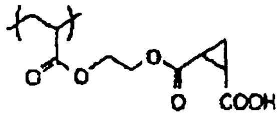

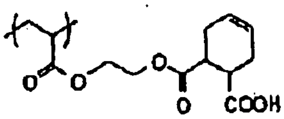

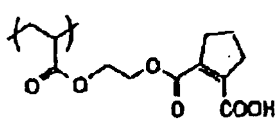

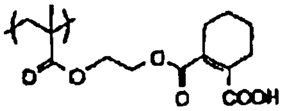

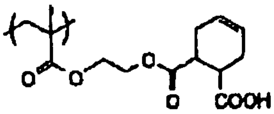

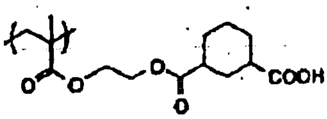

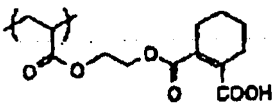

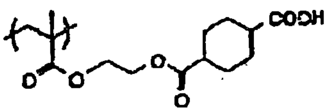

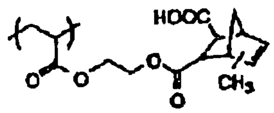

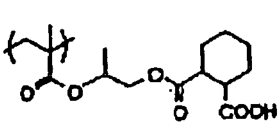

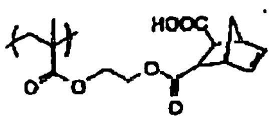

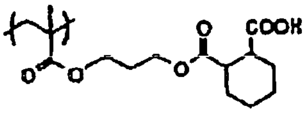

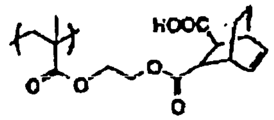

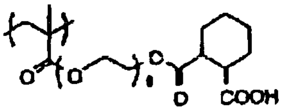

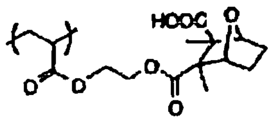

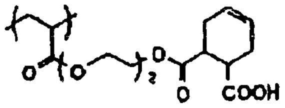

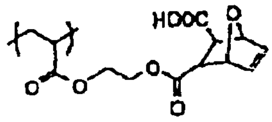

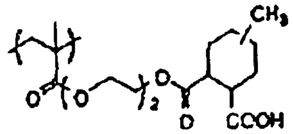

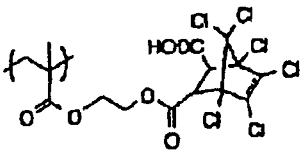

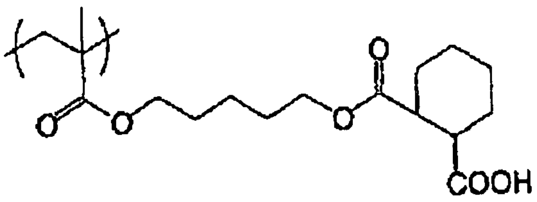

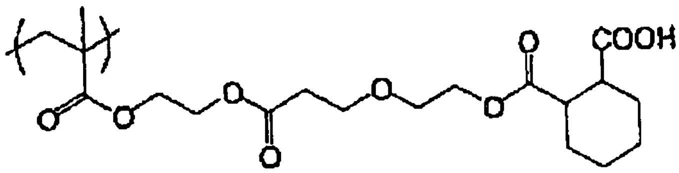

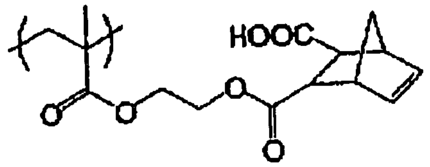

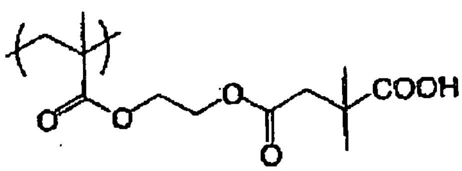

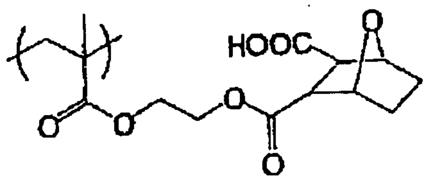

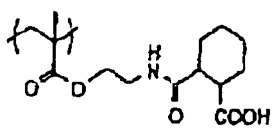

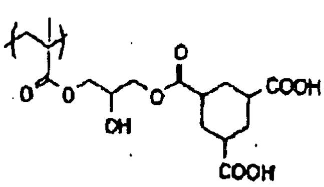

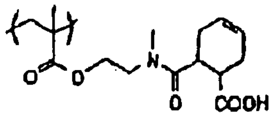

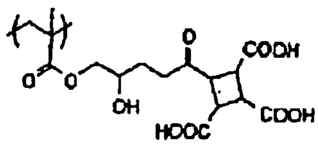

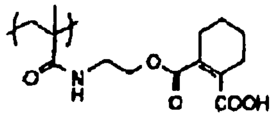

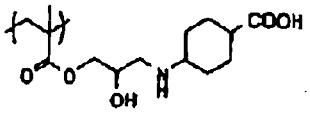

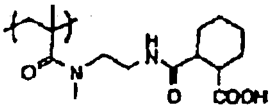

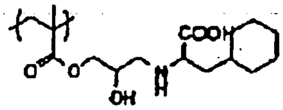

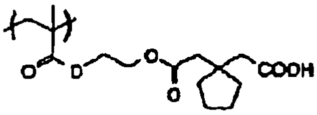

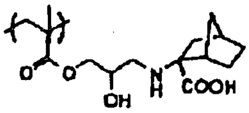

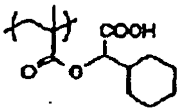

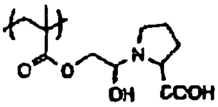

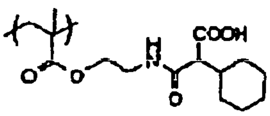

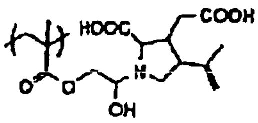

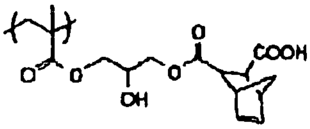

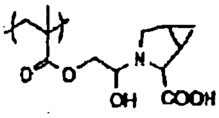

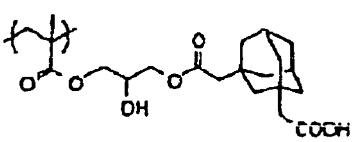

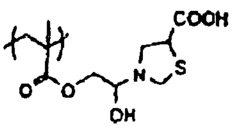

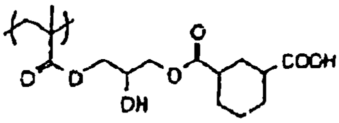

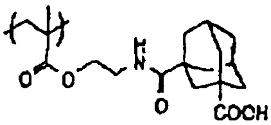

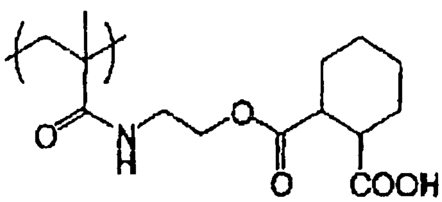

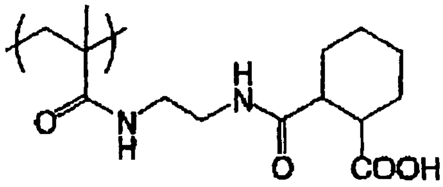

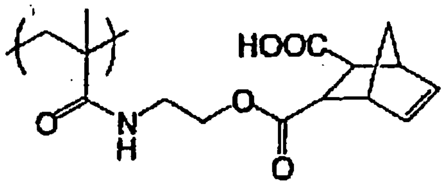

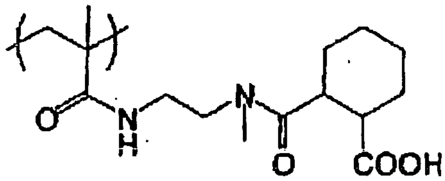

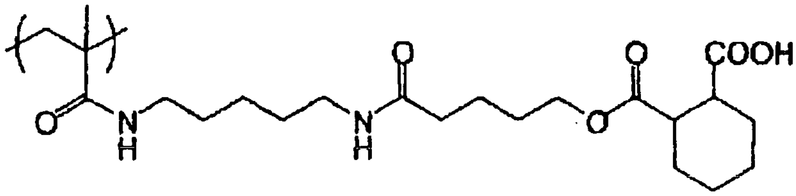

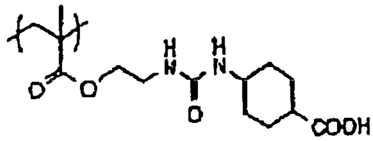

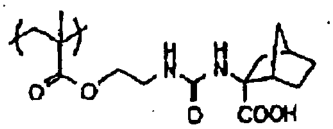

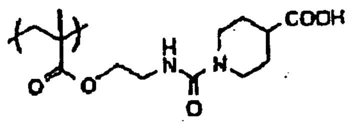

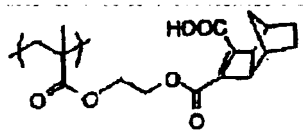

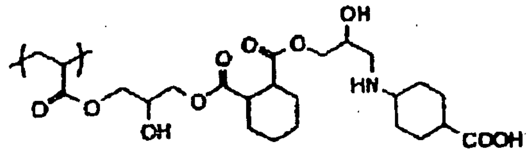

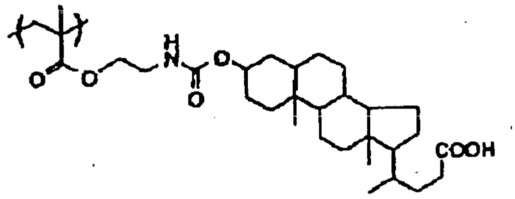

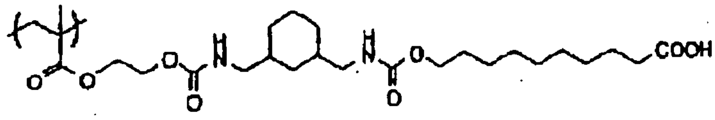

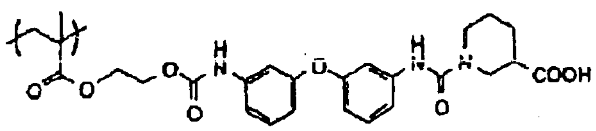

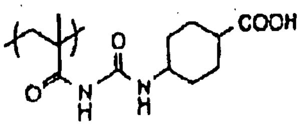

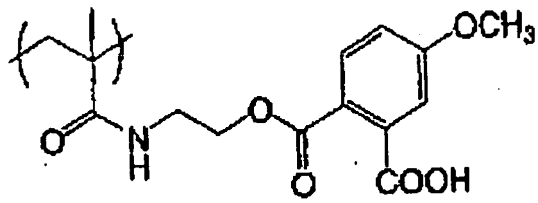

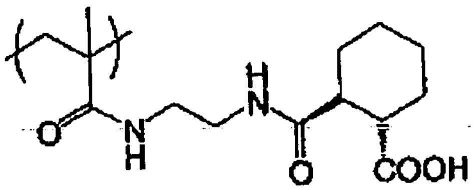

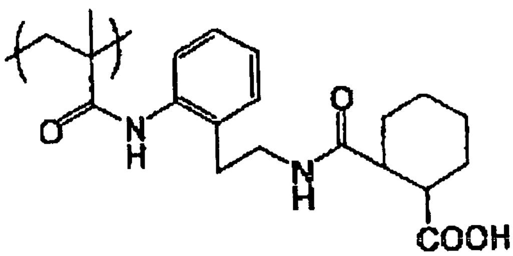

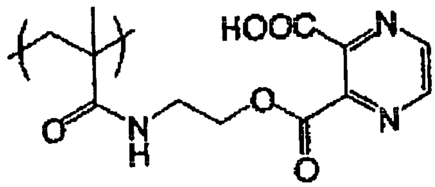

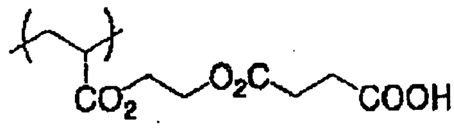

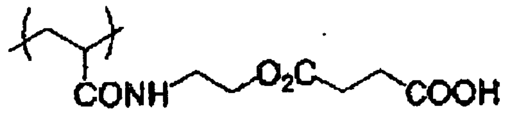

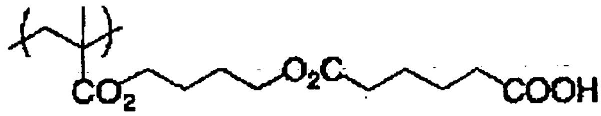

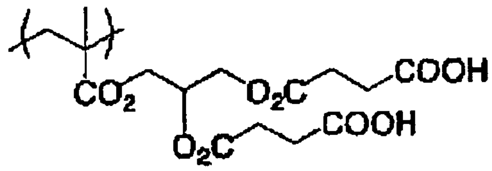

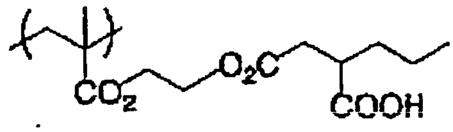

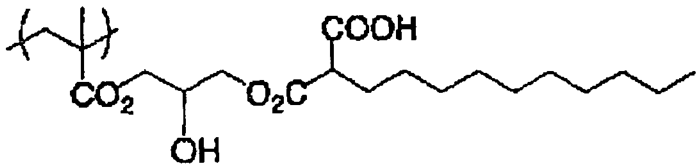

The specific (meth)acrylic resin for use in the present invention is preferably a copolymer obtained by combining a repeating unit represented by formula (i), a repeating unit having a crosslinking group in the side chain and, if desired, other copolymerization components. As for the repeating unit represented by formula (i), one kind of the repeating unit may be contained in the specific (meth)acrylic resin, or two or more kinds of the repeating units may be contained. The total content of the repeating unit represented by formula (i) is appropriately selected according to the structure of the repeating unit, the design of the polymerizable compound, or the like, but the total content is preferably from 1 to 99 mol%, more preferably from 5 to 40 mol%, still more preferably from 5 to 20 mol%, based on the total molar amount of the resin components.

Examples of the polymer having an ethylenically unsaturated bond as a crosslinking group in the side chain include a polymer which is a polymer of acrylic or methacrylic acid ester or amide and in which the ester or amide residue (R in -COOR or -CONHR) has an ethylenically unsaturated bond.

Examples of the residue (R above) having an ethylenically unsaturated bond include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (wherein $R^1$ to $R^3$ each represents a hydrogen atom, a halogen atom or an alkyl, aryl, alkoxy or aryloxy group having from 1 to 20 carbon atoms, $R^1$ may combine with $R^2$ or $R^3$ to form a ring, n represents

an integer of 1 to 10, and X represents a dicyclopentadienyl residue).

Specific examples of the ester residue include $-CH_2CH=CH_2$ (described in JP-B-7-21633), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples of the amide residue include $-CH_2CH=CH_2$, $-CH_2CH_2-Y$ (wherein Y represents a cyclohexene residue) and $-CH_2CH_2-OCO-CH=CH_2$.

In the binder polymer having a crosslinking property, for example, a free radical (a polymerization initiating radical or a radical grown in the process of polymerization of a polymerizable compound) is added to the crosslinking functional group to cause addition-polymerization between polymers directly or through a polymerization chain of the polymerizable compound, as a result, crosslinking is formed between polymer molecules and thereby curing is effected. Alternatively, an atom (for example, a hydrogen atom on the carbon atom adjacent to the functional crosslinking group) in the polymer is withdrawn by a free radical to produce a polymer radical and the polymer radicals combine with each other to form crosslinking between polymer molecules, thereby effecting curing.

The content of the crosslinking group (content of the radical-polymerizable unsaturated double bond determined by iodine titration) in the binder polymer is preferably from 0.1 to 10.0 mmol, more preferably from 1.0 to 7.0 mmol, most preferably from 2.0 to 5.5 mmol, per g of the binder polymer. Within this range, good sensitivity and good storage stability are obtained.

As for other copolymerization components, a conventionally known monomer may be used without limitation as long as it is a radical-polymerizable monomer. Specific examples thereof include monomers described in Kobunshi Data Handbook - Kiso Hen- (Polymer Data Handbook -Basic Edition-), compiled by The Society of Polymer Science, Japan, Baifukan (1986). One of these copolymerization components may be used, or two or more thereof may be used in combination.

The amount of the polymer binder having a crosslinking group in the photopolymerizable composition may be appropriately selected but is usually from 10 to 90 mass%, preferably from 20 to 80 mass%, more preferably from 30 to 70 mass%, based on the entire mass of nonvolatile components in the photopolymerizable composition.

Also, the ratio of the photopolymerizable ethylenically unsaturated bond-containing compound and the polymer binder having a crosslinking group is, in terms of the mass ratio, preferably from 1/9 to 9/1, more preferably from 2/8 to 8/2, still more preferably from 3/7 to 7/3.

Together with the polymer binder having a crosslinking group, one or more kinds of other resins may be used as the binder in combination.

The resin used in combination is generally added in an amount of 50 mass% or less, preferably 30 mass% or less, based on the mass of the polymer binder having a crosslinking group.

The molecular weight of the polymer binder for use in the present invention is appropriately selected in view of image formability and press life. The mass average molecular weight is preferably from 2,000 to 1,000,000, more preferably from 5,000 to 500,000, still more preferably from 10,000 to 200,000.

The polymer binder for use in the present invention may be used as a sole polymer binder, or two or more kinds of the polymer binders may be used in combination. Also, the polymer binder may be used as a mixture by using one or more kinds of other binder polymers having no crosslinking group in combination. As for the binder polymer which can be used in combination, a conventionally known alkalisoluble or swellable binder may be used without limitation. More specifically, for example, an acryl main chain binder or a urethane binder, which are often used in this industry, is preferably used.

The total amount of the polymer binder and the binder polymer which may be used in combination, in the photosensitive layer, may be appropriately selected but is usually from 10 to 90 mass%, preferably from 20 to 80 mass%, more preferably from 30 to 70 mass%, based on the total mass of nonvolatile components in the photosensitive layer.

[Polymerization Initiation System]

The polymerization initiation system contained in the photosensitive layer for use in the present invention may be either a photopolymerization initiation system (photon-mode initiation system) or a heat-mode initiation system.

(Photopolymerization Initiation System)

The photopolymerization initiation system (initiator) contained in the photosensitive layer of the photosensitive lithographic printing plate of the present invention may be appropriately selected from various photopolymerization initiators or a combination system of two or more photopolymerization initiators (photo-initiation system) known, for example, in patents and publications, according to the wavelength of the light source used. Specific examples thereof include, but are not limited to, the followings.

In the case of using a light source of 400 nm or more, such as visible ray, Ar laser, second harmonic of

semiconductor laser, or SHG-YAG laser, various photoinitiators have been proposed. Examples thereof include a certain kind of a photoreducing dye, such as Rose Bengal, eosin and erythrosine, described in U.S. Patent 2,850,445, and a combination system of a dye and an initiator, such as a composite initiation system of a dye and an amine (see, JP-B-44-20189), a combination system of a hexaarylbiimidazole, a radical generator and a dye (see, JP-B-45-37377), a system of a hexaarylbiimidazole and a p-dialkylaminobenzylidene ketone (see, JP-B-47-2528 and JP-A-54-155292), a system of a cyclic cis-α-dicarbonyl compound and a dye (see, JP-A-48-84183), a system of a cyclic triazine and a merocyanine dye (see, JP-A-54-151024), a system of a 3-ketocoumarin and an activator (see, JP-A-52-112681 and JP-A-58-15503), a system of a biimidazole, a styrene derivative and a thiol (see, JP-A-59-140203), a system of an organic peroxide and a coloring matter (see, JP-A-59-1504, JP-A-59-140203, JP-A-59-189340, JP-A-62-174203, JP-B-62-1641 and U.S. Patent 4,766,055), a system of a dye and an active halogen compound (see, JP-A-63-258903 and JP-A-2-63054), a system of a dye and a borate compound (see, JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), a system of a rhodanine ring-containing coloring matter and a radical generator (see, JP-A-2-179643 and JP-A-2-244050), a system of a titanocene and a 3-ketocoumarin dye (see, JP-A-63-221110), a combination system of a titanocene, a xanthene dye and an addition-polymerizable ethylenically unsaturated compound having an amino group or a urethane group (see, JP-A-4-221958 and JP-A-4-219756), a system of a titanocene and a specific merocyanine dye (see, JP-A-6-295061), and a system of a titanocene and a benzopyran ring-containing coloring matter (JP-A-8-334897).

Furthermore, with recent development of a laser having a wavelength of 400 to 410 nm (violet laser), a photo-initiation system responding thereto and showing high sensitivity to light at the wavelength of 450 nm or less has been developed and such a photo-initiation system may also be used. Examples thereof include a cationic dye/borate system (see, JP-A-11-84647), a merocyanine dye/titanocene system (see, JP-A-2000-147763), and a carbazole-type coloring matter/titanocene system (see, JP-A-2001-42524). In the present invention, a titanocene compound and a hexaarylbiimidazole compound are particularly preferred.

As for the titanocene compound, various titanocene compounds may be used, but an appropriate titanocene compound may be selected from those described in JP-A-59-152396 and JP-A-61-151197. Specific examples thereof include dicyclopentadienyl-Ti-dichloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-l-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-bis-2,6-difluorophen-1-yl and dicyclopentadienyl-Ti-bis-2,6-difluoro-3-(pyr-1-lyl)-phen-1-yl.

As for the hexaarylbiimidazole compound, various hexaarylbiimidazole compounds may be used, but examples thereof include lophine dimers described in JP-B-45-37377 and JP-B-44-86516, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, 2,2'-bis(o-trifluorophenyl)-4,4',5,5'-tetraphenylbiimidazole, 2,2'-bis(o,m-dichlorophenyl)-4,4',5,5'-tetraphenylbiimidazole and 2,2'-bis(o-chlorophenyl)-4,4',5,5'-tetra(p-bromophenyl)biimidazole.

Among these, preferred are 2,2'-bis(o-chlorophenyl)-4,4',5,5'-tetraphenylbiimidazole, 2,2'-bis(o,m-dichlorophenyl)-4,4',5,5'-tetraphenylbiimidazole and 2,2'-bis(o-chlorophenyl)-4,4',5,5'-tetra(p-bromophenyl)biimidazole.

Furthermore, if desired, a compound called chain transfer agent or sensitization aid known to more enhance the photo-initiation ability when used in combination with a photopolymerization initiator may be used in the above-described photopolymerization initiation system. Examples of such a compound include a hydrogen-donating compound such as thiol compound (e.g., 2-mercaptobenzothiazole, 2-mercaptobenzimidazole, 2-mercaptobenzoxazole) and amine compound (e.g., N-phenylglycin, N,N-dialkylamino-aromatic alkyl ether).

The photopolymerization initiator (initiation system) is used in an amount of 0.05 to 100 parts by mass, preferably from 0.1 to 70 parts by mass, more preferably from 0.2 to 50 parts by mass, per 100 parts by mass of an ethylenically unsaturated compound described later.

(Heat-Mode Initiation System)

A heat-mode polymerization system may also be applied to the photosensitive lithographic printing plate of the present invention. In the heat-mode polymerization system, a combination of an infrared absorbent and a polymerization initiator is used in place of the above-described photopolymerization initiation system. As for the hydrogen-donating compound or chain transfer agent for accelerating the polymerization, a compound described in connection with the photopolymerization system may be appropriately used, if desired.

(1) Infrared Absorbent

It is essential to use an infrared absorbent in the photosensitive composition of the present invention. The infrared absorbent has a function of converting the absorbed infrared ray into heat. By the effect of heat generated here, the polymerization initiator (radical generator) described later is thermally decomposed to generate a radical. The infrared absorbent for use in the present invention is preferably a dye or pigment having absorption maximum in the wavelength region from 760 to 1,200 nm.

As for the dye, commercially available dyes and known dyes, for example, those described in publications such as Senryo Binran (Handbook of Dyes), compiled by The Society of Synthetic Organic Chemistry, Japan (1970) may be used. Specific examples thereof include dyes such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Preferred examples of the dye include cyanine dyes described in JP-A-58-125246, JP-A-59-84356 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiapyrylium salts described in U.S. Patent 4,283,475, and pyrylium compounds described in JP-B-5-13514 and JP-B-5-19702 may also be preferably used. Other preferred examples of the dye include near infrared absorbing dyes represented by formulae (I) and (II) of U.S. Patent 4,756,993.

Also, other preferred examples of the infrared absorbing dye for use in the present invention include specific indolenine cyanine dyes described in Japanese Patent Application Nos. 2001-6326 and 2001-237840, such as those shown below.

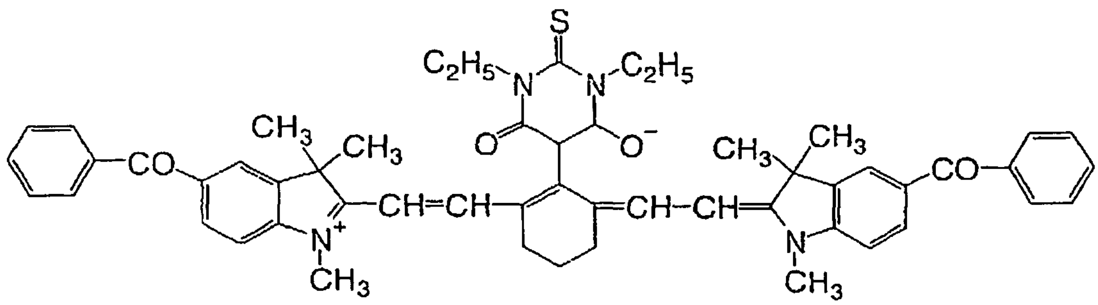

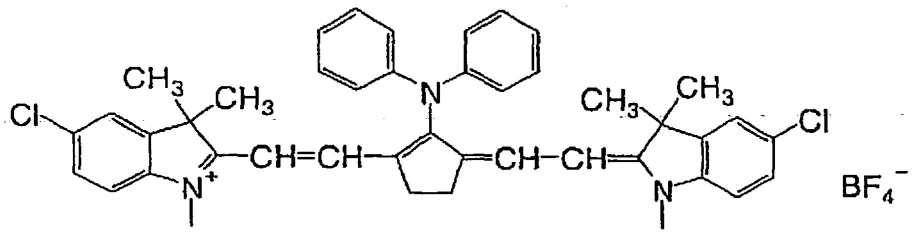

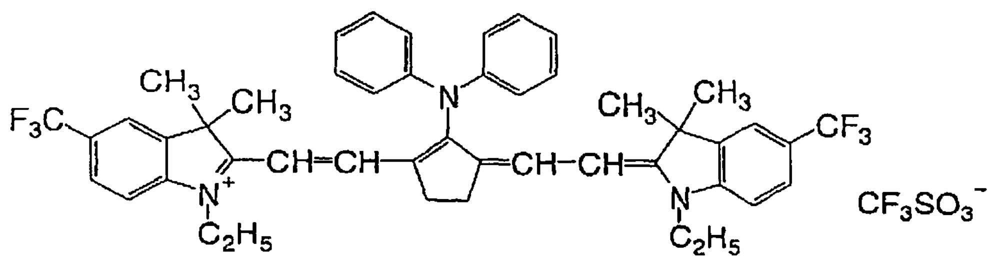

Among these dyes, preferred are a cyanine dye, a squarylium dye, a pyrylium salt, a nickel thiolate complex

and an indolenine cyanine dye, more preferred are a cyanine dye and an indolenine cyanine dye. A particularly preferred example of the dye is a cyanine dye represented by the following formula (a):

Formula (a):

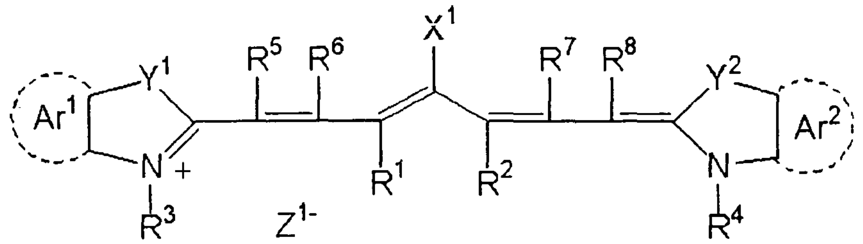

In formula (a), $X^1$ represents a hydrogen atom, a halogen atom, $-NPh_2$, $X^2-L^1$ or a group shown below (wherein $X^2$ represents an oxygen atom, a nitrogen atom or a sulfur atom, $L^1$ represents a hydrocarbon group having from 1 to 12 carbon atoms, an aromatic ring having a heteroatom, or a hydrocarbon group having from 1 to 12 carbon atoms and containing a heteroatom (the heteroatom as used herein indicates N, S, O, a halogen atom or Se), $X_a^-$ has the same definition as $Z^{1-}$ described later, and $R^a$ represents a substituent selected from a hydrogen atom, an alkyl group, an aryl group, a substituted or unsubstituted amino group and a halogen atom).

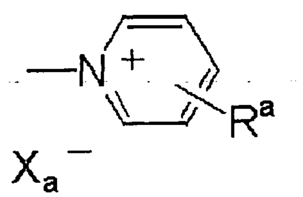

$R^1$ and $R^2$ each independently represents a hydrocarbon group having from 1 to 12 carbon atoms. In view of storage stability of the coating solution for recording layer, $R^1$ and $R^2$ each is preferably a hydrocarbon group having 2 or more carbon atoms, and $R^1$ and $R^2$ are more preferably combined with each other to form a 5- or 6-membered ring.

$Ar^1$ and $Ar^2$ may be the same or different and each represents an aromatic hydrocarbon group which may have a substituent. Preferred examples of the aromatic hydrocarbon group include a benzene ring and a naphthalene ring. Preferred examples of the substituent include a hydrocarbon group having 12 or less carbon atoms, a halogen atom and an alkoxy group having 12 or less carbon atoms. $Y^1$ and $Y^2$ may be the same or different and each represents a sulfur atom or a dialkylmethylene group having 12 or less carbon atoms. $R^3$ and $R^4$ may be the same or different and each represents a hydrocarbon group having 20 or less carbon atoms, which may have a substituent. Preferred examples of the substituent include an alkoxy group having 12 or less carbon atoms, a carboxyl group and a sulfo group. $R^5$, $R^6$, $R^7$ and $R^8$ may be the same or different and each represents a hydrogen atom or a hydrocarbon group having 12 or less carbon atoms and in view of availability of the raw material, preferably a hydrogen atom. $Za^-$ represents a counter anion, but when the cyanine dye represented by formula (a) has an anionic substituent in its structure and neutralization of electric charge is not necessary, $Za^-$ is not present. In view of storage stability of the coating solution for recording layer, $Za^-$ is preferably halogen ion, perchlorate ion, tetrafluoroborate ion, hexafluorophosphate ion or sulfonate ion, more preferably perchlorate ion, hexafluorophosphate ion or arylsulfonate ion.

Specific examples of the cyanine dye represented by formula (a), which can be suitably used in the present invention, include those described in paragraphs [0017] to [0019] of JP-A-2001-133969.

Other preferred examples include specific indolenine cyanine dyes described in Japanese Patent Application Nos. 2001-6326 and 2001-237840 which are cited above.

As for the pigment used in the present invention, commercially available pigments and pigments described in Color Index (C.I.) Binran C.I. Handbook), Saishin Ganryo Binran (Handbook of Latest Pigments), compiled by Nippon Ganryo Gijutsu Kyokai (1977), Saishin Ganryo Oyo Gijutsu (Latest Pigment Application Technology), CMC Shuppan (1986), and Insatsu Ink Gijutsu (Printing Ink Technology), CMC Shuppan (1984) can be used.

The kind of the pigment includes black pigment, yellow pigment, orange pigment, brown pigment, red pigment, violet pigment, blue pigment, green pigment, fluorescent pigment, metal powder pigment and polymer bond pigment. Specific examples of the pigment which can be used include an insoluble azo pigment, an azo lake pigment, a condensed azo pigment, a chelate azo pigment, a phthalocyanine-based pigment, an anthraquinone-based pigment, a perylene-

or perynone-based pigment, a thioindigo-based pigment, a quinacridone-based pigment, a dioxazine-based pigment, an isoindolinone-based pigment, a quinophthalone-based pigment, a dyed lake pigment, an azine pigment, a nitroso pigment, a nitro pigments, a natural pigment, a fluorescent pigment, an inorganic pigment and carbon black. Among these pigments, carbon black is preferred.

These pigments may or may not be surface-treated before use. Examples of the method for surface treatment include a method of coating the surface with resin or wax, a method of attaching a surfactant, and a method of binding a reactive substance (for example, a silane coupling agent, an epoxy compound or an isocyanate) to the pigment surface. These surface-treating methods are described in Kinzoku Sekken no Seishitsu to Oyo (properties and Application of Metal Soap), Saiwai Shobo, Insatsu Ink Gijutsu (Printing Ink Technology), CMC Shuppan (1984), and Saishin Ganryo Oyo Gijutsu (Latest Pigment Application Technology), CMC Shuppan (1986).

The particle diameter of the pigment is preferably from 0.01 to 10 (μm, more preferably from 0.05 to 1 μm, still more preferably from 0.1 to 1 μm. If the particle diameter of the pigment is less than 0.01 μm, this is not preferred in view of stability of the dispersion in the coating solution for photosensitive layer, and a particle diameter exceeding 10 μm is not preferred in view of uniformity of the photosensitive layer.

As for the method of dispersing the pigment, a known dispersion technique employed in the production of ink or toner may be used. Examples of the disperser include an ultrasonic disperser, a sand mill, an attritor, a pearl mill, a super-mill, a ball mill, an impeller, a disperser, a KD mill, a colloid mill, a dynatron, a three-roll mill and a pressure kneader. These are described in detail in Saishin Ganryo Oyo Gijutsu (Latest Pigment Application Technology), CMC Shuppan (1986).

In the case of applying the photosensitive composition of the present invention to a photosensitive lithographic printing plate, the infrared absorbent may be added together with other components in the same layer or may be added to a layer provided separately, but the infrared absorbent is preferably added such that when a negative lithographic printing plate precursor is produced, the absorbancy of the photosensitive layer at a maximum absorption wavelength in the wavelength range from 760 to 1,200 nm becomes from 0.5 to 1.2, more preferably from 0.6 to 1.15, as measured by a reflection measuring method. If the absorbancy is out of this range, the strength of the image area is reduced and the number of printed sheets at the printing decreases. The cause thereof is not clearly known, but it is presumed that if the absorbancy is less than 0.5, the infrared ray irradiated cannot be satisfactorily absorbed, as a result, radical polymerization does not sufficiently proceed in the entire photosensitive layer, whereas if the absorbancy exceeds 1.2, the ultraviolet ray is absorbed only in the outermost surface of the photosensitive layer and fails in reaching the vicinity of the support, as a result, radical polymerization does not occur in the vicinity of the support and the adhesive strength between the support and the photosensitive layer becomes insufficient.

The absorbancy of the photosensitive layer can be adjusted by the amount of the infrared absorbent added to the photosensitive layer and the thickness of the photosensitive layer. The absorbancy can be measured by an ordinary method. Examples of the measuring method include a method where a photosensitive layer having a thickness appropriately decided within the range of the dry coated amount necessary as a lithographic printing plate is formed on a reflective support such as aluminum and the reflection density is measured by an optical densitometer, and a method of measuring the absorbancy by a spectrophotometer according to a reflection method using an integrating sphere.

(2) Polymerization Initiator

In the heat-mode system, a polymerization initiator is used in combination with the above-described infrared absorbent, and this polymerization initiator generates a radical by the effect of heat generated from the ultraviolet absorbent upon irradiation with an infrared laser. The polymerization initiator for the heat-mode system may be selected from the polymerization initiators described for the photopolymerization system, but an onium salt is preferably used and a sulfonium salt polymerization initiator is more preferred. In the present invention, when the infrared absorbent is combined with an onium salt polymerization initiator, high-sensitivity heat-mode recording can be achieved.

Examples of the sulfonium salt polymerization initiator which is suitably used in the present invention include an onium salt represented by the following formula (I):

Formula (I):

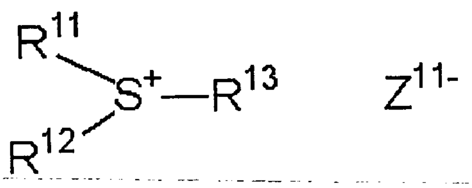

In formula (I), $R^{11}$, $R^{12}$ and $R^{13}$, which may be the same or different, each represents a hydrocarbon group having 20 or less carbon atoms, which may have a substituent. Preferred examples of the substituent include a halogen atom, a nitro group, an alkyl group having 12 or less carbon atoms, an alkoxy group having 12 or less carbon atoms, and an aryloxy group having 12 or less carbon atoms. $Z^{11-}$ represents a counter ion selected from a halogen ion, a perchlorate ion, a tetrafluoroborate ion, a hexafluorophosphate ion, a carboxylate ion and a sulfonate ion, and is preferably a perchlorate ion, a hexafluorophosphate ion, a carboxylate ion or an arylsulfonate ion.

Specific examples of the onium salt represented by formula (I) are set forth below ([OS-1] to [OS-10], but the present invention is not limited thereto.

[OS-1]

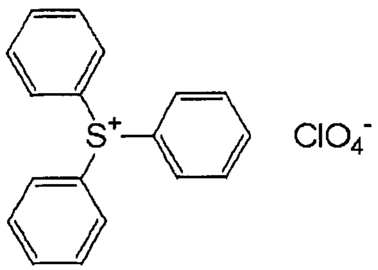

[OS-2]

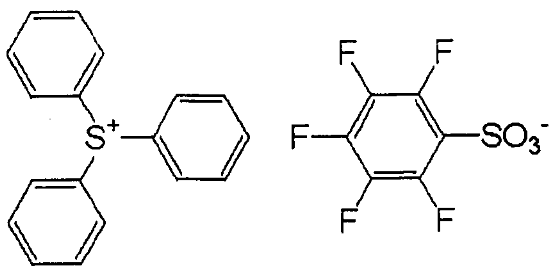

[OS-3]

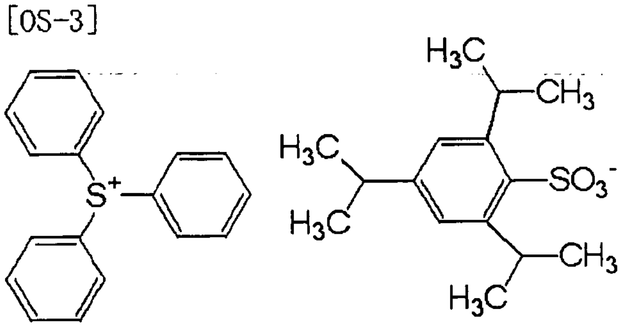

[OS-4]

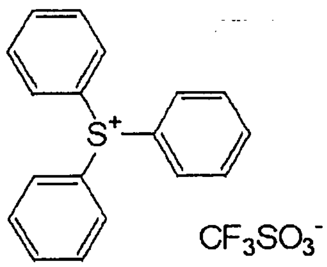

[OS-5]

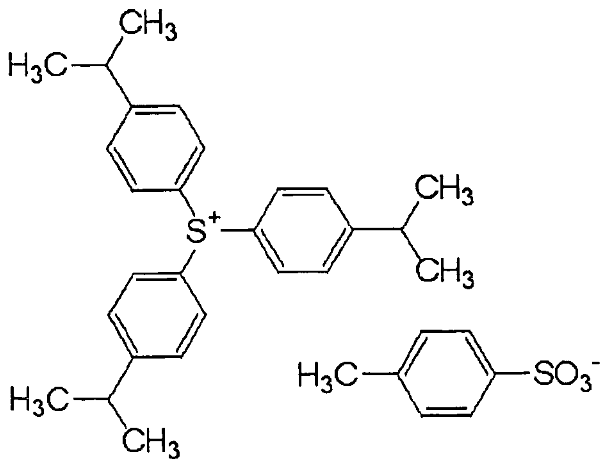

[OS-6]

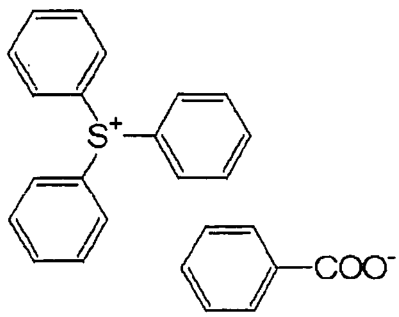

[OS-7]

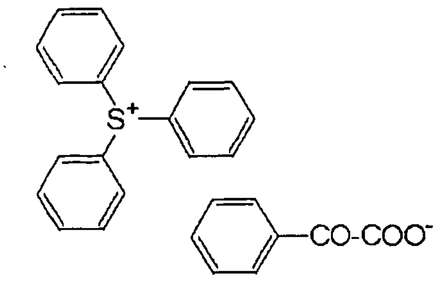

[OS-8]

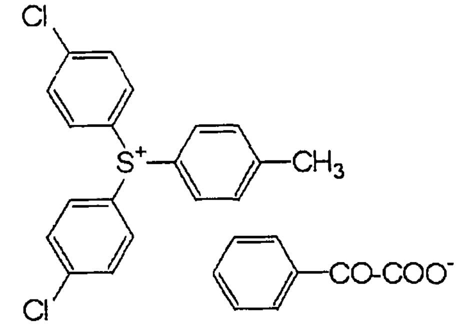

[OS-9]

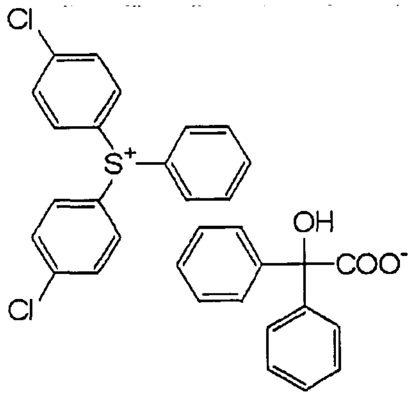

[OS-10]

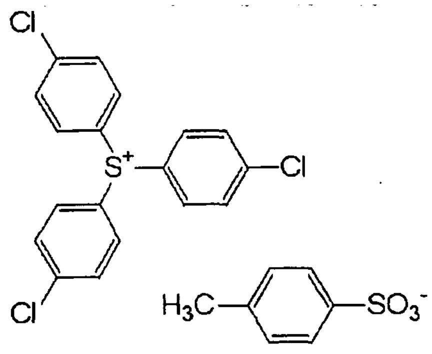

Other than those described above, specific aromatic sulfonium salts described in JP-A-2002-148790, JP-A-2002-148790, JP-A-2002-350207 and JP-A-2002-6482 are suitably used.

In the present invention, an onium salt except for the above-described sulfonium salt polymerization initiator is also suitably used. Examples of such an onium salt include an iodonium salt and a diazonium salt. Specific examples thereof include onium salts represented by the following formulae (II) and (III):

Formula (II): $Ar^{21}\text{-}I^{+}\text{-}Ar^{22}\ Z^{21-}$

Formula (III): $Ar^{31}\text{-}N^{+}{\equiv}N\ Z^{31-}$

In formula (II), $Ar^{21}$ and $Ar^{22}$ each independently represents an aryl group having 20 or less carbon atoms, which may have a substituent. When the aryl group has a substituent, preferred examples of the substituent include a halogen atom, a nitro group, an alkyl group having from 12 or less carbon atoms, an alkoxy group having 12 or less carbon atoms, and an aryloxy group having 12 or less carbon atoms. $Z^{21-}$represents a counter ion having the same meaning as $Z^{11-}$.

In formula (III), $Ar^{31}$ represents an aryl group having 20 or less carbon atoms, which may have a substituent. Preferred examples of the substituent include a halogen atom, a nitro group, an alkyl group having 12 or less carbon atoms, an alkoxy group having 12 or less carbon atoms, an aryloxy group having 12 or less carbon atoms, an alkylamino group having 12 or less carbon atoms, a dialkylamino group having 12 or less carbon atoms, an arylamino group having 12 or less carbon atoms, and a diarylamino group having 12 or less carbon atoms. $Z^{31-}$ represents a counter ion having the same meanings as $Z^{11-}$.

Specific examples of the onium salt represented by formula (II) ([OI-1] to [OI-10]) and the onium salt represented by formula (III) ([ON-1] to [ON-5]), which can be suitably used in the present invention, are set forth below, but the present invention is not limited thereto.

[ OI-1 ]

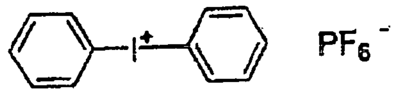

[ OI-2 ]

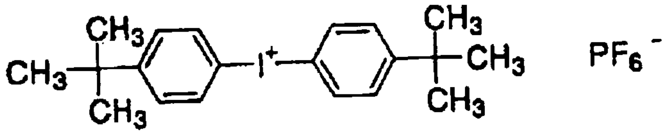

[ OI-3 ]

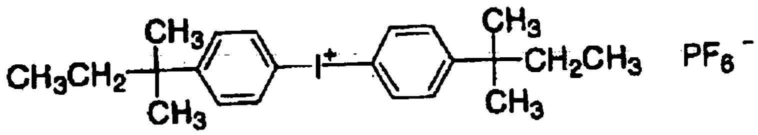

[ OI-4 ]

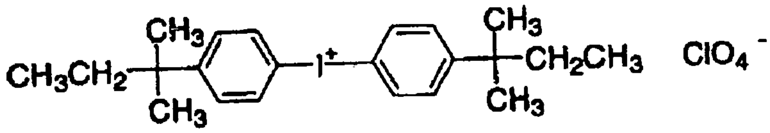

[ OI-5 ]

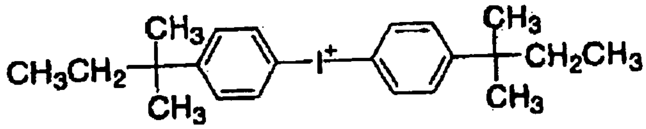

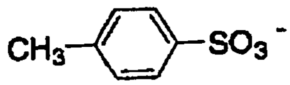

[ OI-6 ]

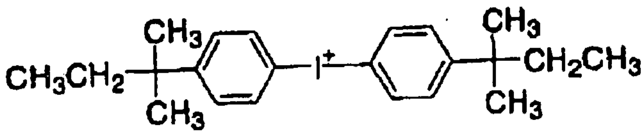

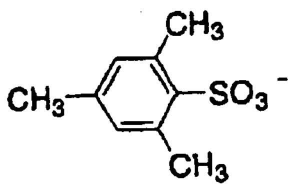

[ OI-7 ]

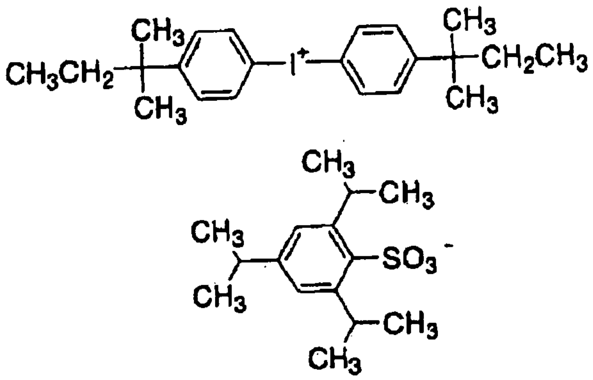

[ OI-8 ]

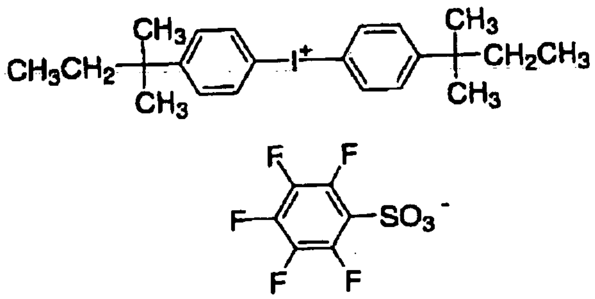

[ OI-9 ]

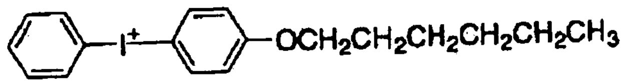

[ OI-10 ]

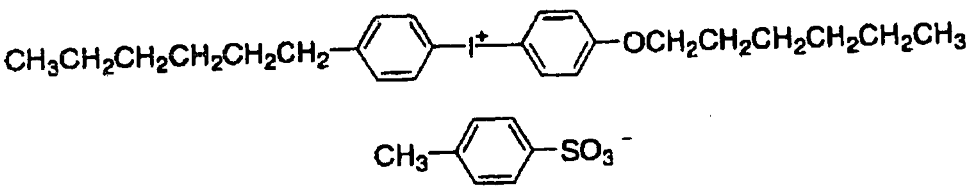

[ ON-1 ]

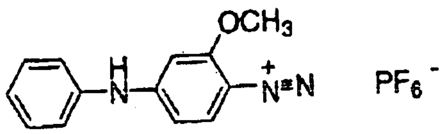

[ ON-2 ]

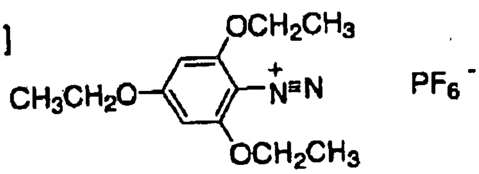

[ ON-3 ]

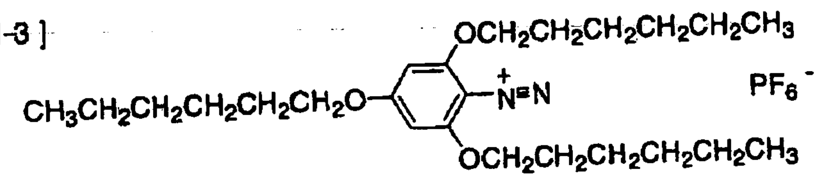

[ ON-4 ]

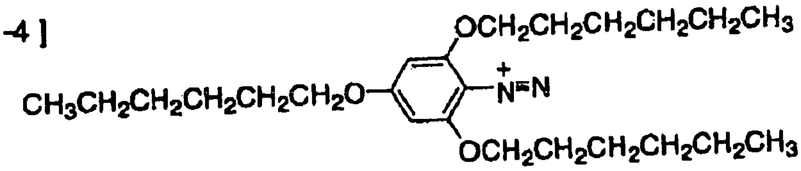

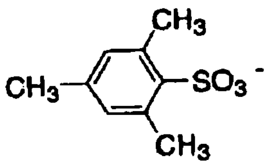

[ ON-5 ]

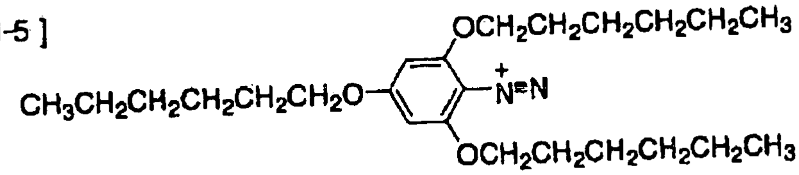

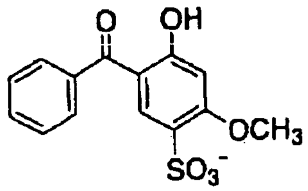

Specific examples of the onium salt which can be suitably used as the polymerization initiator in the present invention include those described in JP-A-2001-133969.

The polymerization initiator (radical generator) for use in the present invention preferably has a maximum absorption wavelength of 400 nm or less, more preferably 360 nm or less. By specifying the absorption wavelength in this way to the ultraviolet region, the photosensitive lithographic printing plate can be handled under white light.

The total content of the polymerization initiator in the photosensitive layer is from 0.1 to 50 mass%, preferably from 0.5 to 30 mass%, more preferably from 1 to 20 mass%, based on the entire solid content.

[Thermal polymerization inhibitor]

Furthermore, in the invention, in addition to the foregoing basic components, it is desired to add a small amount of a thermal polymerization inhibitor during the production or storage of the photopolymerizable composition for the purpose of preventing unnecessary thermal polymerization of the polymerizable ethylenically unsaturated bond-containing compound from occurring. Examples of a suitable thermal polymerization inhibitor include hydroquinone, p-methoxyphenol, di-t-butyl-p-cresol, pyrogallol, t-butyl chatecol, benzoquinone, 4,4'-thiobis(3-methyl-6-t-butylphenol), 2,2'-methylenebis(4-methyl-6-t-butylphenol), N-nitrosophenylhydroxylamine cerous salt, and N-nitrosophenylhydroxylamine aluminum salt.

The amount of addition of the thermal polymerization inhibitor is preferably from about 0.01 % by weight to about 5 % by weight based on the whole of solids constituting the photosensitive layer. Furthermore, if desired, for the purpose of preventing polymerization hindrance due to oxygen, a higher fatty acid derivative such as behenic acid and behenic amide may be added, thereby unevenly distributing it on the surface of the photosensitive layer during a drying step to be carried out after coating. The amount of addition of the higher fatty acid derivative or the like is preferably from about 0.5 % by weight to about 10 % by weight based on the whole of solids constituting the photosensitive layer.

[Other additives]

In addition, for the purpose of coloring the photosensitive layer, a coloring agent may be added. Examples of the coloring agent include pigments (for example, phthalocyanine based pigments (for example, C.I. Pigment Blue 15:3, C.I. Pigment Blue 15:4, and C.I. Pigment Blue 15:6), azo based pigments, carbon black, and titanium oxide) and dyes

(for example, Ethyl Violet, Crystal Violet, azo based dyes, anthraquinone based dyes, and cyanine based dyes). The amount of addition of the dye or pigment is preferably from about 0.5 % by weight to about 20 % by weight of the entire composition. In addition, for the purpose of improving physical properties of the cured film, additives such as an inorganic filler and a plasticizer (for example, dioctyl phthalate, dimethyl phthalate, and tricresyl phosphate) may be added. The amount of addition of such an additive is preferably not more than 10 % by weight of the entire composition.

[Coating liquid]

In coating the photosensitive layer, the foregoing respective components are dissolved in a solvent to form a coating liquid. Examples of the solvent which is used herein include organic solvents such as acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate-3-methoxypropyl acetate, N,N-dimethylformamide, dimethyl sulfoxide, γ-butyrolactone, methyl lactate, and ethyl lactate. Such a solvent can be used singly or in admixture.

The concentration of solids in the coating liquid is usually from 1 to 50 % by weight.

Furthermore, for the purpose of enhancing the coating surface quality, it is possible to add a surfactant.

The coating amount of the photosensitive layer is usually from about 0.1 to about 10 g/m$^2$, preferably from 0.3 to 5 g/m$^2$, and more preferably from 0.5 to 3 g/m$^2$ in terms of weight after drying.

(Support)

In order to obtain a lithographic printing plate in the invention, the foregoing photosensitive layer is provided on a support, the surface of which is hydrophilic. As the hydrophilic support, conventionally known hydrophilic supports which are useful in lithographic printing plates can be used without limitations. It is preferable that the support to be used is a dimensionally stable plate-like material. Examples of the support include papers, papers laminated with a plastic (for example, polyethylene, polypropylene, and polystyrene), metal plates (for example, aluminum, zinc, and copper), plastic films (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonates, and polyvinyl acetal), and papers or plastic films having the foregoing metal laminated or vapor deposited thereon. If desired, the surface of such a support may be subjected to a proper known physical or chemical treatment for the purposes of imparting hydrophilicity, enhancing the strength, and so on.

In particular, as the preferred support, there are enumerated papers, polyester films, and aluminum plates. Of these, aluminum plates which have good dimensional stability, are relatively cheap and can provide a surface having more excellent hydrophilicity and strength by a surface treatment as the need arises are especially preferable. Furthermore, a composite sheet having an aluminum sheet coupled on a polyethylene terephthalate film as described in JP-B-48-18327 is also preferable.

The aluminum substrate is a dimensionally stable metal plate containing aluminum as the major component and includes pure aluminum plates and alloy plates containing aluminum as the major component and a slight amount of foreign elements. Plastic films or papers having aluminum (alloy) laminated or vapor deposited thereon are also employable.

In the foregoing description, the foregoing substrate made of aluminum or an aluminum alloy is named generically as an aluminum substrate and used. Examples of the foreign elements in the alloy include silicon, iron, manganese, copper, magnesium, chromium, zinc, bismuth, nickel, and titanium. The content of the foreign elements in the alloy is not more than 10 % by weight. In the invention, while a pure aluminum plate is suitable, since it is difficult to produce completely pure aluminum according to the smelting technology, a slight amount of foreign elements may be contained.

With respect to the aluminum plate which is applied in the invention, its composition is not specified, but conventionally known and publicly used raw materials such as JIS A 1050, JIS A 1100, JIS A 3103, and JIS A 3005 can be properly utilized. Furthermore, the thickness of the aluminum substrate which is used in the invention is from about 0.1 mm to 0.6 mm, preferably from 0.15 mm to 0.4 mm, and especially preferably from 0.2 mm to 0.3 mm. This thickness can be properly varied depending upon the size of a printing machine, the size of a printing plate, and the desire of a user. The aluminum substrate may be properly subjected to a substrate surface treatment as described later as the need arises. As a matter of course, the aluminum substrate may not be subjected to a substrate surface treatment.

The aluminum substrate is usually subjected to a surface roughing treatment. Examples of the surface roughing treatment include mechanical surface roughing, chemical etching, and electrolytic graining as disclosed in JP-A-56-28893. In addition, an electrochemical surface roughing method for performing electrochemical surface roughing in a hydrochloric acid or nitric acid electrolytic liquid and a mechanical surface roughing method such as a wire brush graining method for scratching the aluminum surface by a metallic wire, a ball graining method for graining the aluminum surface by an abrasive ball and an abrasive material, and a brush graining method for subjecting the surface to surface roughing by a nylon brush and an abrasive material are employable. The foregoing surface roughing methods can be carried out singly or in combination. Above all, the method which is usually employed is an electrochemical method for performing chemical surface roughing in a hydrochloric acid or nitric acid electrolytic liquid. The quantity of electricity at the time of anode is suitably in the range of from 50 C/dm$^2$ to 400 C/dm$^2$. More specifically, it is preferable that alternating current and/or direct current electrolysis is carried out in an electrolytic liquid containing from 0.1 to 50 % of hydrochloric acid or nitric acid under conditions at a temperature of from 20 to 100 °C for a period of time of from 1 second to 30 minutes in a current density of from 100 C/dm$^2$ to 400 C/dm$^2$.

The thus surface roughed aluminum substrate may be chemically etched with an acid or an alkali. Examples of an etching agent which is suitably used include sodium hydroxide, sodium carbonate, sodium aluminate, sodium metasilicate, sodium phosphate, potassium hydroxide, and lithium hydroxide. Preferred ranges of the concentration and temperature are from 1 to 50 % and from 20 to 100 °C, respectively. After the etching, for the purpose of removing smuts remaining on the surface, acid washing is carried out. Examples of the acid to be used include nitric acid, sulfuric acid, phosphoric acid, chromic acid, hydrofluoric acid, and borofluoric acid. In particular, as the method for removing smuts after the electrochemical surface roughing treatment, a method for bringing it into contact with sulfuric acid of from 15 to 65 % by weight at a temperature of from 50 to 90 °C as described in JP-A-53-12739 and an alkaline etching method as described in JP-B-48-28123 are preferable. So far as after such treatments, the treated surface has a center line average roughness (Ra) of from 0.2 to 0.5 μm, the method and conditions are not particularly limited.

The thus surface roughed aluminum substrate is then subjected to an anodic oxidation treatment to form an oxidized film. For the anodic oxidation treatment, an aqueous solution of sulfuric acid, phosphoric acid, oxalic acid, or boric acid/sodium borate is used singly, or a combination of plural kinds thereof is used as the major component of an electrolytic bath. As a matter of course, the electrolytic liquid may contain components which are usually at least contained in Al alloy plate, electrodes, tap water, ground water, or the like. In addition, a second or third component may be added. Examples of the second or third component as referred to herein include cations such as ions of metals (for example, Na, K, Mg, Li, Ca, Ti, Al, V, Cr, Mn, Fe, Co, Ni, Cu, and Zn) and an ammonium ion; and anions such as a nitric acid ion, a carbonic acid ion, a chlorine ion, a phosphoric acid ion, a fluorine ion, a phosphorous acid ion, a titanium acid ion, a silicic acid ion, and a boric acid ion. The second or third component may be contained in a concentration of from approximately 0 to 10,000 ppm. Though the conditions of the anodic oxidation treatment are not particularly limited, the anodic oxidation treatment is carried out by direct current or alternating current electrolysis in a concentration ranging from 30 to 500 g/liter at a treatment temperature ranging from 10 to 70 °C in a current density ranging from 0.1 to 40 A/m$^2$. The thickness of the formed anodically oxidized film is in the range of from 0.5 to 1.5 μm, and preferably in the range of from 0.5 to 1.0 μm.

In addition, after carrying out these treatments, a treatment for undercoating a water-soluble resin (for example, polyvinyl phosphonic acid, polymers or copolymers having a sulfonic group in the side chain thereof, and polyacrylic acid), a water-soluble metal salt (for example, zinc borate), a yellow dye, an amine salt, etc. is suitable. Moreover, a sol-gel treated substrate which has been subjected to covalent bonding with a functional group capable of causing addition reaction by a radical as disclosed in JP-A-7-159983 is suitably used.

As other preferred examples, there can be enumerated ones in which a waterproof hydrophilic layer is provided as a surface layer on an arbitrary support. Examples of such a surface layer include layers comprising an inorganic pigment and a binder as described in U.S. Patent No. 3,055,295 and JP-A-56-13168, hydrophilic swelling layers as described in JP-A-9-80744, and sol-gel films comprising titanium oxide, polyvinyl alcohol, and a silicic acid as described in JP-T-8-507727. Such a hydrophilic treatment is carried out for the purposes of, in addition to making the surface of the support hydrophilic, preventing harmful reaction of the photopolymerizable composition to be provided thereon and enhancing adhesion of the photosensitive layer.

[Intermediate layer]

For the purpose of improving adhesion between the photosensitive layer and the substrate and staining properties, the photosensitive lithographic printing plate in the invention may be provided with an intermediate layer. Specific examples of the such an intermediate layer include ones as described in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A-2000-235254, JP-A-2000-352824, JP-A-2001-209170, and so on.

<Inserting Paper>

In the present invention, an inserting paper is used for preventing the protective layer from being damaged during storage or conveyance of the photosensitive lithographic printing plate.

Generally, the photosensitive lithographic printing plate is, for example, stored, stocked or transported in the state that an inserting paper is interposed between plate materials so as to prevent mechanical shock during storage or reduce unwanted impact during conveyance, and various inserting papers are known.

As for the paper material of the inserting paper, wood pulp, synthetic pulp (polyethylene fiber), natural fiber such as hemp, regenerated cellulose and the like may be used.

In many cases, a low-cost raw material is selected for the inserting paper so as to reduce the material cost. Examples of the inserting paper which can be used include a paper using 100% wood pulp, a paper using a mixture of wood pulp and synthetic pulp, and a paper obtained by providing a low-density or high-density polyethylene layer on the surface of such a paper. Particularly, in the case of a paper not using synthetic pulp or a polyethylene layer, the material cost is low and in turn, the inserting paper can be produced at a low cost.

More specifically, the inserting paper is preferably a paper produced from a paper material prepared by beating bleached kraft pulp, diluting it to a concentration of 4%, adding a sizing agent and a paper-strengthening agent in an amount of 0.1% and 0.2%, respectively, based on the mass of the base paper, and further adding aluminum sulfate until the pH value reaches 5.0, in which the inserting paper has a basis weight of 20 to 60 $g/m^2$, preferably from 25 to 50 $g/m^2$ (according to the measurement method prescribed in JIS P 8124), and a thickness of 42 to 80 $\mu m$, preferably from 45 to 55 $\mu m$, more preferably from 40 to 50 $\mu m$ (according to the measurement method prescribed in JIS P 8118), and satisfies the chemical requirement that no $NH_3$ gas is detected by a $NH_3$ gas detection method of cutting 20 g of a sample into fine pieces, placing the sample in 100 g of pure water and after heating it in a sealed state at 110°C for 10 minutes, measuring a $NH_3$ gas by a Kitagawa gas detecting tube (for 20 ppm) and at the same time, no white turbidity is observed in a chloride detection method of placing 3 ml of an inserting paper sample in 6 ml of distilled water, adding 2 drops of a 1 mass% silver nitrate solution thereto, and observing the presence or absence of white turbidity due to chloride. Among the inserting papers according to this design, preferred is an inserting paper having a basis weight of 30 to 60 $g/m^2$, a smoothness of 10 to 100 seconds as measured by the Bekk smoothness measurement method prescribed in JIS P 8119, a water content of 4 to 8% as measured by the water content measurement method prescribed in JIS P 8127, and a density of 0.7 to 0.9 $g/cm^3$.

In the present invention, such a known inserting paper may be appropriately selected and used.

<Plate-Making Method>

The plate-making method for the photosensitive lithographic printing plate of the present invention is described in detail below. The above-described photosensitive lithographic printing plate is image-exposed and then developed with an aqueous alkali solution. The developer for use in the plate-making method of the present invention is described below.

[Developing solution]

Though the developing solution to be used in the plate-making process of the photosensitive lithographic printing plate of the invention is not particularly limited, for example, a developing solution containing an inorganic alkaline salt and a nonionic surfactant and usually having a pH of from 11.0 to 12.5 is suitably used.

The inorganic alkaline salt can be properly used. Examples thereof include inorganic alkaline agents such as sodium hydroxide, potassium hydroxide, ammonium hydroxide, lithium hydroxide, sodium silicate, potassium silicate, ammonium silicate, lithium silicate, sodium triphosphate, potassium triphosphate, ammonium triphosphate, sodium carbonate, potassium carbonate, ammonium carbonate, sodium hydrogencarbonate, potassium hydrogencarbonate, ammonium hydrogencarbonate, sodium borate, potassium borate, and ammonium borate. These inorganic alkaline agents may be used singly or in combination of two or more kinds thereof.

In the case where a silicate is used, it is possible to easily adjust developability by regulating a mixing ratio and a concentration of silicon oxide $SiO_2$ as a component of the silicate and an alkaline oxide $M_2O$ (wherein M represents an alkali metal or an ammonium group). Among the foregoing alkaline aqueous solutions, ones having a mixing ratio of the foregoing silicon oxide $SiO_2$ and the alkaline oxide $M_2O$ (a molar ratio of $SiO_2/M_2O$) of from 0.5 to 3.0 are preferable, and ones having the subject mixing ratio of from 1.0 to 2.0 are more preferable. The amount of addition of the foregoing $SiO_2/M_2O$ mixture is preferably from 1 to 10 % by weight, more preferably from 3 to 8 % by weight, and most preferably from 4 to 7 % by weight based on the weight of the alkaline aqueous solution. When this concentration falls within the foregoing range, the developability and treatment ability are not lowered, the generation of precipitation or the formation of a crystal does not occur, and gelation does not occur during neutralization at the time of discharging a waste liquid

so that the treatment of waste liquid is not impaired.

Furthermore, for the purposes of finely regulating the alkaline concentration and assisting the solubility of the photosensitive layer, an organic alkaline agent may be auxiliarily used jointly. Examples of the organic alkaline agent which can be used jointly include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkaline agents are used singly or in combination of two or more kinds thereof.

The surfactant can be properly used. Examples thereof include nonionic surfactants such as polyoxyalkylene ether group-containing nonionic surfactants, polyoxyethylene alkyl esters (for example, polyoxyethylene stearate), sorbitan alkyl esters (for example, sorbitan monolaurate, sorbitan monostearate, sorbitan distearate, sorbitan monooleate, sorbitan sesquioleate, and sorbitan trioleate), and monoglyceride alkyl esters (for example, glycerol monostearate and glycerol monooleate); anionic surfactants such as alkylbenzenesulfonic acid salts (for example, sodium dodecylbenzenesulfonate), alkylnaphthalenesulfonic acid salts (for example, sodium butylnaphthalenesulfonate, sodium pentylnaphthalenesulfonate, sodium hexylnaphthalenesulfonate, and sodium octylnaphthalenesulfonate), alkylsulfuric acid salts (for example, sodium laurylsulfate), alkylsulfonic acid salts (for example, sodium dodecylsulfonate), and sulfosuccinic acid ester salts (for example, sodium dilaurylsulfosuccinate); and ampholytic surfactants such as alkyl betaines (for example, lauryl betaine and stearyl betaine) and amino acids. Of these, polyoxyalkylene ether group-containing nonionic surfactants are especially preferable.

As the polyoxyalkylene ether group-containing nonionic surfactant, ones having a structure represented by the following formula (IV) are suitably used.

$$R^{40}\text{-O-}(R^{41}\text{-O})_pH \qquad \text{(IV)}$$

In the foregoing formula (IV), $R^{40}$ represents an alkyl group having from 3 to 15 carbon atoms, an aromatic hydrocarbon group having from 6 to 15 carbon atoms, or a heteroaromatic ring group having from 4 to 15 carbon atoms (incidentally, examples of the substituent include an alkyl group having from 1 to 20 carbon atoms, a halogen atom (for example, Br, Cl, and I), an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms, and an acyl group having from 2 to 15 carbon atoms); $R^{41}$ represents an alkylene group having from 1 to 100 carbon atoms; and p represents an integer of from 1 to 100. Incidentally, these respective groups may contain a substituent, and examples of the substituent include an alkyl group having from 1 to 20 carbon atoms and an aromatic hydrocarbon group having from 6 to 15 carbon atoms.

In the definition of the foregoing formula (IV), specific examples of the "aromatic hydrocarbon group" include a phenyl group, a tolyl group, a naphthyl group, an anthryl group, a biphenyl group, and a phenanthryl group; and specific examples of the "heteroaromatic ring group" include a furyl group, a thienyl group, an oxazolyl group, an imidazolyl group, a pyranyl group, a pyridinyl group, an acridinyl group, a benzofuranyl group, a benzothienyl group, a benzopyranyl group, a benzoxazolyl group, and a benzimidazolyl group.

Furthermore, the $(R^{41}\text{-O})_p$ moiety of the formula (IV) may be a combination of two or three kinds of groups so far as it falls within the foregoing range. Specifically, there are enumerated random or block-like forms of a combination, for example, a combination of an ethyleneoxy group and a propyleneoxy group, a combination of an ethyleneoxy group and an isopropyloxy group, a combination of an ethyleneoxy group and a butyleneoxy group, and a combination of an ethyleneoxy group and an isobutylene group. In the invention, the polyoxyalkylene ether group-containing surfactant is used singly or in a composite system. It is effective to add the polyoxyalkylene ether group-containing surfactant in an amount of from 1 to 30 % by weight, and preferably from 2 to 20 % by weight in the developing solution. When the addition amount is too low, the developability may be possibly lowered, while it is too high, damage of the development is so strong that printing resistance of a printing plate may be possibly lowered.

Furthermore, examples of the polyoxyalkylene ether group-containing nonionic surfactant represented by the foregoing formula (IV) include polyoxyethylene alkyl ethers (for example, polyoxyethylene lauryl ether, polyoxyethylene cetyl ether, and polyoxyethylene stearyl ether), polyoxyethylene aryl ethers (for example, polyoxyethylene phenyl ether and polyoxyethylene naphthyl ether), and polyoxyethylene alkylaryl ethers (for example, polyoxyethylene methylphenyl ether, polyoxyethylene octylphenyl ether, and polyoxyethylene nonylphenyl ether).

Such a surfactant can be used singly or in combination. Furthermore, the content of such a surfactant in the developing solution is suitably in the range of from 0.1 to 20 % by weight as reduced into an active ingredient.

The pH of the developing solution which is used in the plate-making process of the invention is usually from 11.0 to 12.7, and preferably from 11.5 to 12.5 in view of the image formation and development damage in the exposed area.

Furthermore, it is preferable that the developing solution which is used in the invention has a conductivity of from 3 to 30 mS/cm. When the conductivity is lower than the foregoing range, in general, elution of the photopolymerizable

composition on the surface of the aluminum plate support becomes difficult, thereby causing staining during printing. On the other hand, when the conductivity exceeds the foregoing range, since the salt concentration is high, an elution rate of the photosensitive layer becomes extremely low so that a residual film may be possibly generated in an unexposed area. The conductivity is especially preferably in the range of from 5 to 20 mS/cm.

(Exposure and development treatment)

By image exposing the photosensitive lithographic printing plate in the invention by conventionally known active rays such as a carbon arc lamp, a high pressure mercury vapor lamp, a xenon lamp, a metal halide lamp, a fluorescent lamp, a tungsten lamp, a halogen lamp, a helium-cadmium laser, an argon ion laser, an FD·YAG laser, a helium-neon laser, and a semiconductor laser (from 350 nm to 600 nm) and then developing it, it is possible to form an image on the surface of the aluminum plate support.

For the purpose of enhancing a rate of curing of the photosensitive layer, a heating process to be carried out at a temperature of from 50 °C to 140 °C for a period of time of from 1 second to 5 minutes may be provided and carried out after the image exposure but before the development. When the heating temperature falls within the foregoing range, an effect for increasing the rate of curing is brought, and a residual film due to dark polymerization in an unexposed area is not generated.

Furthermore, as described previously, the protective layer is provided on the photosensitive layer of the photosensitive lithographic printing plate in the invention. There is known a method for achieving the removal of the protective layer and the removal of the unexposed area of the photosensitive layer at the same time by using a developing solution, or a method for removing the protective layer with water or warm water and then removing the photosensitive layer in the unexposed area with a developing solution. An antiseptic, etc. as described in JP-A-10-10754 or an organic solvent, etc. as described in JP-A-8-278636 can be contained in such water or warm water.

The development of the photosensitive lithographic printing plate in the invention with the foregoing developing solution is carried out according to a usual method at a temperature of from 0 to 60 °C, and preferably from 15 to 40 °C by, for example, dipping the exposed photosensitive lithographic printing plate in the developing solution and rubbing it by a brush or other means.

In addition, in the case where the development treatment is carried out by using an automatic processor, since the developing solution fatigues corresponding to the amount of treatment, treatment ability may be recovered by using a replenisher or a fresh developing solution. The thus developed photosensitive lithographic printing plate is subjected to post treatments with washing water, a rinse liquid containing a surfactant, etc., and a desensitizing liquid containing gum arabic, a starch derivative, etc. as described in JP-A-54-8002, JP-A-55-115045, JP-A-59-58431, and the like. In the invention, for the post treatments of the photosensitive lithographic printing plate, a combination of a variety of these treatments can be employed.

In the printing plate as obtained by the foregoing treatments, its printing resistance can be enhanced by a post exposure treatment or a heating treatment such as burning as described in JP-A-2000-89478.

The lithographic printing plate as obtained by these treatments is set in an offset printing machine and provided for printing of a number of sheets.

## EXAMPLES

The invention will be hereunder described in detail with reference to the following Examples, but as a matter of course, it should not be construed that the invention is limited thereto.

[Examples 1 to 10 and Comparative Examples 1 to 3]

(Preparation method of aluminum support)

An aluminum plate having a thickness of 0.3 mm was etched by dipping in 10 % by weight sodium hydroxide at 60 °C for 25 seconds, washed with running water, neutralized and washed with 20 % by weight nitric acid, and then washed with water.

This aluminum plate was subjected to an electrolytic surface roughing treatment in a quantity of electricity at the time of anode of 300 coulombs/$dm^2$ in a 1 % by weight nitric acid aqueous solution using an alternating waveform current of sine wave. Subsequently, the resulting aluminum plate was dipped in a 1 % by weight sodium hydroxide aqueous solution at 40 °C for 5 seconds; dipped in a 30 % by weight sulfuric acid aqueous solution; subjected to a desmutting treatment at 60°C for 40 seconds; and then subjected to an anodic oxidation treatment in a 20 % by weight sulfuric acid aqueous solution for 2 minutes in a current density of 2 A/$dm^2$ such that the anodically oxidized film had a thickness of 2.7 g/$m^2$. A surface roughness thereof was measured and found to be 0.3 μm (in terms of an Ra expression

according to JIS B0601).

[Intermediate layer]

On the thus treated aluminum plate, the following intermediate layer liquid was first coated using a bar coater and then dried at 80 °C for 20 seconds. A coating weight of the intermediate layer after drying was 10 mg/$m^2$.

Intermediate layer liquid

- Sol liquid as described below: 100 g
- Methanol: 900 g

Sol liquid

- PHOSMER PE (manufactured by Uni-Chemical Co., Ltd.): 5 g
- Methanol: 45 g
- Water: 10 g
- 85 % phosphoric acid: 5 g
- Tetraethoxysilane: 20 g
- 3-Methacryloxypropyltrimethoxysilane: 15 g

<Formation of photosensitive layer>

A highly sensitive photopolymerizable composition P-1 having the following composition was coated on this intermediate layer in a dry coating weight of 1.4 g/$m^2$ and dried at 100 °C for one minute to form a photosensitive layer.

(Photopolymerizable composition P-1)

| | |
|---|---|
| Ethylenically unsaturated bond-containing compound (A1): | 4.2 parts by weight |
| Linear organic high molecular polymer (polymer binder) (B1): | 3.6 parts by weight |
| Sensitizer (C1): | 0.21 parts by weight |
| Photopolymerization initiator (D1): | 0.81 parts by weight |
| Chain transfer agent (E1): | 0.3 parts by weight |
| ε-Phthalocyanine dispersion: | 0.76 parts by weight |
| Fluorine based nonionic surfactant, MEGAFAC F780 (manufactured by Dainippon Ink and Chemicals, Incorporated) | 0.05 parts by weight |
| Methyl ethyl ketone: | 58 parts by weight |
| Propylene glycol monomethyl ether acetate: | 53 parts by weight |

A-1 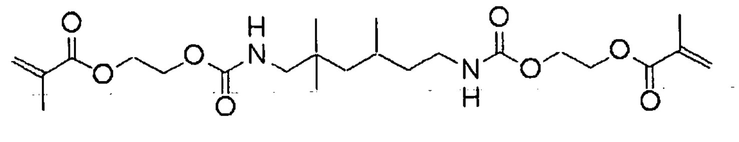

B-1 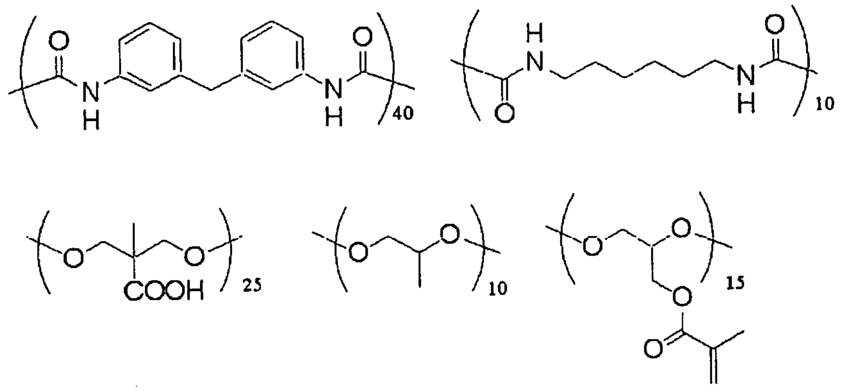

C-1 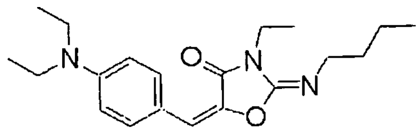

D-1 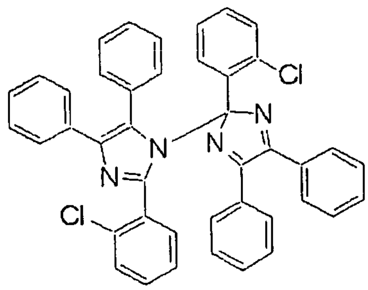

E-1 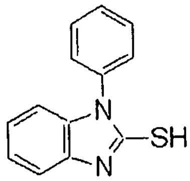

(Formation of Protective Layer)

Coating solutions for the upper layer, intermediate layer and lower layer were each prepared by mixing 98 mass% of a composition shown in Table 1 and 2 mass% of Surfactant EMALEX 710® (surfactant, produced by Nihon Emulsion Co., Ltd.) and sequentially coated on the photosensitive layer to have a dry coated mass value shown in Table 1 of each layer, thereby forming a protective layer. In this way, Negative Photosensitive Lithographic Printing Plate [P] was obtained. The drying conditions were 120°C and 1 minute.

Table 1: Composition of Protective Layer (unit in column of material: mass%)

| Upper Layer composition | T1 | T2 | T3 | T4 | T5 | T6 | T7 |
|---|---|---|---|---|---|---|---|
| Coated amount ($g/m^2$) | 0.5 | 0.5 | 0.5 | 0.5 | 0.5 | 0.5 | 0.5 |
| PVA-105® | 98 | 85 | 85 | 85 | | | 85 |
| PVA-205® | | | | | | | 13 |
| SOMASIF ME-100® | | 13 | | | | | |
| MERPOL MF-25® | | | 13 | | 98 | | |
| PAOGEN EP-25® | | | | 13 | | 98 | |

| Intermediate layer composition | M1 | M2 | M3 |
|---|---|---|---|
| Coated amount ($g/m^2$) | 1.8 | 1.8 | 1.8 |
| PVA-105® | 98 | | 85 |
| PVA-205® | | 98 | |
| PVP K30® | | | 13 |

| Lower layer composition | B1 | B2 | B3 | B4 | B5 | B6 | B7 |
|---|---|---|---|---|---|---|---|
| Coated amount (g/m$^2$) | 0.5 | 0.5 | 0.5 | 0.5 | 0.5 | 0.5 | 0.5 |
| PVA-105 ® | 98 | 85 | 85 | 85 | | | 85 |
| PVA-205 ® | | | | | | | 13 |
| SOMASIF ME-100 ® | | 13 | | | | | |
| MERPOL MF-25 ® | | | 13 | | 98 | | |
| PAOGEN EP-25 ® | | | | 13 | | 98 | |

| Comparative protective layer composition | R1 | R2 | R3 |
|---|---|---|---|
| Coated amount (g/m$^2$) | 2.5 | 2.5 | 2.5 |
| PVA-105 ® | 98 | | 85 |
| PVA-205 ® | | 98 | |
| PVP K30 ® | | | 13 |

PVA-105®: produced by Kuraray Co., Ltd. (saponification degree: 98 mol%, polymerization degree: 500)

PVA-205®: produced by Kuraray Co., Ltd. (saponification degree: 88 mol%, polymerization degree: 500)

PVA-405®: produced by Kuraray Co., Ltd. (saponification degree: 81 mol%, polymerization degree: 500)

PVA-K30®: polyvinylpyrrolidone, produced by Wako Pure Chemical Industries, Ltd.

Luvitec VA64W®: vinylpyrrolidone-vinyl acetate copolymer, produced by ICP

SOMASIF ME-100®: produced by CO-OP Chemical Co., Ltd., aspect ratio: 1,000 or

| | |
|---|---|
| | more |
| MERPOL MF-25®: | water-soluble polymer, produced by Daiichi Kogyo Kagaku K.K. |
| PAOGEN EP-25®: | water-soluble polymer, produced by Daiichi Kogyo Kagaku K.K. |

[Production of Inserting Paper]

A paper material was prepared by beating bleached kraft pulp and diluting it to a concentration of 4 mass% and after adding aluminum sulfate thereto until the pH value became 5.0, subjected to papermaking to produce an inserting paper for photosensitive printing plate, having a basis weight of 35 g/$m^2$.

[Evaluation]

(Press Life)

The obtained photosensitive lithographic printing plate was subjected to imagewise drawing on Vx9600CTP (light source wavelength: 405 nm) manufactured by Fuji Photo Film Co., Ltd. under the control of adjusting the exposure amount on the photosensitive material to 0.05 mJ/$cm^2$, then developed by using PS Processor IP850HD® (manufactured by G & J) into which an alkali developer having the following composition was charged, for a development time of 28 seconds while keeping the liquid temperature to 25°C, and further subjected to printing in Lithrone® (printing press, manufactured by Komori Corp.) by using DIC-GEOS(N)® black ink, produced by DaiNippon Ink & Chemicals, Inc.). The press life was evaluated by the number of sheets printed until it was recognized with an eye that the density of a solid image started thinning. The evaluation results are shown in Table 2.

| Alkali Developer Composition | |
|---|---|
| Potassium hydroxide | 0.15 g |
| Polyoxyethylene naphthyl ether (n=13) | 5.0 g |
| Chelest 400 (chelating agent) | 0.1 g |
| Water | 94.75 g |

(Dynamic Friction Coefficient)

An inserting paper was laminated on the obtained Negative Photosensitive Lithographic Printing Plate [P] to produce a laminated product.

The dynamic friction coefficient between the protective layer surface of Negative Photosensitive Lithographic Printing Plate [P] and the inserting paper was measured according to the method prescribed in JIS P 8147, and the results are shown in Table 2.

(Conveyability)

The laminated product comprising a negative photosensitive lithographic printing plate and an inserting paper produced above was set in a cassette, and 500 plates were conveyed by an autoloader from the setting portion to the exposure part and then to the development part. How many plates were not normally processed (jamming) was evaluated. The evaluation results are shown in Table 2.

(Scratch Resistance)

The laminated product of Negative Photosensitive Lithographic Printing Plate [P] produced was set in a cassette and conveyed by an autoloader from the setting portion to the exposure part and then to the development part, and development was performed by the above-described automatic developing machine. The state of scratches generated

in this process was evaluated. The evaluation was performed according to the following criteria. The exposure and development conditions were as described above. Also, in the evaluation of scratch resistance, the presence or absence of a white spotted state was inspected, because when the photosensitive material surface is scratched before development, an image is not formed in this portion at the development and the image area provides a white spotted state.

The evaluation results are shown in Table 2.

○: Scratches were not observed.
Δ: Scratches were faintly observed.
×: Scratches were clearly observed.

(Scumming Resistance)

The lithographic printing plate developed and used for the evaluation of scratch resistance above was subjected to printing in a printing press, SOR-M, manufactured by Heilderberg Co., by using a commercially available oily ink. At this time, whether staining was generated or not in the non-image area was observed with an eye and used as an index for scumming resistance. The exposure and development conditions were as described above. The evaluation results are shown in Table 2.

○: Staining was not observed.
Δ: Staining was faintly observed.
×: Staining was clearly observed.

(Measurement of Oxygen Permeability)

On the surface of a photographic paper having a thickness of 200 μm, where polyethylene was coated to a thickness of 20 μm on both surfaces, the protective layer described above was coated under the same conditions as above and dried to produce a sample for measurement. The oxygen permeability of the photographic paper measured previously under the following measurement conditions was 700 [$cm^3/(m^2 \cdot day)$], and this was a sufficiently negligible value at the measurement of permeability in the protective layer.

Using the thus-obtained sample, the oxygen permeability [$cm^3/(m^2 \cdot day)$] was measured under the conditions of 25°C and 60% RH according to the gas permeability test method prescribed in JIS K7126B and ASTM D3985 by using OX-TRAN2/20 manufactured by Mocon. The evaluation results are shown in Table 2.

(Measurement of Adhesive Force between Photosensitive Layer and Protective Layer)

A universal tensile tester, Tensilon (manufactured by Baldwin Co., Ltd.), was used. In the measurement, a pressure-sensitive adhesive tape (width: 20 cm) was attached on the protective layer of the unexposed plate material, and the protective layer with the tape was peeled off from the photosensitive layer by the universal tensile tester, Tensilon, at a rate of 40 mm/min. The peeling force (g) required for the separation was measured.

(Storage Stability)

The halftone dot area was measured in the same manner except for using a photosensitive lithographic printing plate which was hermetically packaged together with the inserting paper by an aluminum kraft paper and left standing at 60°C for 3 days. As for the halftone dot area, the area of 30 to 70% halftone dot was measured by using a reflection densitometer, Gretag D19C (manufactured by Gretag-Macbeth), in the halftone dot area ratio mode and the cyan mode of the reflection densitometer. Thereafter, the difference between the halftone dot area with standing at 60°C for 3 days and the halftone dot area without standing at 60°C for 3 days was calculated, and the dot fluctuation (Δ%) due to enforced aging was determined. As the absolute value of the numeral obtained is smaller, the effect by the enforced aging is smaller, that is, the storage safety is higher. The evaluation results are shown in Table 2.

Table 2: Examples 1 to 10 and Comparative Examples 1 to 3

| | | Example | | | | | | | | | | Comparative Example | | |
|---|---|---|---|---|---|---|---|---|---|---|---|---|---|---|
| | | 1 | 2 | 3 | 4 | 5 | 6 | 7 | 8 | 9 | 10 | 1 | 2 | 3 |
| Protective Layer | Upper layer | T1 | T2 | T3 | T4 | T5 | T6 | T2 | T2 | T2 | T4 | R1 | R2 | R3 |
| | Intermediate layer | M2 | M2 | M2 | M2 | M2 | M2 | M3 | M3 | M2 | M2 | | | |
| | Lower layer | B1 | B2 | B3 | B4 | B5 | B6 | B2 | none | none | none | | | |
| Dynamic friction coefficient | | 0.55 | 0.6 | 0.42 | 0.35 | 0.51 | 0.56 | 0.55 | 0.55 | 0.55 | 0.35 | 0.75 | 0.98 | 0.82 |
| Oxygen permeability ($cm^3/cm^2 \cdot day$) | | 2.4 | 3.1 | 2.8 | 3.1 | 2.8 | 3.1 | 2.9 | 3.2 | 3.1 | 2.9 | 0.1 | 3.1 | 2.5 |
| Adhesive force between photosensitive layer and protective layer (g/cm) | | 24 | 46 | 77 | 48 | 45 | 60 | 60 | 31 | 24 | 25 | 15 | 8 | 13 |
| Conveyability (plates) | | 2 | 0 | 0 | 0 | 0 | 1 | 0 | 0 | 0 | 1 | 38 | 49 | 35 |
| Scratch resistance | | Δ | ○ | ○ | ○ | ○ | ○ | ○ | ○ | ○ | ○ | Δ | × | Δ |
| Scumming resistance | | Δ | Δ | ○ | ○ | ○ | Δ | Δ | Δ | Δ | Δ | × | | × |
| Press life (sheets in ten thousand) | | 14 | 15 | 14 | 14 | 14 | 14 | 16 | 14 | 14 | 14 | 16 | 13 | 13 |
| Dot fluctuation in enforced aging (%) | | 0 | 0 | 0 | 0 | 0 | 0 | 1 | 1 | 0 | 0 | fogged | 0 | 1 |

[Examples 11 to 13 and Comparative Example 4]

The procedure until the formation of photosensitive layer was performed in the same manner as in Example 1 except for chaining Polymer Binder B1 of Photopolymerizable Composition P-1 to B2, and then the protective layer shown in Table 3 was provided to produce photosensitive lithographic printing plates of Examples 11 to 13 and Comparative Example 4. The photosensitive lithographic printing plates obtained were evaluated. The evaluation results are shown in Table 3.

B-2

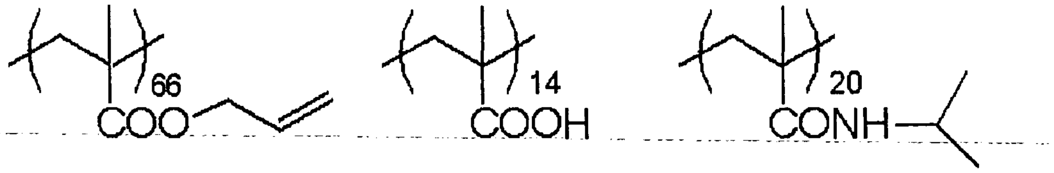

Table 3: Examples 11 to 13 and Comparative Example 4

| | | Example | | | Comparative Example |
|---|---|---|---|---|---|
| | | 11 | 12 | 20 | 4 |
| Protective Layer | Upper layer | T2 | T2 | T4 | R1 |
| | Intermediate layer | M3 | M2 | M2 | |
| | Lower layer | none | none | none | |
| Dynamic friction coefficient | | 0.55 | 0.55 | 0.35 | 0.75 |
| Oxygen permeability ($cm^3/cm^2 \cdot day$) | | 3.2 | 3.1 | 2.9 | 0.1 |
| Adhesive force between photosensitive layer and protective layer (g/cm) | | 28 | 41 | 45 | 13 |
| Conveyability (plates) | | 0 | 0 | 1 | 29 |
| Scratch resistance | | ○ | ○ | ○ | Δ |
| Scumming resistance | | Δ | Δ | Δ | × |
| Press life (sheets in ten thousand) | | 16 | 18 | 18 | 18 |
| Dot fluctuation in enforced aging (%) | | 1 | 0 | 0 | fogged |

As apparent from Tables 2 and 3, in all of the lithographic printing plates of the present invention, the conveyability and scratch resistance are excellent, the storage stability is also good, a high-quality image free of staining in the non-image area is formed, and high press life is maintained even under the high-sensitivity condition that the exposure amount is 0.05 $mJ/cm^2$. On the other hand, in all of the lithographic printing plates of Comparative Examples having an excessively high dynamic friction coefficient, the conveyability and scratch resistance are inferior and staining is generated in the non-image area.

Also, in the photosensitive lithographic printing plates of Examples where the oxygen permeability A of the protective layer is in the range of $1.0 \leq A \leq 20$ ($cm^3/m^2 \cdot day$), satisfactory results are obtained in view of both the press life and the storage stability.

## Claims

1. A photosensitive lithographic printing plate comprising: a hydrophilic support; a photosensitive layer; and a protective layer in this order, wherein the photosensitive layer contains a compound having an ethylenically unsaturated double bond and a polymer binder, and the protective layer includes at least two layers each containing water-soluble resin, wherein at least one of the layers included in the protective layer contains a polyvinyl alcohol and wherein at least one of the layers included in the protective layer contains polyester or polyurethane.

2. The photosensitive lithographic printing plate as claimed in claim 1, wherein at least one of the layers included in the protective layer has an oxygen permeability at 25°C under 1 atm of from 1.0 to 20 $cm^3/m^2$ day, and a dynamic friction coefficient between an outermost surface of the protective layer and an inserting paper or back surface of the photosensitive lithographic printing plate is from 0.2 to 0.7.

3. The photosensitive lithographic printing plate as claimed in claim 2, wherein the dynamic friction coefficient between an outermost surface of the protective layer and an inserting paper or back surface of the photosensitive lithographic printing plate is from 0.3 to 0.6.

4. The photosensitive lithographic printing plate as claimed in claim 1, wherein at least one of the layers included in the protective layer contains polyester or polyurethane, and the at least one layer containing polyester or polyurethane is another layer than the at least one layer containing a polyvinyl alcohol.

5. The photosensitive lithographic printing plate as claimed in any one of claims 1 to 4, wherein the polymer binder is a polyurethane resin having a crosslinking group in a side chain or a (meth)acrylic resin having a crosslinking group in a side chain.

6. The photosensitive lithographic printing plate as claimed in any one of claims 1 to 5, wherein the polymer binder is a polyurethane resin having a crosslinking group in a side chain.

7. The photosensitive lithographic printing plate as claimed in claim 1, wherein the protective layer contains a filler.

8. The photosensitive lithographic printing plate as claimed in claim 7, wherein the filler is an inorganic layered compound.

9. The photosensitive lithographic printing plate as claimed in claim 8, wherein the inorganic layered compound is mica.

10. The photosensitive lithographic printing plate as claimed in claim 9, wherein the filler is contained in an outermost layer included in the protective layer.

11. The photosensitive lithographic printing plate as claimed in any one of claims 1 to 6, wherein the polyester or polyurethane is contained in an outermost layer included in the protective layer.

12. The photosensitive lithographic printing plate as claimed in any one of claims 1 to 6, wherein the polyester or polyurethane is contained in a lowermost layer included in the protective layer.

**Patentansprüche**

1. Fotoempfindliche Lithographiedruckplatte, umfassend:

   einen hydrophilen Träger; eine fotoempfindliche Schicht; und eine Schutzschicht, in dieser Reihenfolge, worin die fotoempfindliche Sicht eine Verbindung mit einer ethylenisch ungesättigten Doppelbindung und ein PolymerBindemittel enthält und die Schutzschicht mindestens zwei Schichten umfasst, die jeweils wasserlösliches Harz enthalten, worin zumindest eine der in der Schutzschicht enthaltenen Schichten einen Polyvinylalkohol enthält und worin zumindest eine der in der Schutzschicht enthaltenen Schichten Polyester oder Polyurethan enthält.

2. Fotoempfindliche Lithographiedruckplatte gemäß Anspruch 1, worin zumindest eine der in der Schutzschicht enthaltenen Schichten eine Sauerstoffdurchlässigkeit bei 25°C unter 1 Atm von 1,0 bis 20 $cm^3/m^2\cdot$Tag aufweist und ein dynamischer Reibungskoeffizient zwischen einer äußersten Oberfläche der Schutzschicht und einem Zwischenpapier oder eine Rückseitenoberfläche der fotoempfindlichen Lithographiedruckplatte von 0,2 bis 0,7 beträgt.

3. Fotoempfindliche Lithographiedruckplatte gemäß Anspruch 2, worin der dynamische Reibungskoeffizient zwischen einer äußersten Oberfläche der Schutzschicht und einem Zwischenpapier oder einer Rückseitenüberfläche der fotoempfindlichen Lithographiedruckplatte von 0,3 bis 0,6 beträgt.

4. Fotoempfindliche Lithographiedruckplatte gemäß Anspruch 1, worin zumindest eine der in der Schutzschicht enthaltenen Schichten Polyester oder Polyurethan enthält und die zumindest eine Schicht, die Polyester oder Polyurethan enthält, eine andere Schicht ist als die zumindest eine Schicht, die einen Polyvinylalkohol enthält.

**5.** Fotoempfindliche Lithographiedruckplatte gemäß irgendeinem der Ansprüche 1 bis 4, worin das PolymerBindemittel ein Polyurethanharz mit einer Vernetzungsgruppe in einer Seitenkette oder ein (Meth)acrylharz mit einer Vernetzungsgruppe in einer Seitenkette ist.

**6.** Fotoempfindliche Lithographiedruckplatte gemäß irgendeinem der Ansprüche 1 bis 5, worin das PolymerBindemittel ein Polyurethanharz mit einer Vernetzungsgruppe in einer Seitenkette ist.

**7.** Fotoempfindliche Lithographiedruckplatte gemäß Anspruch 1, worin die Schutzschicht einen Füllstoff enthält.

**8.** Fotoempfindliche Lithographiedruckplatte gemäß Anspruch 7, worin der Füllstoff eine anorganische Schichtverbindung ist.

**9.** Fotoempfindliche Lithographiedruckplatte gemäß Anspruch 8, worin die anorganische Schichtverbindung Glimmer ist.

**10.** Fotoempfindliche Lithographiedruckplatte gemäß Anspruch 9, worin der Füllstoff in einer äußersten Schicht enthalten ist, die in der Schutzschicht umfasst ist.

**11.** Fotoempfindliche Lithographiedruckplatte gemäß irgendeinem der Ansprüche 1 bis 6, worin der Polyester oder das Polyurethan in einer äußersten Schicht enthalten ist, die in der Schutzschicht umfasst ist.

**12.** Fotoempfindliche Lithographiedruckplatte gemäß irgendeinem der Ansprüche 1 bis 6, worin der Polyester oder das Polyurethan in einer untersten Schicht enthalten ist, die in der Schutzschicht umfasst ist.

## Revendications

**1.** Plaque d’impression lithographique photosensible comprenant: un support hydrophile; une couche photosensible; et une couche protectrice dans cet ordre, dans laquelle la couche photosensible contient un composé ayant une double liaison éthyléniquement insaturée et un liant polymère, et la couche protectrice inclut au moins deux couches contenant chacune une résine soluble dans l’eau, dans laquelle au moins une des couches incluses dans la couche protectrice contient un alcool polyvinylique et dans laquelle au moins une des couches incluses dans la couche protectrice contient du polyester ou du polyuréthane.

**2.** Plaque d’impression lithographique photosensible selon la revendication 1, dans laquelle au moins une des couches incluses dans la couche protectrice a une perméabilité à l’oxygène à 25°C sous 1 atm de 1,0 à 20 $cm^3/m^2$ par jour, et un coefficient de friction dynamique entre une surface la plus externe de la couche protectrice et un papier d’insertion ou une surface arrière de la plaque d’impression lithographique photosensible est de 0,2 à 0,7.

**3.** Plaque d’impression lithographique photosensible selon la revendication 2, dans laquelle le coefficient de friction dynamique entre une surface la plus externe de la couche protectrice et un papier d’insertion ou une surface arrière de la plaque d’impression lithographique photosensible est de 0,3 à 0,6.

**4.** Plaque d’impression lithographique photosensible selon la revendication 1, dans laquelle au moins une des couches incluses dans la couche protectrice contient du polyester ou du polyuréthane, et la au moins une couche contenant du polyester ou du polyuréthane est une autre couche que la au moins une couche contenant un alcool polyvinylique.

**5.** Plaque d’impression lithographique photosensible selon l’une quelconque des revendications 1 à 4, dans laquelle le liant polymère est une résine polyuréthane ayant un groupe de réticulation dans une chaîne latérale ou une résine (méth)acrylique ayant un groupe de réticulation dans une chaîne latérale.

**6.** Plaque d’impression lithographique photosensible selon l’une quelconque des revendications 1 à 5, dans laquelle le liant polymère est une résine polyuréthane ayant un groupe de réticulation dans une chaîne latérale.

**7.** Plaque d’impression lithographique photosensible selon la revendication 1, dans laquelle la couche protectrice

contient une charge.

**8.** Plaque d'impression lithographique photosensible selon la revendication 7, dans laquelle la charge est un composé inorganique en couches.

**9.** Plaque d'impression lithographique photosensible selon la revendication 8, dans laquelle le composé inorganique en couches est le mica.

**10.** Plaque d'impression lithographique photosensible selon la revendication 9, dans laquelle la charge est contenue dans une couche la plus externe incluse dans la couche protectrice.

**11.** Plaque d'impression lithographique photosensible selon l'une quelconque des revendications 1 à 6, dans laquelle le polyester ou polyuréthane est contenu dans une couche la plus externe incluse dans la couche protectrice.

**12.** Plaque d'impression lithographique photosensible selon l'une quelconque des revendications 1 à 6, dans laquelle le polyester ou polyuréthane est contenu dans une couche la plus basse incluse dans la couche protectrice.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 8220758 A
- JP 2000035673 A
- JP 2003098674 A
- JP 2004125876 A
- EP 1450207 A
- US 20050005794 A1
- JP 2003287878 A
- US 3458311 A
- JP 55049729 B
- JP 48041708 B
- JP 51037193 A
- JP 2032293 B
- JP 48064183 A
- JP 49043191 B
- JP 52030490 B
- JP 59053836 A
- JP 59071048 A
- JP 2003270775 A
- JP 7021633 B
- US 2850445 A
- JP 4420189 B
- JP 4537377 B
- JP 47002528 B
- JP 54155292 A
- JP 48084183 A
- JP 54151024 A
- JP 52112681 A
- JP 58015503 A
- JP 59140203 A
- JP 59001504 A
- JP 59189340 A
- JP 62174203 A
- JP 62001641 B
- US 4766055 A
- JP 63258903 A
- JP 2063054 A
- JP 62143044 A
- JP 62150242 A
- JP 6413140 A
- JP 6413141 A
- JP 6413142 A
- JP 6413143 A
- JP 6413144 A
- JP 6417048 A
- JP 1229003 A
- JP 1298348 A
- JP 1138204 A
- JP 2179643 A
- JP 2244050 A
- JP 63221110 A
- JP 4221958 A
- JP 4219756 A
- JP 6295061 A
- JP 8334897 A
- JP 11084647 A
- JP 2000147763 A
- JP 2001042524 A
- JP 59152396 A
- JP 61151197 A
- JP 4486516 B
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2001006326 A
- JP 2001237840 A
- JP 2001133969 A
- JP 2002148790 A
- JP 2002350207 A
- JP 2002006482 A
- JP 48018327 B
- JP 56028893 A

- JP 53012739 A
- JP 48028123 B
- JP 7159983 A
- US 3055295 A
- JP 56013168 A
- JP 9080744 A
- JP 8507727 T
- JP 50007481 B
- JP 54072104 A
- JP 59101651 A
- JP 60149491 A
- JP 60232998 A
- JP 3056177 A
- JP 4282637 A
- JP 5016558 A
- JP 5246171 A
- JP 7314937 A
- JP 8202025 A
- JP 8320551 A
- JP 9034104 A
- JP 9236911 A
- JP 9269593 A
- JP 10069092 A
- JP 10115931 A
- JP 10161317 A
- JP 10260536 A
- JP 10282682 A
- JP 11084674 A
- JP 11038635 A
- JP 11038629 A
- JP 10282645 A
- JP 10301262 A
- JP 11024277 A
- JP 11109641 A
- JP 10319600 A
- JP 11327152 A
- JP 2000010292 A
- JP 2000235254 A
- JP 2000352824 A
- JP 2001209170 A
- JP 10010754 A
- JP 8278636 A
- JP 54008002 A
- JP 55115045 A
- JP 59058431 A
- JP 2000089478 A

**Non-patent literature cited in the description**

- *Journal of the Adhesion Society of Japan,* 1984, vol. 20 (7), 300-308
- Kobunshi Data Handbook - Kiso Hen- (Polymer Data Handbook -Basic Edition-). Baifukan, 1986
- Color Index (C.I.) Binran C.I. Handbook), Saishin Ganryo Binran (Handbook of Latest Pigments). 1977
- Saishin Ganryo Oyo Gijutsu (Latest Pigment Application Technology). CMC Shuppan, 1986
- Insatsu Ink Gijutsu (Printing Ink Technology). CMC Shuppan, 1984
- Kinzoku Sekken no Seishitsu to Oyo (properties and Application of Metal Soap). **SAIWAI SHOBO.** Insatsu Ink Gijutsu (Printing Ink Technology). CMC Shuppan, 1984